(19) Europäisches Patentamt
European Patent Office
Office européen des brevets

(11) **EP 3 859 809 B1**

(12) **EUROPEAN PATENT SPECIFICATION**

(45) Date of publication and mention of the grant of the patent:
**20.12.2023 Bulletin 2023/51**

(21) Application number: **21154440.8**

(22) Date of filing: **29.01.2021**

(51) International Patent Classification (IPC):
***H10K 50/11*** *(2023.01)* ***H10K 50/12*** *(2023.01)*
***H10K 101/10*** *(2023.01)*

(52) Cooperative Patent Classification (CPC):
**H10K 50/121; H10K 50/11;** H10K 2101/10

# (54) LIGHT-EMITTING DEVICE AND ELECTRONIC APPARATUS

LICHTEMITTIERENDE VORRICHTUNG UND ELEKTRONISCHE VORRICHTUNG

DISPOSITIF ÉLECTROLUMINESCENT ET APPAREIL ÉLECTRONIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.01.2020 KR 20200011347**
**28.01.2021 KR 20210011975**

(43) Date of publication of application:
**04.08.2021 Bulletin 2021/31**

(73) Proprietor: **Samsung Display Co., Ltd.**
**Yongin-si, Gyeonggi-do 17113 (KR)**

(72) Inventors:
- **YOON, Seokgyu**
  **Yongin-si Gyeonggi-do 17113 (KR)**
- **JUN, Mieun**
  **Yongin-si Gyeonggi-do 17113 (KR)**
- **CHO, Hyeongu**
  **Yongin-si Gyeonggi-do 17113 (KR)**
- **LYU, Jaejin**
  **Yongin-si Gyeonggi-do 17113 (KR)**

(74) Representative: **Marks & Clerk LLP**
**15 Fetter Lane**
**London EC4A 1BW (GB)**

(56) References cited:
**WO-A1-2018/186101** **WO-A1-2019/142555**
**US-A1- 2019 280 236**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 859 809 B1

## Description

BACKGROUND

1. Field

One or more embodiments relate to a light-emitting device and an electronic apparatus including the same.

2. Description of Related Art

Light-emitting devices, for example, organic light-emitting devices, may include a first electrode located on a substrate, and a hole transport region, an emission layer, an electron transport region, and a second electrode sequentially stacked on the first electrode. Holes provided from the first electrode may move toward the emission layer through the hole transport region, and electrons provided from the second electrode may move toward the emission layer through the electron transport region. Carriers, such as the holes and the electrons, recombine in the emission layer to produce excitons. These excitons transition from an excited state to a ground state to thereby generate light.

WO 2019/142555 A1 discloses a luminescent film containing at least a phosphorescent compound and a fluorescent compound.

WO 2018/186101 A1 discloses an organic electroluminescence element having a light-emitting layer.

US 2019/280236 A1 discloses a luminescent film that includes a host compound, a blue phosphorescent compound, and a blue fluorescent compound.

SUMMARY

Provided is a light-emitting device with low driving voltage, excellent external quantum efficiency, and improved lifespan characteristics and an electronic apparatus including the same.

Additional aspects will be set forth in part in the description which follows and, in part, will be apparent from the description, or may be learned by practice of the presented embodiments of the disclosure.

According to an aspect, provided is a light-emitting device including

a first electrode,
a second electrode facing the first electrode, and
an interlayer arranged between the first electrode and the second electrode and including an emission layer,
wherein the emission layer includes a host, a first dopant, and a second dopant,
the host, the first dopant, and the second dopant are different from one another,
the first dopant is a phosphorescent dopant,
a Stokes shift (or, Stoke's shift) of the second dopant is less than or equal to 15 nm,
a spectral overlap integral of an emission spectrum of the first dopant and an absorption spectrum of the second dopant is greater than or equal to $1.5 \times 10^{15}$ $M^{-1}cm^{-1}nm^4$, and
the spectral overlap integral is evaluated by Equation 1.

Equation 1

$$J(\lambda) = \int_0^\infty \varepsilon(\lambda)\lambda^4 F_D(\lambda)d\lambda$$

In Equation 1,

$J(\lambda)$ is the spectral overlap integral of the emission spectrum of the first dopant and the absorption spectrum of the second dopant in units of $M^{-1}cm^{-1}nm^4$,
$\varepsilon(\lambda)$ is a molar extinction coefficient of the second dopant calculated from the absorption spectrum of the second dopant in units of $M^{-1}cm^{-1}$,
$\lambda$ is the wavelength of the emission spectrum and the absorption spectrum in units of nm, and
$F_D(\lambda)$ is the normalized emission spectrum of the first dopant,
wherein the emission spectrum of the first dopant is an emission spectrum evaluated at room temperature in a 5 μM (5 μmol/L) toluene solution of the first dopant, and
the absorption spectrum of the second dopant is an absorption spectrum evaluated at room temperature in a 5 μM

(5 μmol/L) toluene solution of the second dopant.

According to another aspect, provided is an electronic apparatus including the light-emitting device.
At least some of the above and other features of the invention are set out in the claims.

BRIEF DESCRIPTION OF THE DRAWINGS

The above and other aspects, features, and advantages of certain embodiments of the disclosure will be more apparent from the following description taken in conjunction with the accompanying drawings, in which

FIG. 1 is a diagram schematically illustrating a structure of a light-emitting device according to an embodiment;
FIG. 2 is a diagram schematically illustrating a structure of an electronic apparatus according to an embodiment;
FIG. 3 is a diagram schematically illustrating a structure of an electronic apparatus according to another embodiment; and
FIG. 4 is a diagram schematically illustrating emission spectra of D1-1, D1-2 and D1-3 ("D1-1", "D1-2" and "D1-3") and an absorption spectra of D2-1 ("D2-1 (Abs)").

DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.
Because the disclosure may have diverse modified embodiments, preferred embodiments are illustrated in the drawings and are described in the detailed description. An effect and a characteristic of the disclosure, and a method of accomplishing these will be apparent when referring to embodiments described with reference to the drawings. The disclosure may, however, be embodied in many different forms and should not be construed as limited to the embodiments set forth herein.
One or more embodiments of the disclosure will be described below in more detail with reference to the accompanying drawings. Those components that are the same or are in correspondence with each other are rendered the same reference numeral regardless of the figure number, and redundant explanations are omitted.
An expression used in the singular encompasses the expression of the plural, unless it has a clearly different meaning in the context.
It will be further understood that the terms "comprises" and/or "comprising" used herein specify the presence of stated features or elements, but do not preclude the presence or addition of one or more other features or elements.
It will be understood that when a layer, region, or component is referred to as being "on" or "onto" another layer, region, or component, it may be directly or indirectly formed on the other layer, region, or component. That is, for example, intervening layers, regions, or components may be present.
Sizes of elements in the drawings may be exaggerated or reduced for convenience of explanation. For example, since sizes and thicknesses of elements in the drawings are arbitrarily illustrated for convenience of explanation, the disclosure is not limited thereto.
The expression "(an interlayer) includes a compound represented by Formula 1" as used herein may include a case in which "(an interlayer) includes identical compounds represented by Formula 1" and a case in which "(an interlayer) includes two or more different compounds represented by Formula 1."
A light-emitting device includes: a first electrode; a second electrode facing the first electrode; and an interlayer arranged between the first electrode and the second electrode and including an emission layer, wherein the emission layer includes a host, a first dopant, and a second dopant.
The host, the first dopant, and the second dopant, which are included in the emission layer, are different from each other.
The host may include a compound different from the first dopant and the second dopant. Description of examples of the host is the same as described below.
The first dopant is a phosphorescent dopant. That is, the first dopant is a compound that emits phosphorescence according to phosphorescence emission mechanism.
In an embodiment, the first dopant may be a transition metal-containing organometallic compound. For example, the transition metal may be a first-row transition metal of the Periodic Table of Elements, a second-row transition metal

of the Periodic Table of Elements, or a third-row transition metal of the Periodic Table of Elements. In an embodiment, the transition metal may be a metal having an atomic weight of 40 or more. In an embodiment, the transition metal may be iridium (Ir), platinum (Pt), osmium (Os), titanium (Ti), zirconium (Zr), hafnium (Hf), europium (Eu), terbium (Tb), thulium (Tm), or rhodium (Rh).

A Stokes shift of the second dopant is less than or equal to 15 nm.

In an embodiment, a Stokes shift of the second dopant may be greater than or equal to 5 nm and less than or equal to 15 nm.

Meanwhile, a spectral overlap integral of an emission spectrum of the first dopant and an absorption spectrum of the second dopant is greater than or equal to 1.5 × $10^{15}$ $M^{-1}cm^{-1}nm^4$. The spectral overlap integral is evaluated by Equation 1:

Equation 1

$$J(\lambda) = \int_0^\infty \varepsilon(\lambda)\lambda^4 F_D(\lambda)d\lambda$$

In Equation 1,

$J(\lambda)$ is the spectral overlap integral of the emission spectrum of the first dopant and the absorption spectrum of the second dopant in units of $M^{-1}cm^{-1}nm^4$,
$\varepsilon(\lambda)$ is a molar extinction coefficient of the second dopant calculated from the absorption spectrum of the second dopant in units of $M^{-1}cm^{-1}$,
$\lambda$ is the wavelength of the emission spectrum and the absorption spectrum in units of nm, and
$F_D(\lambda)$ is the normalized emission spectrum of the first dopant,
wherein the emission spectrum of the first dopant is an emission spectrum evaluated at room temperature in a 5 μM (5 μmol/L) toluene solution of the first dopant, and
the absorption spectrum of the second dopant is an absorption spectrum evaluated at room temperature in a 5 μM (5 μmol/L) toluene solution of the second dopant.

In an embodiment, the spectral overlap integral may be greater than or equal to 1.5 × $10^{15}$ $M^{-1}cm^{-1}nm^4$ and less than or equal to 2.0 × $10^{15}$ $M^{-1}cm^{-1}nm^4$.

A Förster radius of the second dopant with respect to the first dopant may be greater than or equal to 4.5 nm, for example, greater than or equal to 5 nm and less then or equal to 10 nm. When the Förster radius of the second dopant with respect to the first dopant satisfies the above-described range, exciton transfer efficiency from the first dopant to the second dopant may be improved, and thus emission efficiency and/or lifespan of the light-emitting device may be improved.

An emission peak wavelength in an emission spectrum of the first dopant may be greater than or equal to 430 nm and less than or equal to 470 nm. The emission peak wavelength in the emission spectrum of the first dopant may be observed from the emission spectrum of the first dopant evaluated in the same manner as described in the present specification.

The emission peak wavelength in the emission spectrum of the first dopant may be greater than an absorption peak wavelength in an absorption spectrum of the second dopant. The emission peak wavelength in the emission spectrum of the first dopant and the absorption peak wavelength in the absorption spectrum of the second dopant may be respectively observed from the emission spectrum of the first dopant and the absorption spectrum of the second dopant, which are evaluated in the same manner as described in the present specification. In an embodiment, an absolute value of a difference between the emission peak wavelength in the emission spectrum of the first dopant and the absorption peak wavelength in the absorption spectrum of the second dopant may be greater than or equal to 5 nm and less than or equal to 50 nm.

A lowest excitation triplet energy level ($T_1$) of the first dopant may be greater than or equal to a lowest excitation singlet energy level ($S_1$) of the second dopant. The lowest excitation triplet energy level of the first dopant may be calculated by comparing a room-temperature emission spectrum with a low-temperature emission spectrum of the first dopant in a solution (for example, in a toluene solution), and the lowest excitation singlet energy level of the second dopant may be calculated from a room-temperature emission spectrum of the second dopant. In an embodiment, an absolute value of a difference between the lowest excitation triplet energy level of the first dopant and the lowest excitation singlet energy level of the second dopant may be greater than or equal to 0.0 eV and less than or equal to 1.0 eV, for example, greater than or equal to 0.0 eV and less than or equal to 0.3 eV. When the lowest excitation triplet energy level of the first dopant and the lowest excitation singlet energy level of the second dopant satisfy the above-described

relationship, excitons may be easily transferred from the first dopant to the second dopant, and thus emission efficiency and/or lifespan of the light-emitting device may be improved.

In an embodiment, excitons transition from a lowest excitation triplet energy level ($T_1$) of the first dopant to a lowest excitation singlet energy level ($S_1$) of the second dopant, and excitons at the lowest excitation singlet energy level ($S_1$) of the second dopant transition to a ground state, and thus light may be emitted from the emission layer. In this case, among the total emission components emitted from the emission layer, the proportion of emission components emitted from the second dopant may be greater than or equal to 80%, for example, greater than or equal to 90% and less than or equal to 100%. Meanwhile, among the total emission components emitted from the emission layer, the proportion of emission components emitted from the first dopant may be less than 20%, for example, greater than or equal to 0% and less than 20%.

An emission peak wavelength in an emission spectrum of the second dopant may be greater than or equal to 420 nm and less than or equal to 470 nm. The emission peak wavelength in the emission spectrum of the second dopant may be observed by using the same method as the method of observing the emission peak wavelength in the emission spectrum of the first dopant.

In an embodiment, the emission layer may emit blue light having an emission peak wavelength of greater than or equal to 420 nm and less than or equal to 470 nm. In an embodiment, the emission layer may emit blue light having a CIE x color coordinate of greater than or equal to 0.115 and less than or equal to 0.135 (for example, greater than or equal to 0.120 and less than or equal to 0.130) and a CIE y color coordinate of greater than or equal to 0.120 and less than or equal to 0.140 (for example, greater than or equal to 0.125 and less than or equal to 0.135). 80% or more, for example, 90% or more and 100% or less, of the total emission components of the blue light may be light emitted from the second dopant.

The sum of an amount of the first dopant and an amount of the second dopant may be less than an amount of the host. The amount may be a weight. In an embodiment, the sum of an amount of the first dopant and an amount of the second dopant may be, based on 100 parts by weight of the emission layer, 0.1 parts by weight to 30 parts by weight, 1 parts by weight to 20 parts by weight, or 5 parts by weight to 15 parts by weight.

A weight ratio of the first dopant to the second dopant in the emission layer may be in a range of 1 : 9 to 9 : 1, 2 : 8 to 8 : 2, 3 : 7 to 7 : 3, or 4 : 6 to 6 : 4.

When, in the emission layer, the amounts of the first dopant and the second dopant and the weight ratio of the first dopant to the second dopant satisfy the above-described ranges, quenching may be substantially prevented, and thus a light-emitting device having excellent emission efficiency and/or excellent lifespan may be embodied.

In an embodiment, the emission layer may consist of the host, the first dopant, and the second dopant, as described above.

As described above, since the emission layer of the light-emitting device includes the host, the first dopant, and the second dopant and satisfies the following conditions below

a) the first dopant is a phosphorescent dopant,
b) a Stokes shift of the second dopant is less than or equal to 15 nm, and
c) a spectral overlap integral of an emission spectrum of the first dopant and an absorption spectrum of the second dopant is greater than or equal to $1.5 \times 10^{15}$ $M^{-1}cm^{-1}nm^4$,

Förster resonance energy transfer (FRET) efficiency from the first dopant to the second dopant may be improved, a Förster radius of the second dopant with respect to the first dopant may increase, and thus emission efficiency (for example, external quantum efficiency) and lifespan of the light-emitting device may be improved.

In the light-emitting device,

the first electrode may be an anode,
the second electrode may be a cathode,
the interlayer may further include a hole transport region located between the first electrode and the emission layer and an electron transport region located between the emission layer and the second electrode,
the hole transport region may include a hole injection layer, a hole transport layer, an emission auxiliary layer, an electron blocking layer, or any combination thereof, and
the electron transport region may include a buffer layer, a hole blocking layer, an electron control layer, an electron transport layer, an electron injection layer, or any combination thereof.

In an embodiment, the light-emitting device may further include a capping layer located outside the first electrode or outside the second electronde.

In an embodiment, the light-emitting device may further include at least one of a first capping layer located outside the first electrode and a second capping layer located outside the second electrode. More details on the first

capping layer and/or the second capping layer are the same as described in the present specification.

According to another aspect, an electronic apparatus including the light-emitting device is provided. The electronic apparatus may further include a thin-film transistor. In one or more embodiments, the electronic apparatus may further include a thin-film transistor including a source electrode and a drain electrode, and the first electrode of the light-emitting device may be electrically connected to the source electrode or the drain electrode. In an embodiment, the electronic apparatus may further include a color filter, a color conversion layer, a touch screen layer, a polarizing layer, or any combination thereof. More details on the electronic apparatus are the same as described in the present specification.

[Description of FIG. 1]

FIG. 1 is a schematic cross-sectional view of a light-emitting device 10 according to an embodiment. The light-emitting device 10 includes a first electrode 110, an interlayer 130, and a second electrode 150.

Hereinafter, a structure of the light-emitting device 10 according to an embodiment and a method of manufacturing the light-emitting device 10 will be described in connection with FIG. 1.

[First electrode 110]

In FIG. 1, a substrate may be additionally located under the first electrode 110 or above the second electrode 150. The substrate may be a glass substrate or a plastic substrate. The substrate may be a flexible substrate. In one or more embodiments, the substrate may include plastics with excellent heat resistance and durability, such as polyimide, polyethylene terephthalate (PET), polycarbonate, polyethylene naphthalate, polyarylate (PAR), polyetherimide, or any combination thereof.

The first electrode 110 may be formed by, for example, depositing or sputtering a material for forming the first electrode 110 on the substrate. When the first electrode 110 is an anode, a high work function material that can easily inject holes may be used as a material for forming the first electrode 110.

The first electrode 110 may be a reflective electrode, a semi-transmissive electrode, or a transmissive electrode. When the first electrode 110 is a transmissive electrode, a material for forming the first electrode 110 may include indium tin oxide (ITO), indium zinc oxide (IZO), tin oxide ($SnO_2$), zinc oxide (ZnO), or any combination thereof. In one or more embodiments, when the first electrode 110 is a semi-transmissive electrode or a reflective electrode, magnesium (Mg), silver (Ag), aluminium (Al), aluminium-lithium (Al-Li), calcium (Ca), magnesium-indium (Mg-In), magnesium-silver (Mg-Ag), or any combination thereof may be used as a material for forming the first electrode 110.

The first electrode 110 may have a single-layered structure consisting of a single layer or a multi-layered structure including a plurality of layers. In an embodiment, the first electrode 110 may have a three-layered structure of ITO/Ag/ITO.

[Interlayer 130]

The interlayer 130 is located on the first electrode 110. The interlayer 130 includes an emission layer.

The interlayer 130 may further include a hole transport region located between the first electrode 110 and the emission layer and an electron transport region located between the emission layer and the second electrode 150.

The interlayer 130 may further include, in addition to various organic materials, inorganic materials such as quantum dots.

In one or more embodiments, the interlayer 130 may include, i) two or more emitting units sequentially stacked between the first electrode 110 and the second electrode 150 and ii) a charge generation layer located between the two emitting units. When the interlayer 130 includes the emitting units and the charge generation layer as described above, the light-emitting device 10 may be a tandem light-emitting device.

[Hole transport region in interlayer 130]

The hole transport region may have i) a single-layered structure consisting of a single layer consisting of a single material, ii) a single-layered structure consisting of a single layer including a plurality of different materials, or iii) a multi-layered structure including a plurality of layers including different materials.

The hole transport region may include a hole injection layer, a hole transport layer, an emission auxiliary layer, an electron blocking layer, or any combination thereof.

For example, the hole transport region may have a multi-layered structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, wherein, in each structure, layers are stacked sequentially from the first electrode 110.

The hole transport region may include a compound represented by Formula 201, a compound represented by Formula 202, or any combination thereof:

Formula 201

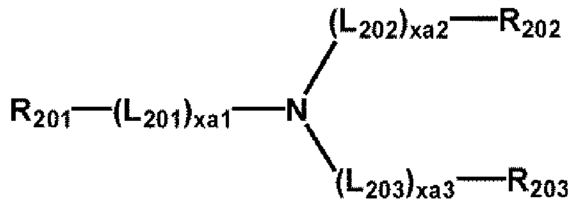

Formula 202

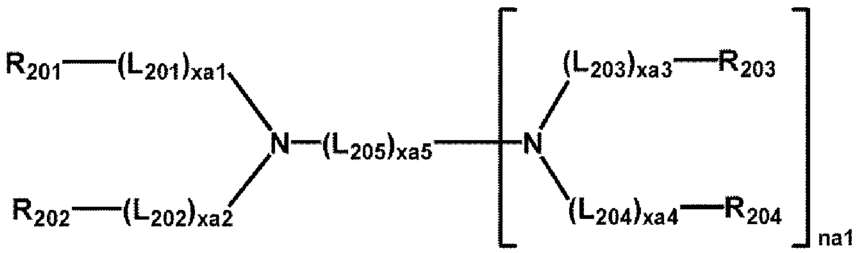

In Formulae 201 and 202,

$L_{201}$ to $L_{204}$ may each independently be a $C_3$-$C_{60}$ (e.g. $C_3$-$C_{30}$) carbocyclic group unsubstituted or substituted with at least one $R_{10a}$ or a $C_1$-$C_{60}$ (e.g. $C_1$-$C_{20}$) heterocyclic group unsubstituted or substituted with at least one $R_{10a}$,
$L_{205}$ may be *-O-*', *-S-*', *-N($Q_{201}$)-*', a $C_1$-$C_{20}$ (e.g. $C_1$-$C_{10}$) alkylene group unsubstituted or substituted with at least one $R_{10a}$, a $C_2$-$C_{20}$ (e.g. $C_2$-$C_{10}$) alkenylene group unsubstituted or substituted with at least one $R_{10a}$, a $C_3$-$C_{60}$ (e.g. $C_3$-$C_{30}$) carbocyclic group unsubstituted or substituted with at least one $R_{10a}$, or a $C_1$-$C_{60}$ (e.g. $C_1$-$C_{20}$) heterocyclic group unsubstituted or substituted with at least one $R_{10a}$,
xa1 to xa4 may each independently be an integer from 0 to 5,
xa5 may be an integer from 1 to 10,
$R_{201}$ to $R_{204}$ and $Q_{201}$ may each independently be a $C_3$-$C_{60}$ (e.g. $C_3$-$C_{30}$) carbocyclic group unsubstituted or substituted with at least one $R_{10a}$ or a $C_1$-$C_{60}$ (e.g. $C_1$-$C_{20}$) heterocyclic group unsubstituted or substituted with at least one $R_{10a}$,
$R_{201}$ and $R_{202}$ may optionally be linked to each other via a single bond, a $C_1$-$C_5$ alkylene group unsubstituted or substituted with at least one $R_{10a}$, or a $C_2$-$C_5$ alkenylene group unsubstituted or substituted with at least one $R_{10a}$, to form a $C_8$-$C_{60}$ (e.g. $C_8$-$C_{30}$) polycyclic group unsubstituted or substituted with at least one $R_{10a}$ (for example, a carbazole group) (for example, see Compound HT16 or the like),
$R_{203}$ and $R_{204}$ may optionally be linked to each other via a single bond, a $C_1$-$C_5$ alkylene group unsubstituted or substituted with at least one $R_{10a}$, or a $C_2$-$C_5$ alkenylene group unsubstituted or substituted with at least one $R_{10a}$, to form a $C_8$-$C_{60}$ (e.g. $C_8$-$C_{30}$) polycyclic group unsubstituted or substituted with at least one $R_{10a}$, and
na1 may be an integer from 1 to 4.

In an embodiment, Formulae 201 and 202 may each include at least one of the groups represented by Formulae CY201 to CY217:

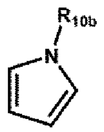
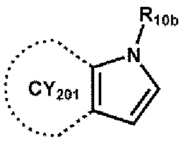
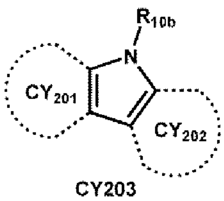
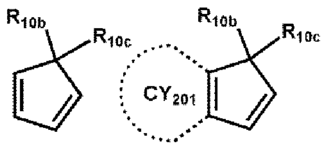
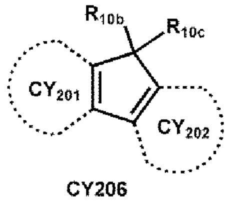

CY201 CY202 CY203 CY204 CY205 CY206

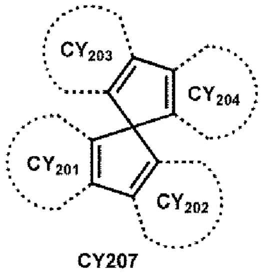
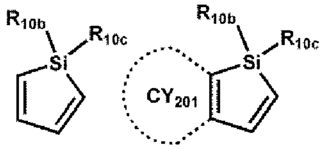
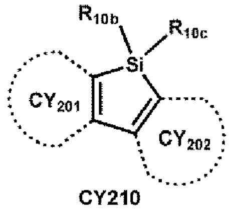
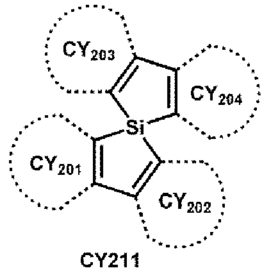

CY207 CY208 CY209 CY210 CY211

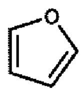
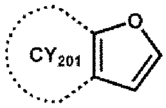
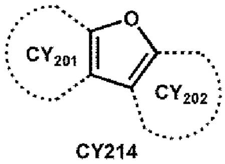
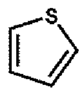
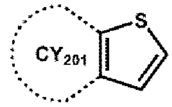
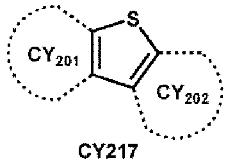

CY212 CY213 CY214 CY215 CY216 CY217

Regarding Formulae CY201 to CY217, $R_{10b}$ and $R_{10c}$ are the same as described in connection with $R_{10a}$, ring $CY_{201}$ to ring $CY_{204}$ may each independently be a $C_3$-$C_{20}$ carbocyclic group or a $C_1$-$C_{20}$ heterocyclic group, and at least one hydrogen in Formulae CY201 to CY217 may be unsubstituted or substituted with at least one $R_{10a}$ described herein.

In an embodiment, ring $CY_{201}$ to ring $CY_{204}$ in Formulae CY201 to CY217 may each independently be a benzene group, a naphthalene group, a phenanthrene group, or an anthracene group.

In an embodiment, Formulae 201 and 202 may each include at least one of the groups represented by Formulae CY201 to CY203.

In an embodiment, Formula 201 may include at least one of the groups represented by Formulae CY201 to CY203 and at least one of the groups represented by Formulae CY204 to CY217.

In one or more embodiments, in Formula 201, xa1 is 1, $R_{201}$ is a group represented by one of Formulae CY201 to CY203, xa2 is 0, and $R_{202}$ is a group represented by one of Formulae CY204 to CY207.

In one or more embodiments, each of Formulae 201 and 202 may not include groups represented by Formulae CY201 to CY203.

In one or more embodiments, each of Formulae 201 and 202 may not include groups represented by Formulae CY201 to CY203 and may include at least one of the groups represented by Formulae CY204 to CY217.

In an embodiment, each of Formulae 201 and 202 may not include groups represented by Formulae CY201 to CY217.

In an embodiment, the hole transport region may include one of Compounds HT1 to HT46, m-MTDATA, TDATA, 2-TNATA, NPB(NPD), β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), or any combination thereof:

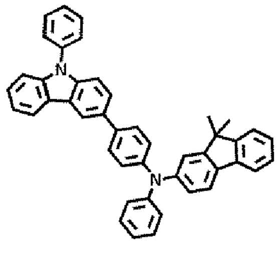
HT1

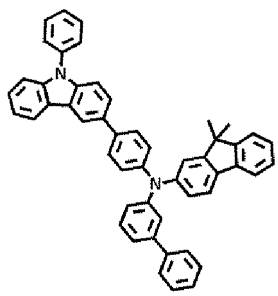
HT2

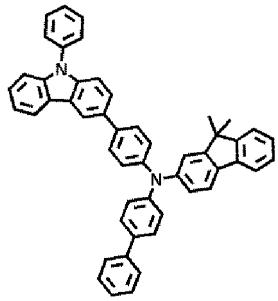
HT3

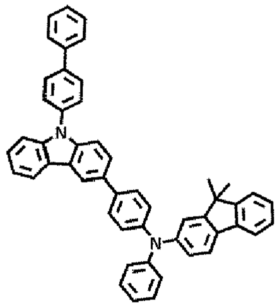
HT4

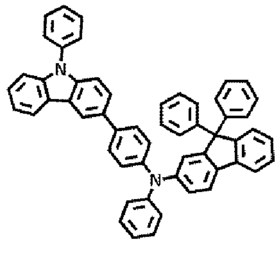
HT5

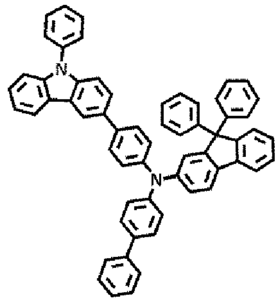
HT6

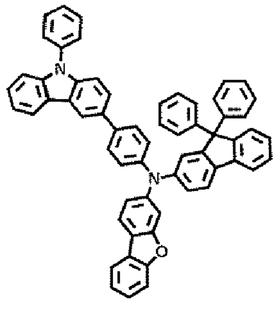
HT7

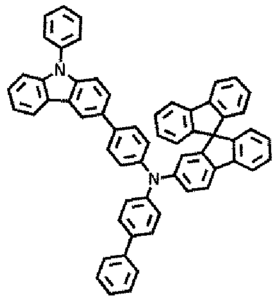
HT8

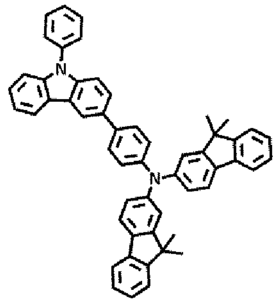
HT9

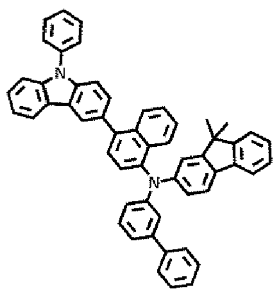
HT10

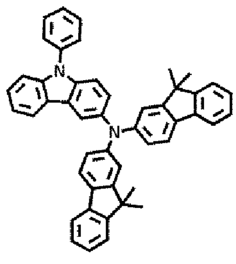
HT11

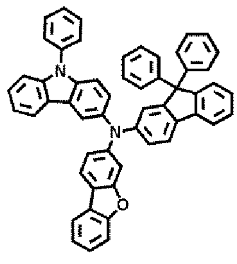
HT12

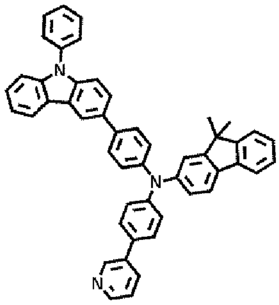
HT13

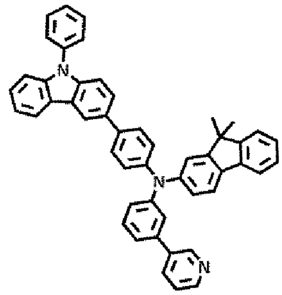
HT14

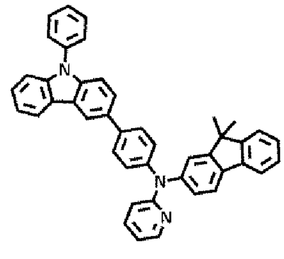
HT15

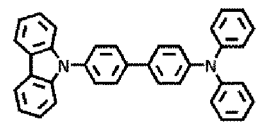

HT16

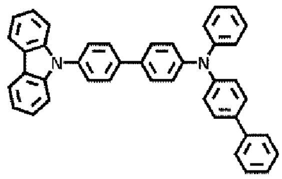

HT17

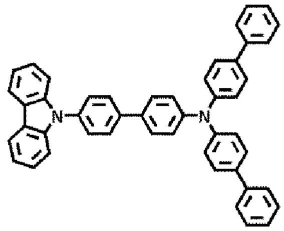

HT18

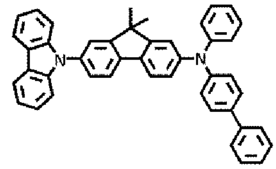

HT19

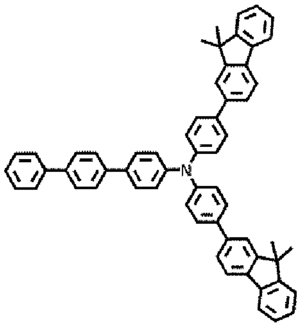

HT20

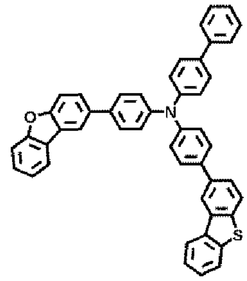

HT21

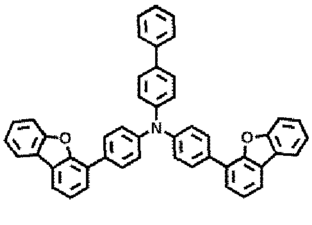

HT22

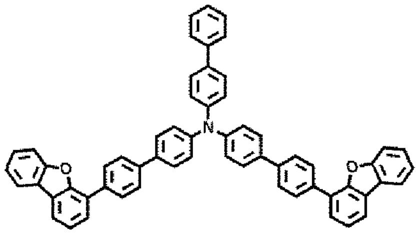

HT23

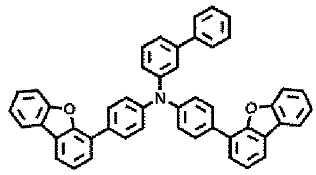

HT24

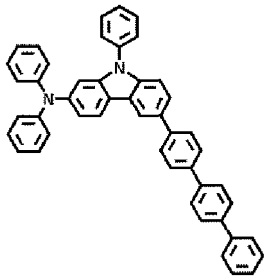

HT25

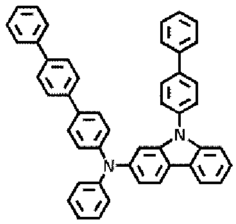

HT26

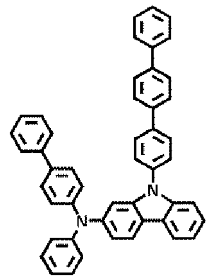

HT27

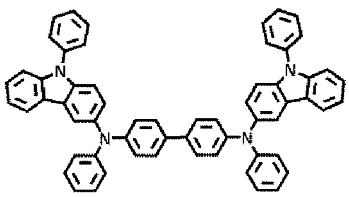

HT28

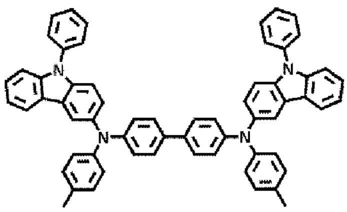

HT29

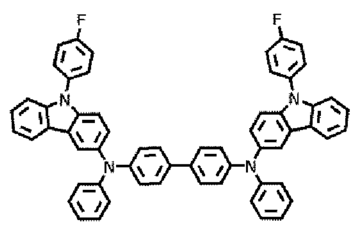

HT30

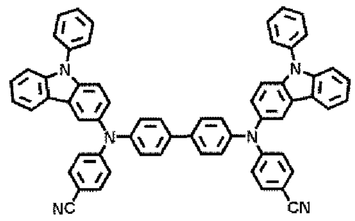
HT31

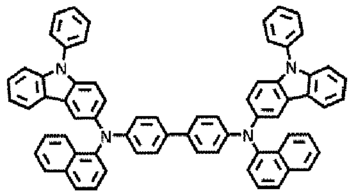
HT32

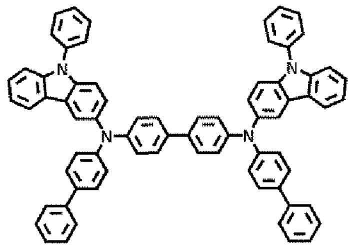
HT33

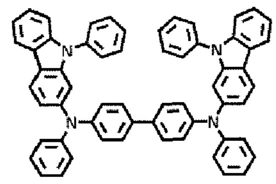
HT34

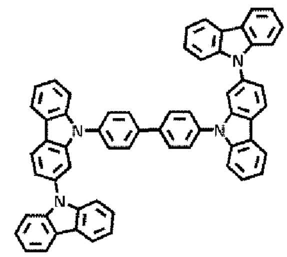
HT35

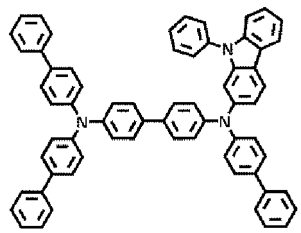
HT36

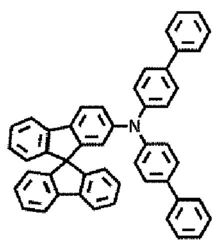
HT37

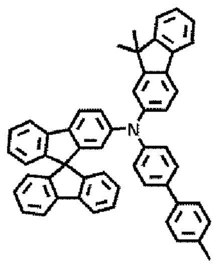
HT38

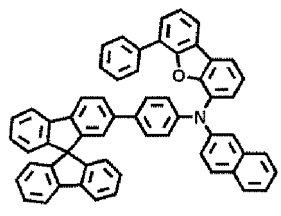
HT39

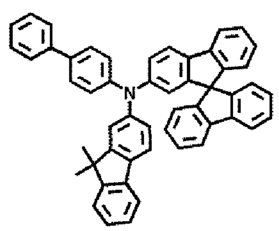
HT40

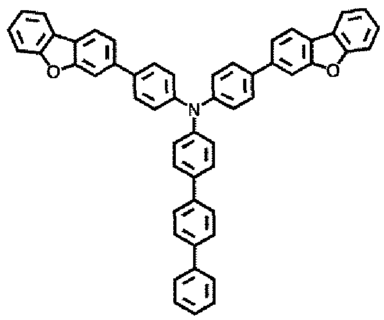
HT41

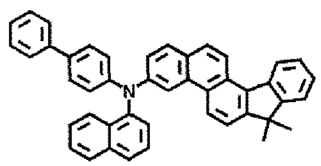
HT42

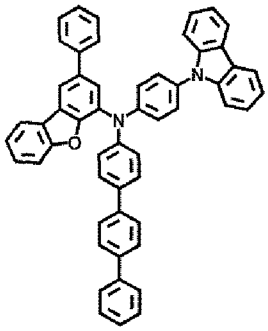
HT43

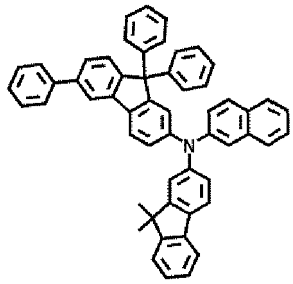
HT44

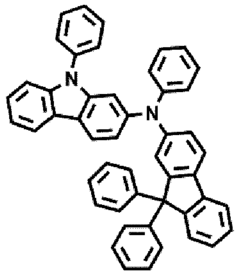

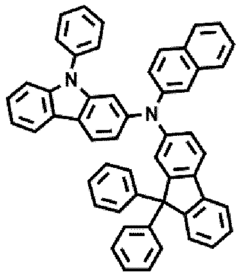

HT45 HT46

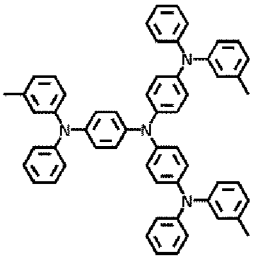

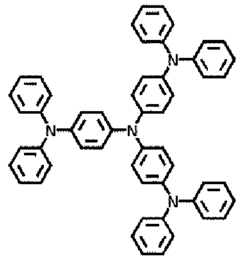

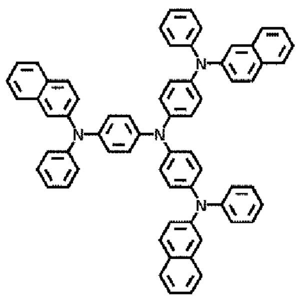

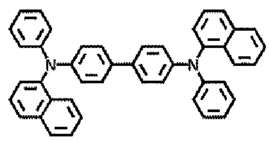

m-MTDATA TDATA 2-TNATA NPB

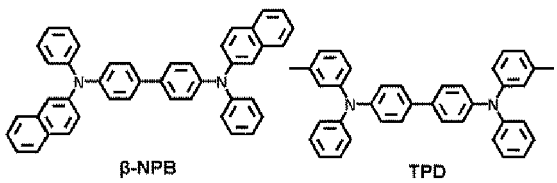

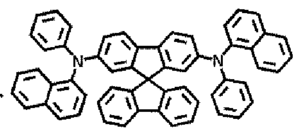

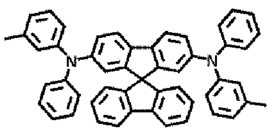

β-NPB TPD Spiro-TPD Spiro-NPB

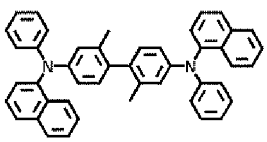

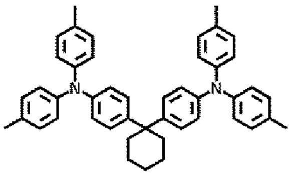

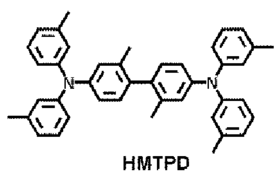

methylated-NPB TAPC HMTPD

A thickness of the hole transport region may be in a range of about 50 Å to about 10,000 Å, for example, about 100 Å to about 7,000 Å, about 100 Å to about 5,000 Å, about 100 Å to about 4,000 Å or about 100 Å to about 1,000 Å. When the hole transport region includes a hole injection layer, a hole transport layer, or any combination thereof, a thickness of the hole injection layer may be in a range of about 100 Å to about 9,000 Å, for example, about 100 Å to about 7,000 Å, about 100 Å to about 5,000 Å, about 100 Å to about 3,000 Å, about 100 Å to about 2,000 Å, about 100 Å to about 1,000 Å or about 500 Å to about 700 Å, and a thickness of the hole transport layer may be in a range of about 50 Å to about 2,000 Å or about 200 Å to about 400 Å, for example, about 100 Å to about 1,500 Å. When the thicknesses of the hole transport region, the hole injection layer, and the hole transport layer are within these ranges, satisfactory hole transporting characteristics may be obtained without a substantial increase in driving voltage.

The emission auxiliary layer may increase light-emission efficiency by compensating for an optical resonance distance according to the wavelength of light emitted by an emission layer, and the electron blocking layer may prevnet the leakage of electrons from an emission layer to a hole transport region. The emission auxiliary layer and the electron blocking layer may include the materials as described above.

[p-dopant]

The hole transport region may further include, in addition to these materials, a charge-generating material for the improvement of conductive properties. The charge-generating material may be uniformly or non-uniformly dispersed

in the hole transport region (for example, in the form of a single layer consisting of a charge-generating material).

The charge-generating material may be, for example, a p-dopant.

In an embodiment, a lowest unoccupied molecular orbital (LUMO) energy level of the p-dopant may be -3.5 eV or less.

In an embodiment, the p-dopant may include a quinone derivative, a cyano group-containing compound, a compound containing element EL1 and element EL2, or any combination thereof.

Examples of the quinone derivative may include TCNQ and F4-TCNQ.

Examples of the cyano group-containing compound may include HAT-CN and a compound represented by Formula 221 below.

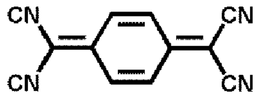

TCNQ

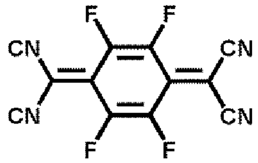

F4-TCNQ

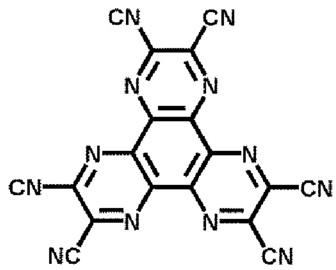

HAT-CN

Formula 221

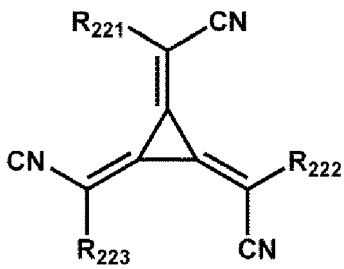

In Formula 221,

$R_{221}$ to $R_{223}$ may each independently be a $C_3$-$C_{60}$ (*e.g.* $C_3$-$C_{30}$) carbocyclic group unsubstituted or substituted with at least one $R_{10a}$ or a $C_1$-$C_{60}$ (*e.g.* $C_1$-$C_{20}$) heterocyclic group unsubstituted or substituted with at least one $R_{10a}$, at least one of $R_{221}$ to $R_{223}$ may each independently be a $C_3$-$C_{60}$ (*e.g.* $C_3$-$C_{30}$) carbocyclic group or a $C_1$-$C_{60}$ (e.g. $C_1$-$C_{20}$) heterocyclic group, each substituted with: a cyano group; -F; -Cl; -Br; -I; a $C_1$-$C_{20}$ (*e.g.* $C_1$-$C_{10}$) alkyl group substituted with a cyano group, -F, -Cl, -Br, -I, or any combination thereof; or any combination thereof.

Regarding the compound containing element EL1 and element EL2, element EL1 may be metal, metalloid, or a combination thereof, and element EL2 may be a non-metal, metalloid, or a combination thereof.

Examples of the metal may include: an alkali metal (for example, lithium (Li), sodium (Na), potassium (K), rubidium (Rb), cesium (Cs), or the like); an alkaline earth metal (for example, beryllium (Be), magnesium (Mg), calcium (Ca), strontium (Sr), barium (Ba), or the like); a transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper(Cu), silver (Ag), gold (Au), or the like); a post-transition metal (for example, zinc (Zn), indium (In), tin (Sn), or the like); and a lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), ruthenium (Ru), or the like).

Examples of the metalloid may include silicon (Si), antimony (Sb), and tellurium (Te).

Examples of the non-metal may include oxygen (O) and halogen (for example, F, Cl, Br, I, etc.).

In an embodiment, examples of the compound containing element EL1 and element EL2 may include metal oxide, metal halide (for example, metal fluoride, metal chloride, metal bromide, or metal iodide), metalloid halide (for

example, metalloid fluoride, metalloid chloride, metalloid bromide, or metalloid iodide), metal telluride, or any combination thereof.

Examples of the metal oxide may include tungsten oxide (for example, WO, $W_2O_3$, $WO_2$, $WO_3$, or $W_2O_5$), vanadium oxide (for example, VO, $V_2O_3$, $VO_2$, or $V_2O_5$), molybdenum oxide (MoO, $Mo_2O_3$, $MoO_2$, MoOs, or $Mo_2O_5$), and rhenium oxide (for example, ReOs).

Examples of the metal halide may include alkali metal halide, alkaline earth metal halide, transition metal halide, post-transition metal halide, and lanthanide metal halide.

Examples of the alkali metal halide may include LiF, NaF, KF, RbF, CsF, LiCl, NaCl, KCl, RbCl, CsCl, LiBr, NaBr, KBr, RbBr, CsBr, LiI, NaI, KI, RbI, and CsI.

Examples of the alkaline earth metal halide may include $BeF_2$, $MgF_2$, $CaF_2$, $SrF_2$, $BaF_2$, $BeCl_2$, $MgCl_2$, $CaCl_2$, $SrCl_2$, $BaCl_2$, $BeBr_2$, $MgBr_2$, $CaBr_2$, $SrBr_2$, $BaBr_2$, $BeI_2$, $MgI_2$, $CaI_2$, $SrI_2$, and $BaI_2$.

Examples of the transition metal halide may include titanium halide (for example, $TiF_4$, $TiCl_4$, $TiBr_4$, or $TiI_4$), zirconium halide (for example, $ZrF_4$, $ZrCl_4$, $ZrBr_4$, or $ZrI_4$), hafnium halide (for example, $HfF_4$, $HfCl_4$, $HfBr_4$, or $HfI_4$), vanadium halide (for example, $VF_3$, $VCl_3$, VBrs, or $VI_3$), niobium halide (for example, NbFs, $NbCl_3$, $NbBr_3$, or $NbI_3$), tantalum halide (for example, $TaF_3$, $TaCl_3$, TaBrs, or $TaI_3$), chromium halide (for example, CrFs, $CrCl_3$, $CrBr_3$, or $CrI_3$), molybdenum halide (for example, $MoF_3$, $MoCl_3$, MoBrs, or $MoI_3$), tungsten halide (for example, $WF_3$, $WCl_3$, WBrs, or $WI_3$), manganese halide (for example, $MnF_2$, $MnCl_2$, $MnBr_2$, or $MnI_2$), technetium halide (for example, $TcF_2$, $TcCl_2$, $TcBr_2$, or $TcI_2$), rhenium halide (for example, $ReF_2$, $ReCl_2$, $ReBr_2$, or $ReI_2$), iron halide (for example, $FeF_2$, $FeCl_2$, $FeBr_2$, or $FeI_2$), ruthenium halide (for example, $RuF_2$, $RuCl_2$, $RuBr_2$, or $RuI_2$), osmium halide (for example, $OsF_2$, $OsCl_2$, $OsBr_2$, or $OsI_2$), cobalt halide (for example, $CoF_2$, $CoCl_2$, $CoBr_2$, or $CoI_2$), rhodium halide (for example, $RhF_2$, $RhCl_2$, $RhBr_2$, or $RhI_2$), iridium halide (for example, $IrF_2$, $IrCl_2$, $IrBr_2$, or $IrI_2$), nickel halide (for example, $NiF_2$, $NiCl_2$, $NiBr_2$, or $NiI_2$), palladium halide (for example, $PdF_2$, $PdCl_2$, $PdBr_2$, or $PdI_2$), platinum halide (for example, $PtF_2$, $PtCl_2$, $PtBr_2$, or $PtI_2$), copper halide (for example, CuF, CuCl, CuBr, or CuI), silver halide (for example, AgF, AgCl, AgBr, or AgI), and gold halide (for example, AuF, AuCl, AuBr, or AuI).

Examples of the post-transition metal halide may include zinc halide (for example, $ZnF_2$, $ZnCl_2$, $ZnBr_2$, or $ZnI_2$), indium halide (for example, $InI_3$), and tin halide (for example, $SnI_2$).

Examples of the lanthanide metal halide may include YbF, $YbF_2$, $YbF_3$, $SmF_3$, YbCl, $YbCl_2$, $YbCl_3$, $SmCl_3$, YbBr, $YbBr_2$, $YbBr_3$, $SmBr_3$, YbI, $YbI_2$, $YbI_3$, and $SmI_3$.

Examples of the metalloid halide may include antimony halide (for example, $SbCl_5$).

Examples of the metal telluride may include an alkali metal telluride (for example, $Li_2Te$, $Na_2Te$, $K_2Te$, $Rb_2Te$, or $Cs_2Te$), alkaline earth metal telluride (for example, BeTe, MgTe, CaTe, SrTe, or BaTe), transition metal telluride (for example, $TiTe_2$, $ZrTe_2$, $HfTe_2$, $V_2Te_3$, $Nb_2Te_3$, $Ta_2Te_3$, $Cr_2Te_3$, $Mo_2Te_3$, $W_2Te_3$, MnTe, TcTe, ReTe, FeTe, RuTe, OsTe, CoTe, RhTe, IrTe, NiTe, PdTe, PtTe, $Cu_2Te$, CuTe, $Ag_2Te$, AgTe, or $Au_2Te$), post-transition metal telluride (for example, ZnTe), and lanthanide metal telluride (for example, LaTe, CeTe, PrTe, NdTe, PmTe, EuTe, GdTe, TbTe, DyTe, HoTe, ErTe, TmTe, YbTe, or LuTe).

[Emission layer in interlayer 130]

When the light-emitting device 10 is a full-color light-emitting device, the emission layer may be patterned into a red emission layer, a green emission layer, and/or a blue emission layer, according to a sub-pixel. In one or more embodiments, the emission layer may have a stacked structure of two or more layers of a red emission layer, a green emission layer, and a blue emission layer, in which the two or more layers contact each other or are separated from each other to emit white light. In one or more embodiments, the emission layer may include two or more materials of a red light-emitting material, a green light-emitting material, and a blue light-emitting material, in which the two or more materials are mixed with each other in a single layer to emit white light.

The emission layer may include a host, a first dopant, and a second dopant. The emission layer, the host, the first dopant, and the second dopant are the same as described in the present specification.

Examples of the host, the first dopant, and the second dopant, which are included in the emission layer, are the same as described below.

A thickness of the emission layer may be in the range of about 100 Å to about 1,000 Å, for example, about 100 Å to about 800 Å, about 150 Å to about 800 Å, about 150 Å to about 700 Å, about 150 Å to about 650 Å, about 200 Å to about 600 Å about 200 Å to about 400 Å. When the thickness of the emission layer is within this range, excellent luminescence characteristics may be obtained without a substantial increase in driving voltage.

[Host]

In an embodiment, the host may be a hole transport compound.

In an embodiment, the host may be an electron transport compound.

In an embodiment, the host may include a first host and a second host, the first host and the second host may be different from each other, and i) the first host may be a hole transport compound, and the second host may be an electron transport compound, ii) both the first host and the second host may be hole transport compounds, or iii) both the first host and the second host may be electron transport compounds. The first host and the second host may form an exciplex.

In an embodiment, the host may form an exciplex with the first dopant.

The hole transport compound in the present specification may be a compound that does not include an electron transport moiety.

The electron transport compound in the present specification may be a compound that includes at least one electron transport moiety.

The term "electron transport moiety" used herein may include a cyano group, a phosphine oxide group, a sulfoxide group, a sulfonate group, a $\pi$ electron-deficient nitrogen-containing $C_1$-$C_{60}$ (e.g. $C_1$-$C_{20}$) cyclic group, or any combination thereof.

In an embodiment, the host, the first host, and the second host may each independently include a compound represented by Formula 1 or a compound represented by Formula 2:

Formula 1

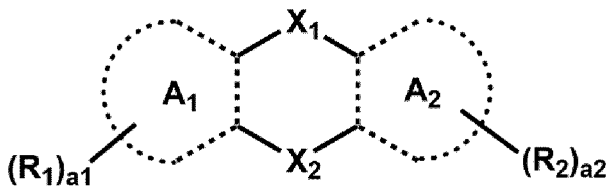

Formula 2

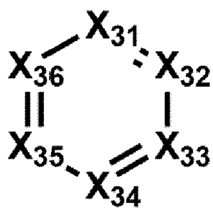

In Formulae 1 and 2,

$X_1$ is O, S, $N(R_3)$, or $C(R_3)(R_4)$,

$X_2$ is a single bond, O, S, $N(R_5)$, or $C(R_5)(R_6)$,

ring $A_1$ and ring $A_2$ are each independently a $C_3$-$C_{60}$ (e.g. $C_3$-$C_{30}$) carbocyclic group or a $C_1$-$C_{60}$ (e.g. $C_1$-$C_{20}$) heterocyclic group,

$R_1$ to $R_6$ are each independently hydrogen, deuterium, -F, -Cl, -Br, -I, a hydroxyl group, a cyano group, a nitro group, a $C_1$-$C_{60}$ (e.g. $C_1$-$C_{20}$) alkyl group unsubstituted or substituted with at least one $R_{10a}$, a $C_2$-$C_{60}$ (e.g. $C_2$-$C_{20}$) alkenyl group unsubstituted or substituted with at least one $R_{10a}$, a $C_2$-$C_{60}$ (e.g. $C_2$-$C_{20}$) alkynyl group unsubstituted or substituted with at least one $R_{10a}$, a $C_1$-$C_{60}$ (e.g. $C_1$-$C_{20}$) alkoxy group unsubstituted or substituted with at least one $R_{10a}$, a $C_3$-$C_{60}$ (e.g. $C_3$-$C_{30}$) carbocyclic group unsubstituted or substituted with at least one $R_{10a}$, a $C_1$-$C_{60}$ (e.g. $C_1$-$C_{20}$) heterocyclic group unsubstituted or substituted with at least one $R_{10a}$, a $C_6$-$C_{60}$ (e.g. $C_6$-$C_{30}$) aryloxy group unsubstituted or substituted with at least one $R_{10a}$, a $C_6$-$C_{60}$ (e.g. $C_6$-$C_{30}$) arylthio group unsubstituted or substituted with at least one $R_{10a}$, $-Si(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, $-P(=O)(Q_1)(Q_2)$, or $-P(=S)(Q_1)(Q_2)$,

a1 and a2 are each independently 1, 2, 3, 4, 5, or 6,

$X_{31}$ is N or $C(R_{31})$; $X_{32}$ is N or $C(R_{32})$; $X_{33}$ is N or $C(R_{33})$; $X_{34}$ is N or $C(R_{34})$; $X_{35}$ is N or $C(R_{35})$; $X_{36}$ is N or $C(R_{36})$, and at least one of $X_{31}$ to $X_{36}$ is N;

$R_{31}$ to $R_{36}$ are each independently hydrogen, deuterium, a $C_1$-$C_{60}$ (e.g. $C_1$-$C_{20}$) alkyl group unsubstituted or substituted with at least one $R_{10a}$, a $C_3$-$C_{60}$ (e.g. $C_3$-$C_{30}$) carbocyclic group unsubstituted or substituted with at least one $R_{10a}$, or a $C_1$-$C_{60}$ (e.g. $C_1$-$C_{20}$) heterocyclic group unsubstituted or substituted with at least one $R_{10a}$, and

$R_{10a}$ and $Q_1$ to $Q_3$ are the same as described in the present specification.

In an embodiment, the first host may include a compound represented by Formula 1, and the second host may include a compound represented by Formula 2.

In one or more embodiments, the host, the first host, and the second host may each independently include a compound represented by Formula 301:

Formula 301 $$[Ar_{301}]_{xb11}-[(L_{301})_{xb1}-R_{301}]_{xb21}$$

In Formula 301,

$Ar_{301}$ and $L_{301}$ may each independently be a $C_3$-$C_{60}$ (e.g. $C_3$-$C_{30}$) carbocyclic group unsubstituted or substituted with at least one $R_{10a}$ or a $C_1$-$C_{60}$ (e.g. $C_1$-$C_{20}$) heterocyclic group unsubstituted or substituted with at least one $R_{10a}$,
xb11 may be 1, 2, or 3,
xb1 may be an integer from 0 to 5,
$R_{301}$ may be hydrogen, deuterium, -F, -Cl, -Br, -I, a hydroxyl group, a cyano group, a nitro group, a $C_1$-$C_{60}$ (e.g. $C_1$-$C_{20}$) alkyl group unsubstituted or substituted with at least one $R_{10a}$, a $C_2$-$C_{60}$ (e.g. $C_2$-$C_{20}$) alkenyl group unsubstituted or substituted with at least one $R_{10a}$, a $C_2$-$C_{60}$ (e.g. $C_2$-$C_{20}$) alkynyl group unsubstituted or substituted with at least one $R_{10a}$, a $C_1$-$C_{60}$ (e.g. $C_1$-$C_{20}$) alkoxy group unsubstituted or substituted with at least one $R_{10a}$, a $C_3$-$C_{60}$ (e.g. $C_3$-$C_{30}$) carbocyclic group unsubstituted or substituted with at least one $R_{10a}$, a $C_1$-$C_{60}$ (e.g. $C_1$-$C_{20}$) heterocyclic group unsubstituted or substituted with at least one $R_{10a}$, $-Si(Q_{301})(Q_{302})(Q_{303})$, $-N(Q_{301})(Q_{302})$, $-B(Q_{301})(Q_{302})$, $-C(=O)(Q_{301})$, $-S(=O)_2(Q_{301})$, or $-P(=O)(Q_{301})(Q_{302})$,
xb21 may be an integer from 1 to 5, and
$Q_{301}$ to $Q_{303}$ are the same as described in connection with $Q_1$.

In an embodiment, when xb11 in Formula 301 is 2 or more, two or more of $Ar_{301}$(s) may be linked to each other via a single bond.

In an embodiment, in Formula 301, $Ar_{301}$ and $L_{301}$ may each independently be a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a pyridine group, a pyrimidine group, a triazine group, a phenanthroline group, a diazole group, or a triazole group.

In an embodiment, at least one of $R_{301}$(s) in Formula 301 may be $-N(Q_{301})(Q_{302})$.

In an embodiment, the host, the first host, and the second host may each independently include a compound represented by Formula 301-1, a compound represented by Formula 301-2, or any combination thereof.

Formula 301-1

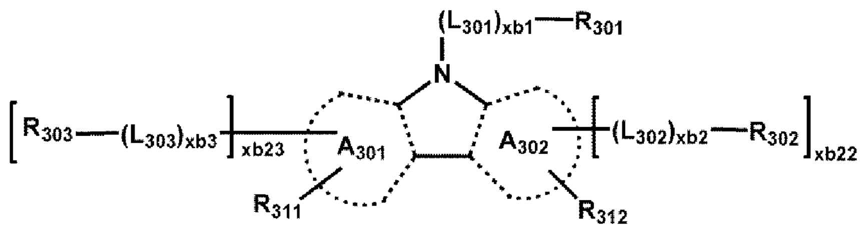

Formula 301-2

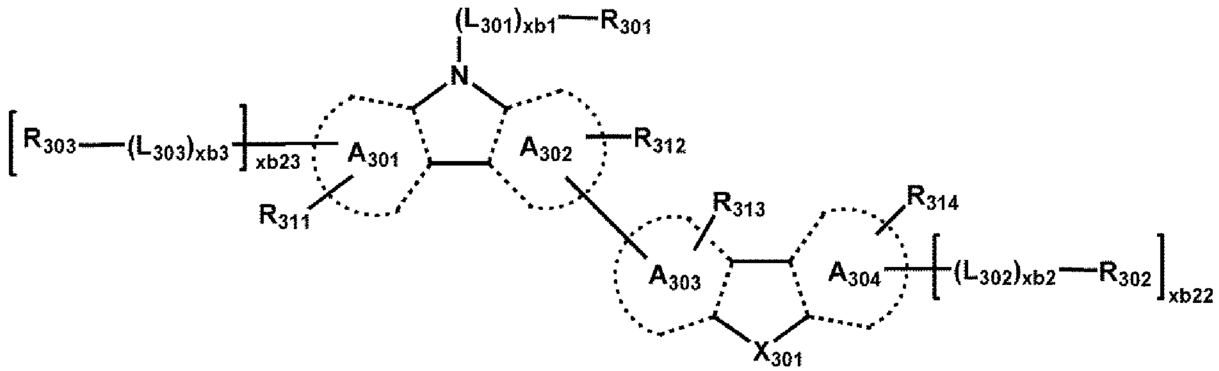

In Formulae 301-1 and 301-2,

ring $A_{301}$ to ring $A_{304}$ are each independently a $C_3$-$C_{60}$ (*e.g.* $C_3$-$C_{30}$) carbocyclic group unsubstituted or substituted with at least one $R_{10a}$ or a $C_1$-$C_{60}$ (*e.g.* $C_1$-$C_{20}$) heterocyclic group unsubstituted or substituted with at least one $R_{10a}$,
$X_{301}$ is O, S, N-[$(L_{304})_{xb4}$-$R_{304}$], $C(R_{304})(R_{305})$, or $Si(R_{304})(R_{305})$,
xb22 and xb23 are each independently 0, 1, or 2,
$L_{301}$, xb1, and $R_{301}$ are the same as described in the present specification,
$L_{302}$ to $L_{304}$ are each independently the same as described in connection with $L_{301}$,
xb2 to xb4 are each independently the same as described in connection with xb1, and
$R_{302}$ to $R_{305}$ and $R_{311}$ to $R_{314}$ are the same as described in connection with $R_{301}$.

In an embodiment, ring $A_{301}$ to ring $A_{304}$ may each independently be a benzene group, a naphthalene group, a phenanthrene group, a fluoranthene group, a triphenylene group, a pyrene group, a chrysene group, a pyridine group, a pyrimidine group, an indene group, a fluorene group, a spiro-bifluorene group, a benzofluorene group, a dibenzofluorene group, an indole group, a carbazole group, a benzocarbazole group, a dibenzocarbazole group, a furan group, a benzofuran group, a dibenzofuran group, a naphthofuran group, a benzonaphthofuran group, a dinaphthofuran group, a thiophene group, a benzothiophene group, a dibenzothiophene group, a naphthothiophene group, a benzonaphthothiophene group, or dinaphthothiophene group, each unsubstituted or substituted with at least one $R_{10a}$.

In an embodiment, the host may include an alkaline earth metal complex, a post-transition metal complex, or any combination thereof. In an embodiment, the host may include a Be complex (for example, Compound H55), a Mg complex, a Zn complex, or any combination thereof.

In an embodiment, the host may include one of Compounds H1 to H130, 9,10-di(2-naphthyl)anthracene (ADN), 2-methyl-9,10-bis(naphthalen-2-yl)anthracene (MADN), 9,10-di-(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), 3,3'-di(9H-carbazol-9-yl)-1,1'-biphenyl (mCBP), or any combination thereof:

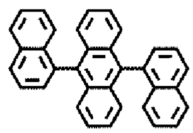

H1

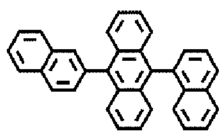

H2

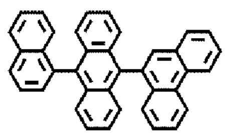

H3

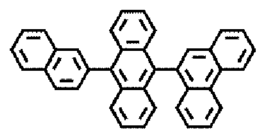

H4

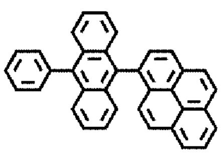

H5

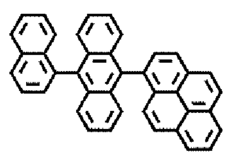

H6

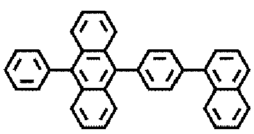

H7

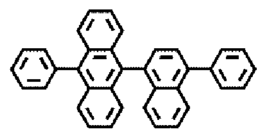

H8

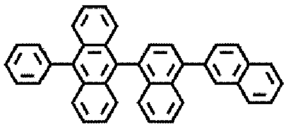
H9

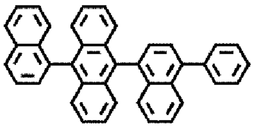
H10

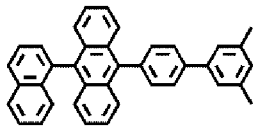
H11

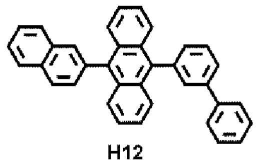
H12

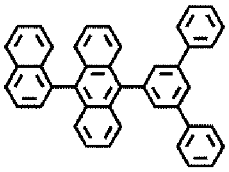
H13

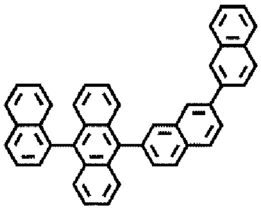
H14

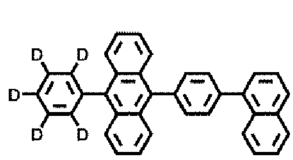
H15

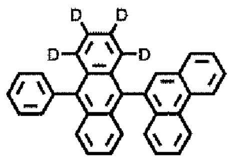
H16

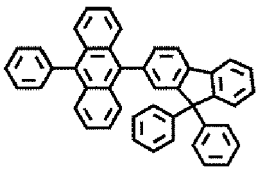
H17

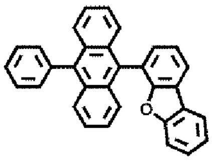
H18

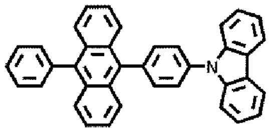
H19

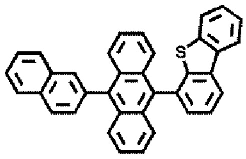
H20

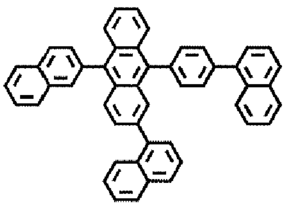
H21

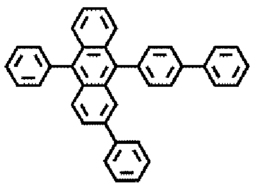
H22

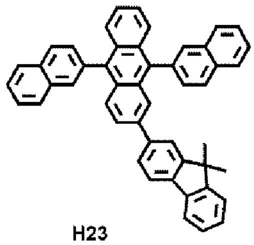
H23

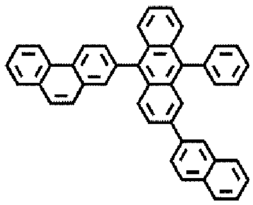
H24

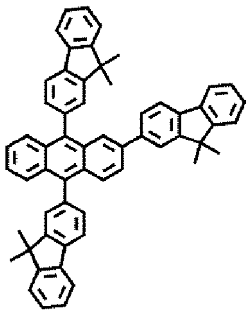
H25

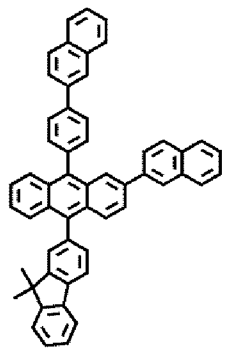
H26

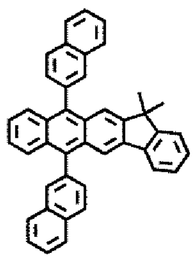
H27

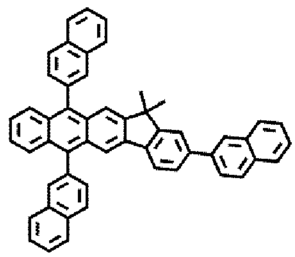
H28

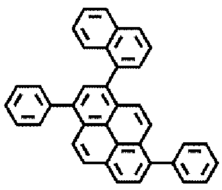
H29

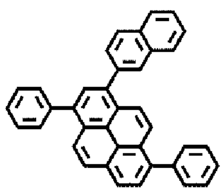
H30

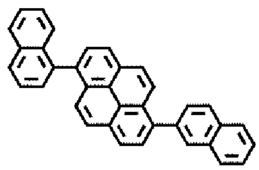
H31

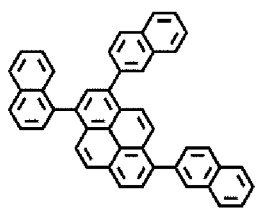
H32

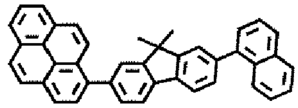
H33

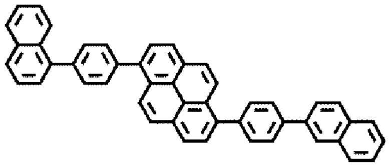
H34

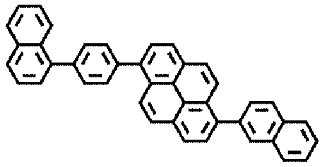
H35

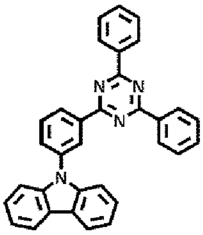
H36

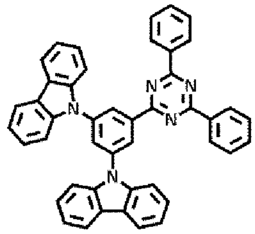
H37

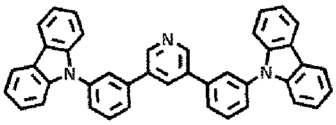
H38

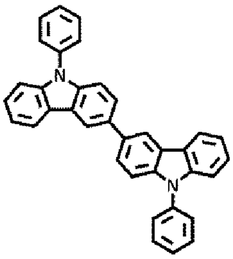
H39

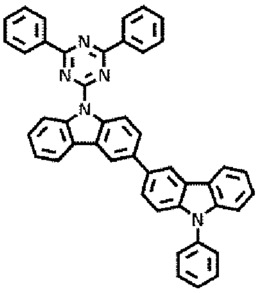
H40

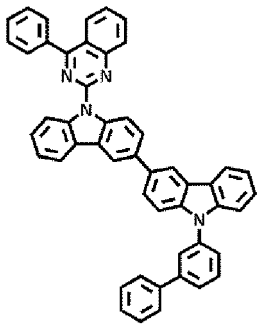
H41

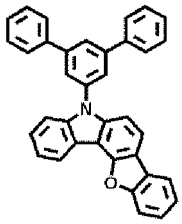
H42

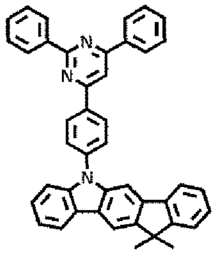
H43

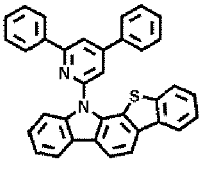
H44

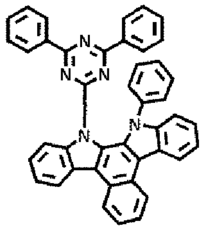
H45

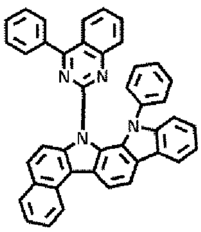
H46

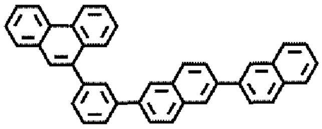
H47

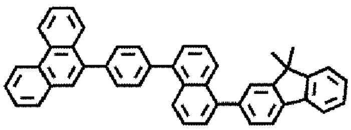
H48

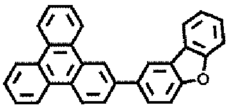
H49

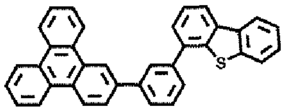
H50

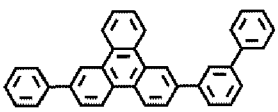
H51

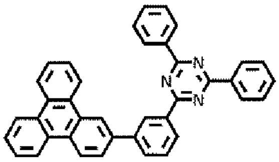
H52

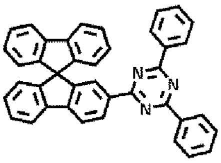
H53

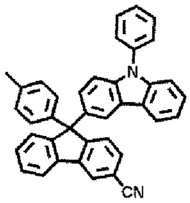
H54

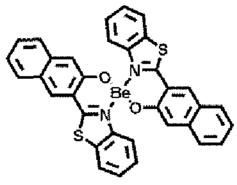
H55

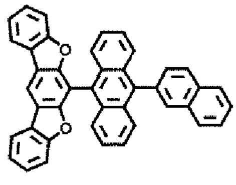
H56

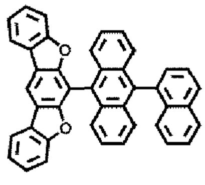
H57

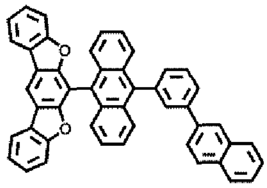
H58

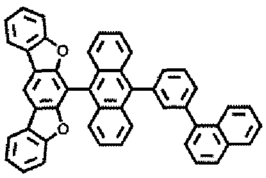
H59

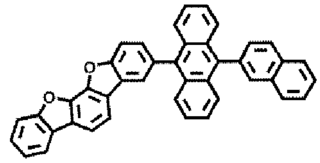
H60

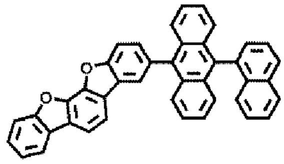
H61

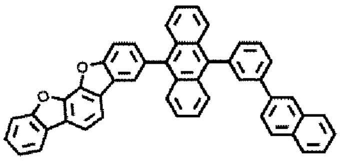
H62

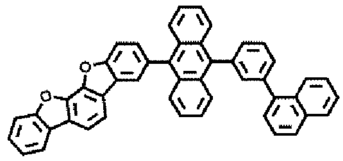
H63

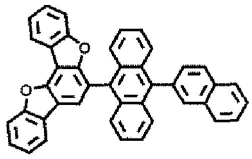
H64

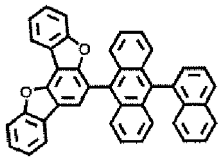
H65

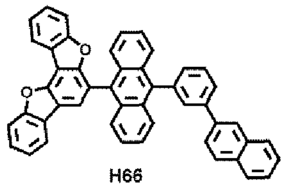
H66

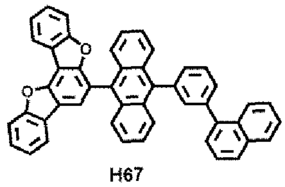
H67

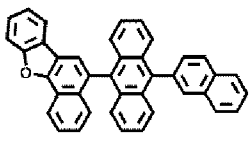
H68

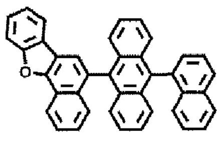
H69

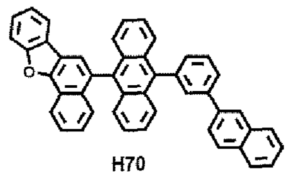
H70

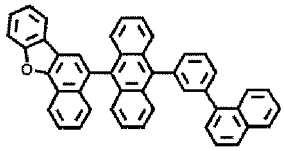
H71

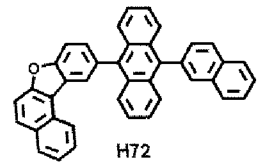
H72

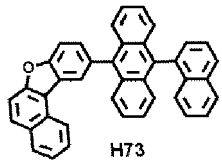
H73

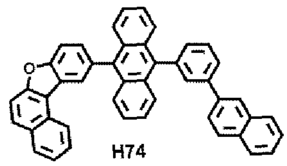
H74

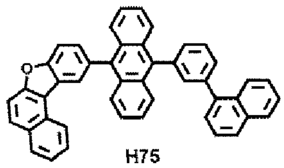
H75

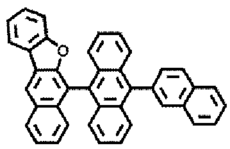
H76

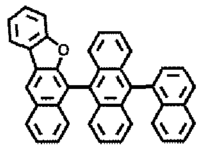
H77

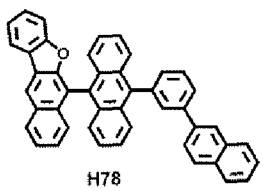
H78

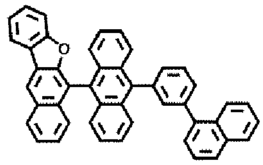
H79

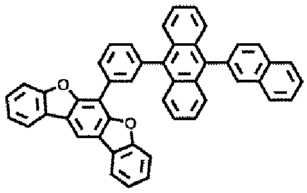
H80

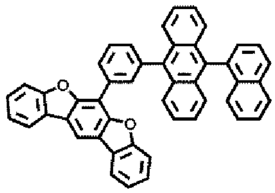
H81

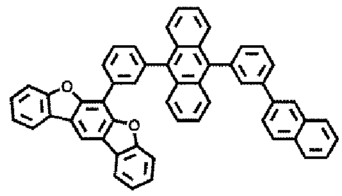
H82

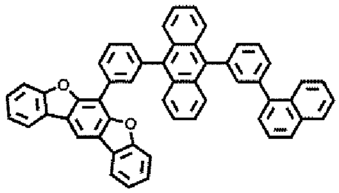
H83

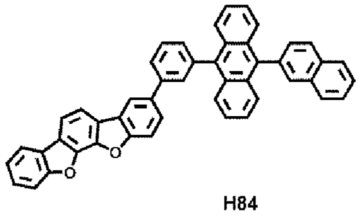
H84

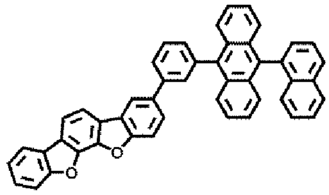
H85

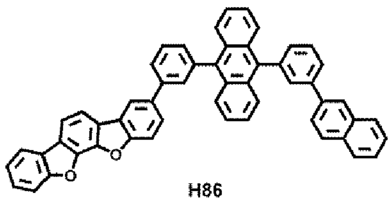
H86

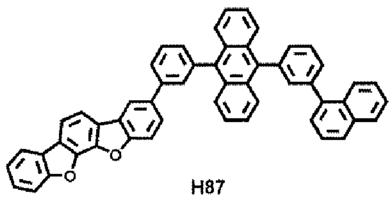
H87

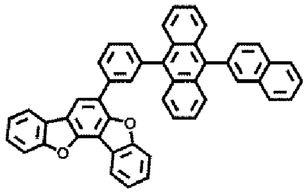
H88

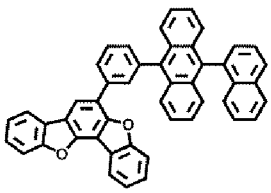
H89

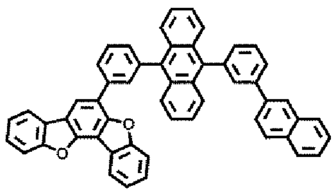
H90

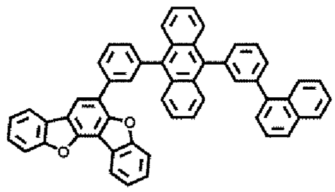
H91

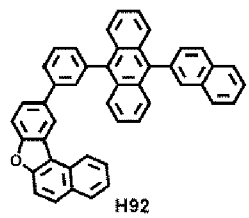
H92

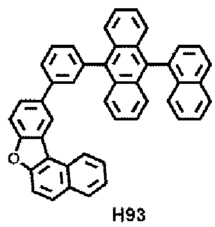
H93

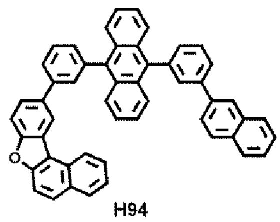
H94

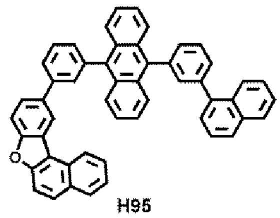
H95

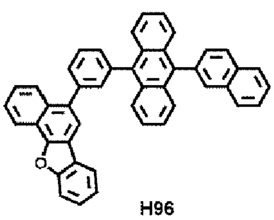
H96

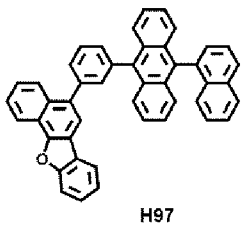
H97

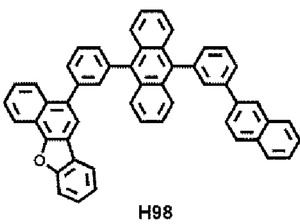
H98

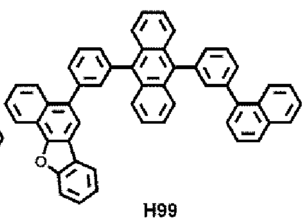
H99

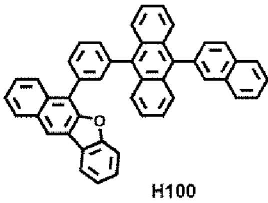
H100

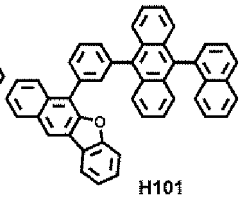
H101

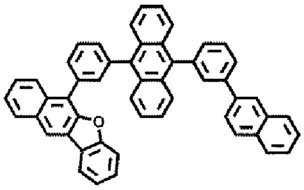
H102

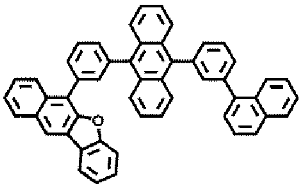
H103

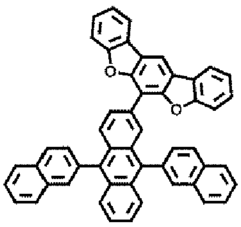
H104

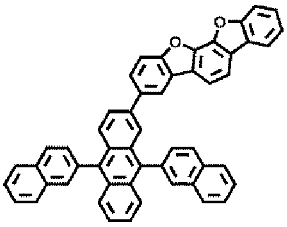
H105

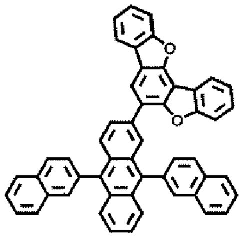
H106

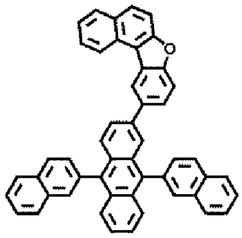
H107

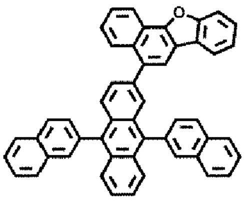
H108

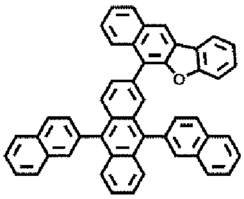
H109

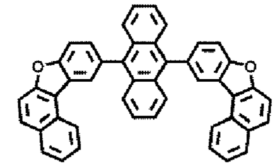
H110

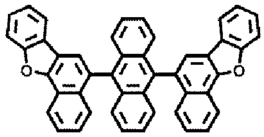
H111

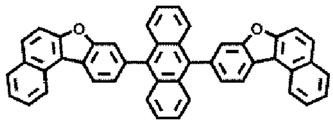
H112

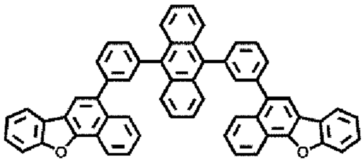
H113

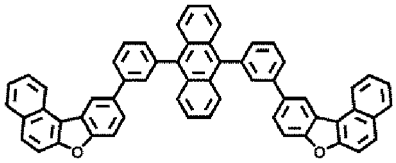
H114

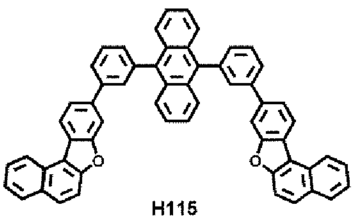
H115

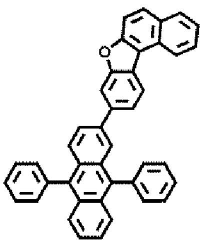
H116

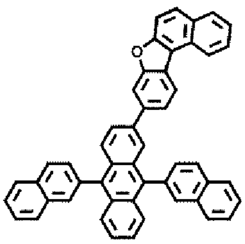
H117

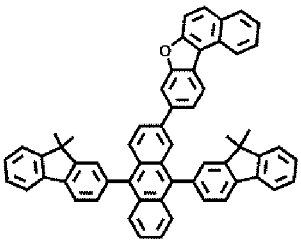
H118

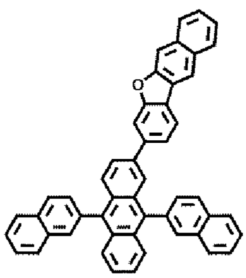
H119

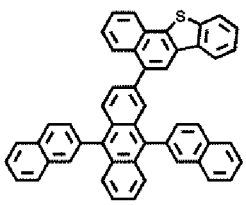
H120

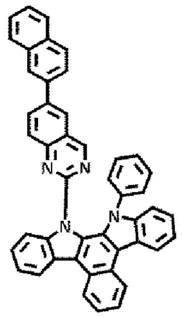

H121

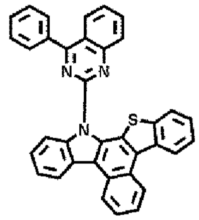

H122

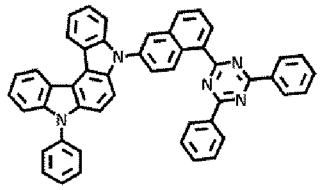

H123

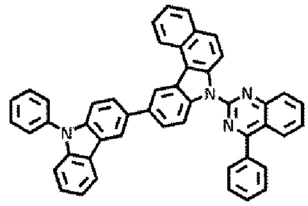

H124

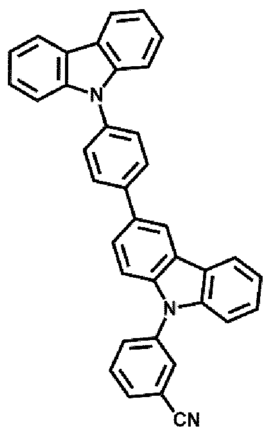

H125

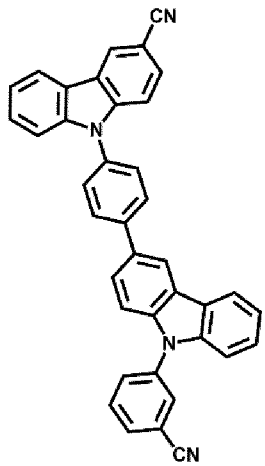

H126

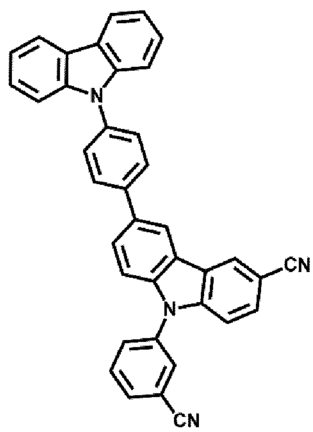

H127

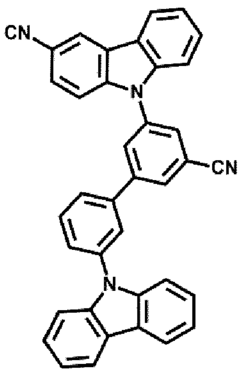

H128

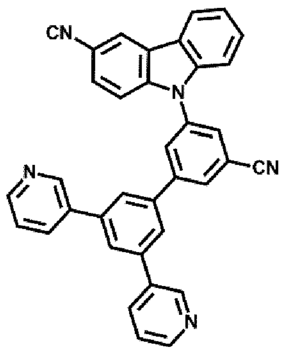

H129

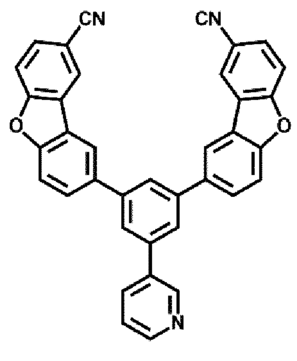

H130

[Dopant in emission layer]

The first dopant may be an organometallic compound including: iridium or platinum; and at least one organic ligand, and the organic ligand may be a bidentate organic ligand, a tridentate organic ligand, or a tetradentate organic ligand.

In an embodiment, the first dopant may be an organometallic compound including platinum and a tetradentate ligand.

In one or more embodiments, the first dopant may include an organometallic compound represented by Formula 40, an organometallic compound represented by Formula 50, or any combination thereof:

Formula 40

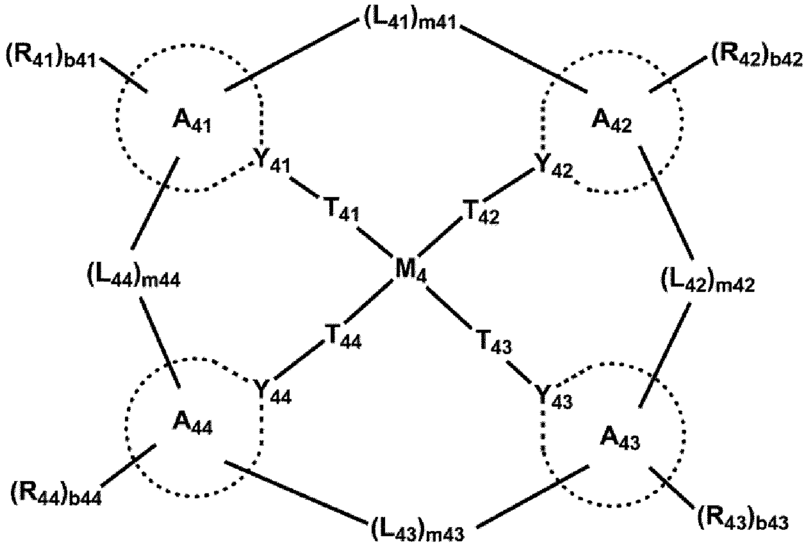

Formula 50

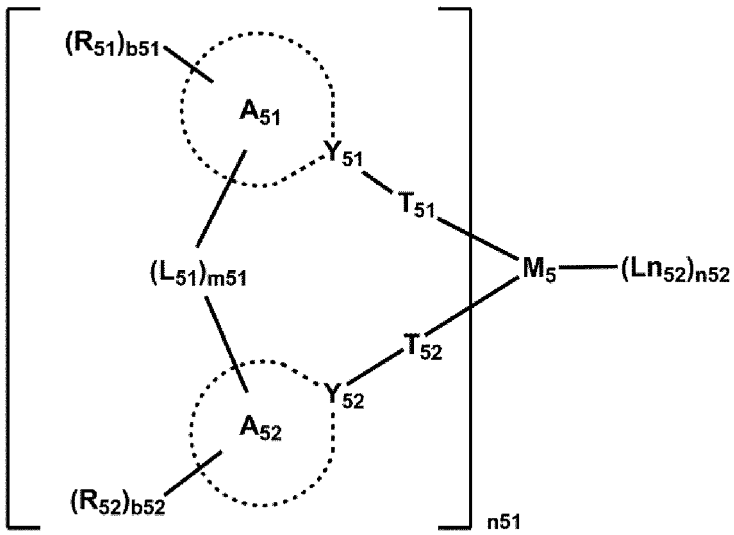

In Formulae 40 and 50,

$M_4$ and $M_5$ are each independently platinum (Pt), palladium (Pd), copper (Cu), silver (Ag), gold (Au), rhodium (Rh), iridium (Ir), ruthenium (Ru), osmium (Os), titanium (Ti), zirconium (Zr), hafnium (Hf), europium (Eu), terbium (Tb) or thulium (Tm),
n51 is 1, 2, or 3,
$Ln_{52}$ is an organic ligand,
n52 is 0, 1, or 2,
$Y_{41}$ to $Y_{44}$ and $Y_{51}$ and $Y_{52}$ are each independently N or C,
ring $A_{41}$ to ring $A_{44}$, ring $A_{51}$, and ring $A_{52}$ are each independently a $C_3$-$C_{60}$ (e.g. $C_3$-$C_{30}$) carbocyclic group or a $C_1$-$C_{60}$ (e.g. $C_1$-$C_{20}$) heterocyclic group,
$T_{41}$ to $T_{44}$, $T_{51}$, and $T_{52}$ are each independently a chemical bond (for example, a covalent bond or a coordination bond), *-O-*', or *-S-*',
$L_{41}$ to $L_{44}$ and $L_{51}$ are each independently a single bond, *-O-*', *-S-*', *-C($R_{45}$)($R_{46}$)-*', *-C($R_{45}$)=*', *=C($R_{45}$)-*', *-C($R_{45}$)=C($R_{45}$)-*', *-C(=O)-*', *-C(=S)-*', *-C≡C-*', *-B($R_{45}$)-*', *-N($R_{45}$)-*', *-P($R_{45}$)-*', *-Si($R_{45}$)($R_{46}$)-*', *-P($R_{45}$)($R_{46}$)-*', or *-Ge($R_{45}$)($R_{46}$)-*',
m41 to m44 are each independently 0, 1, or 2, wherein, when m41 is 0, $L_{41}$ does not exist, when m42 is 0, $L_{42}$ does

not exist, when m43 is 0, $L_{43}$ does not exist, when m44 is 0, $L_{44}$ does not exist, and two or more of m41 to m44 are not 0, m51 is 1 or 2,

$R_{41}$ to $R_{46}$, $R_{51}$, and $R_{52}$ are each independently hydrogen, deuterium, -F, -Cl, -Br, -I, a hydroxyl group, a cyano group, a nitro group, a $C_1$-$C_{60}$ (e.g. $C_1$-$C_{20}$) alkyl group unsubstituted or substituted with at least one $R_{10a}$, a $C_2$-$C_{60}$ (e.g. $C_2$-$C_{20}$) alkenyl group unsubstituted or substituted with at least one $R_{10a}$, a $C_2$-$C_{60}$ (e.g. $C_2$-$C_{20}$) alkynyl group unsubstituted or substituted with at least one $R_{10a}$, a $C_1$-$C_{60}$ (e.g. $C_1$-$C_{20}$) alkoxy group unsubstituted or substituted with at least one $R_{10a}$, a $C_3$-$C_{60}$ (*e.g.* $C_3$-$C_{30}$) carbocyclic group unsubstituted or substituted with at least one $R_{10a}$, a $C_1$-$C_{60}$ (*e.g.* $C_1$-$C_{20}$) heterocyclic group unsubstituted or substituted with at least one $R_{10a}$, a $C_6$-$C_{60}$ (*e.g.* $C_6$-$C_{30}$) aryloxy group unsubstituted or substituted with at least one $R_{10a}$, a $C_6$-$C_{60}$ (e.g. $C_6$-$C_{30}$) arylthio group unsubstituted or substituted with at least one $R_{10a}$, - $Si(Q_{41})(Q_{42})(Q_{43})$, $-N(Q_{41})(Q_{42})$, $-B(Q_{41})(Q_{42})$, $-C(=O)(Q_{41})$, $-S(=O)_2(Q_{41})$, or - $P(=O)(Q_{41})(Q_{42})$,

$R_{45}$ and $R_{41}$; $R_{45}$ and $R_{42}$; $R_{45}$ and $R_{43}$; or $R_{45}$ and $R_{44}$ are optionally linked to each other to form a $C_3$-$C_{60}$ (*e.g.* $C_3$-$C_{30}$) carbocyclic group unsubstituted or substituted with at least one $R_{10a}$ or a $C_1$-$C_{60}$ (*e.g.* $C_1$-$C_{20}$) heterocyclic group unsubstituted or substituted with at least one $R_{10a}$,

b41 to b44, b51, and b52 are each independently an integer from 1 to 8,

* and *' each indicate a binding site to a neighboring atom,

$R_{10a}$ is the same as described in the present specification, and

$Q_{41}$ to $Q_{43}$ are the same as described in connection with $Q_{11}$.

In Formulae 40 and 50, $M_4$ and $M_5$ may each independently be Pt, Pd, Cu, Ag, Au, Ir, or Os.

For example, in Formulae 40 and 50, $M_4$ and $M_5$ may each independently be Pt or Ir.

In an embodiment, $M_4$ may be Pt, and $M_5$ may be Ir.

In an embodiment, in Formula 40,

$Y_{41}$, $Y_{42}$, and $Y_{43}$ may each be C, and $Y_{41}$ may be N;
$Y_{41}$, $Y_{42}$, and $Y_{44}$ may each be C, and $Y_{43}$ may be N;
$Y_{41}$, $Y_{43}$, and $Y_{44}$ may each be C, and $Y_{42}$ may be N;
$Y_{42}$, $Y_{43}$, and $Y_{44}$ may each be C, and $Y_{41}$ may be N;
$Y_{41}$ and $Y_{44}$ may each be C, and $Y_{42}$ and $Y_{43}$ may each be N;
$Y_{41}$ and $Y_{44}$ may each be N, and $Y_{42}$ and $Y_{43}$ may each be C;
$Y_{41}$ and $Y_{42}$ may each be C, and $Y_{43}$ and $Y_{44}$ may each be N;
$Y_{41}$ and $Y_{42}$ may each be N, and $Y_{43}$ and $Y_{44}$ may each be C;
$Y_{41}$ and $Y_{43}$ may each be C, and $Y_{42}$ and $Y_{44}$ may each be N; or
$Y_{41}$ and $Y_{43}$ may each be N, and $Y_{42}$ and $Y_{44}$ may each be C.
In one or more embodiments, in Formula 50,
$Y_{51}$ and $Y_{52}$ may each be C,
$Y_{51}$ may be N, and $Y_{52}$ may be C,
$Y_{51}$ may be C, and $Y_{52}$ may be N, or
$Y_{51}$ and $Y_{52}$ may each be N.

In Formulae 40 and 50, ring $A_{41}$ to ring $A_{44}$, ring $A_{51}$, and ring $A_{52}$ may each independently be a benzene group, a naphthalene group, an anthracene group, a phenanthrene group, a triphenylene group, a pyrene group, a chrysene group, a cyclopentadiene group, a 1,2,3,4-tetrahydronaphthalene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an indenopyridine group, an indolopyridine group, a benzofuropyridine group, a benzothienopyridine group, a benzosilolopyridine group, an indenopyrimidine group, an indolopyrimidine group, a benzofuropyrimidine group, a benzothienopyrimidine group, a benzosilolopyrimidine group, a dihydropyridine group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, a thiadiazole group, a benzopyrazole group, a benzimidazole group, a 2,3-dihydrobenzimidazole group, an imidazopyridine group, a 2,3-dihydroimidazopyridine group, an imidazopyrimidine group, a 2,3-dihydroimidazopyrimidine group, an imidazopyrazine group, a 2,3-dihydroimidazopyrazine group, a benzoxazole group, a benzothiazole group, a benzoxadiazole group, a benzothiadiazole group, a 5,6,7,8-tetrahydroisoquinoline group, or a 5,6,7,8-tetrahydroquinoline group.

In an embodiment, in Formula 40,

each of $T_{41}$ to $T_{44}$ may be a chemical bond;
$T_{41}$ may be *-O-*' or *-S-*', and $T_{42}$ to $T_{44}$ may be chemical bonds;
$T_{42}$ may be *-O-*' or *-S-*', and $T_{41}$, $T_{43}$, and $T_{44}$ may be chemical bonds;
$T_{43}$ may be *-O-*' or *-S-*', and $T_{41}$, $T_{42}$, and $T_{44}$ may be chemical bonds; or
$T_{44}$ may be *-O-*' or *-S-*', and $T_{41}$, $T_{42}$, and $T_{43}$ may be chemical bonds.

In one or more embodiments, in Formula 40, each of $T_{41}$ to $T_{44}$ may be a chemical bond.

In one or more embodiments, in Formula 50, each of $T_{51}$ and $T_{52}$ may be a chemical bond.

In one or more embodiments, a bond between $Y_{41}$ and $T_{41}$ or a bond between $Y_{41}$ and $M_4$ may be a covalent bond or a coordinate bond.

In one or more embodiments, a bond between $Y_{42}$ and $T_{42}$ or a bond between $Y_{42}$ and $M_4$ may be a covalent bond or a coordinate bond.

In one or more embodiments, a bond between $Y_{43}$ and $T_{43}$ or a bond between $Y_{43}$ and $M_4$ may be a covalent bond or a coordinate bond.

In one or more embodiments, a bond between $Y_{44}$ and $T_{44}$ or a bond between $Y_{44}$ and $M_4$ may be a covalent bond or a coordinate bond.

In one or more embodiments, a bond between $Y_{51}$ and $T_{51}$ or a bond between $Y_{51}$ and $M_5$ may be a covalent bond or a coordinate bond.

In one or more embodiments, a bond between $Y_{52}$ and $T_{52}$ or a bond between $Y_{52}$ and $M_5$ may be a covalent bond or a coordinate bond.

In one or more embodiments, $L_{41}$ to $L_{44}$ and $L_{51}$ may each independently be a single bond, *-O-*', *-S-*', *-C($R_{45}$)($R_{46}$)-*', *-C($R_{45}$)=*', *=C($R_{45}$)-*', *-C($R_{45}$)=C($R_{45}$)-*', *-C(=O)-*', or *-N($R_{45}$)-*'.

In one or more embodiments, m41 may be 0, m42 to m44 may be 1, and m51 may be 1.

In one or more embodiments, in Formulae 40 and 50, $R_{41}$ to $R_{46}$, $R_{51}$, and $R_{52}$ may each independently be:

hydrogen, deuterium, -F, -Cl, -Br, -I, a cyano group, a $C_1$-$C_{20}$ (*e.g.* $C_1$-$C_{10}$) alkyl group, or a $C_1$-$C_{20}$ (*e.g.* $C_1$-$C_{10}$) alkoxy group;

a $C_1$-$C_{20}$ (*e.g.* $C_1$-$C_{10}$) alkyl group or a $C_1$-$C_{20}$ (*e.g.* $C_1$-$C_{10}$) alkoxy group, each substituted with deuterium, -F, -Cl, -Br, -I, a cyano group, a phenyl group, a biphenyl group, or any combination thereof;

a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentacenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a benzoisoquinolinyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, a benzothiazolyl group, a benzoisothiazolyl group, a benzoxazolyl group, a benzoisoxazolyl group, a triazolyl group, a tetrazolyl group, a thiadiazolyl group, an oxadiazolyl group, a triazinyl group, a carbazolyl group, a dibenzofuranyl group, a dibenzothiophenyl group, a dibenzosilolyl group, a benzocarbazolyl group, a naphthobenzofuranyl group, a naphthobenzothiophenyl group, a naphthobenzosilolyl group, a dibenzocarbazolyl group, a dinaphthofuranyl group, a dinaphthothiophenyl group, a dinaphthosilolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, an indenopyrrolyl group, an indolopyrrolyl group, an indeno carbazolyl group, or an indolocarbazolyl group, each unsubstituted or substituted with deuterium, -F, - Cl, -Br, -I, a cyano group, a $C_1$-$C_{20}$ (*e.g.* $C_1$-$C_{10}$) alkyl group, a $C_1$-$C_{20}$ (*e.g.* $C_1$-$C_{10}$) alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentacenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl

group, a purinyl group, a quinolinyl group, an isoquinolinyl group, a benzoquinolinyl group, a benzoisoquinolinyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, a benzothiazolyl group, a benzoisothiazolyl group, a benzoxazolyl group, a benzoisoxazolyl group, a triazolyl group, a tetrazolyl group, a thiadiazolyl group, an oxadiazolyl group, a triazinyl group, a carbazolyl group, a dibenzofuranyl group, a dibenzothiophenyl group, a dibenzosilolyl group, a benzocarbazolyl group, a naphthobenzofuranyl group, a naphthobenzothiophenyl group, a naphthobenzosilolyl group, a dibenzocarbazolyl group, a dinaphthofuranyl group, a dinaphthothiophenyl group, a dinaphthosilolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, an indenopyrrolyl group, an indolopyrrolyl group, an indeno carbazolyl group, an indolocarbazolyl group, $-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, $-P(=O)(Q_{31})(Q_{32})$, or any combination thereof; or

$-Si(Q_{41})(Q_{42})(Q_{43})$, $-N(Q_{41})(Q_{42})$, $-B(Q_{41})(Q_{42})$, $-C(=O)(Q_{41})$, $-S(=O)_2(Q_{41})$, or $-P(=O)(Q_{41})(Q_{42})$.

In one or more embodiments, in Formulae 40 and 50, $R_{41}$ to $R_{40}$, $R_{51}$, and $R_{52}$ may each independently be:

hydrogen, deuterium, -F, -Cl, -Br, -I, a cyano group, a $C_1$-$C_{20}$ (*e.g.* $C_1$-$C_{10}$) alkyl group, or a $C_1$-$C_{20}$ (e.g. $C_1$-$C_{10}$) alkoxy group;

a $C_1$-$C_{20}$ (*e.g.* $C_1$-$C_{10}$) alkyl group or a $C_1$-$C_{20}$ (*e.g.* $C_1$-$C_{10}$) alkoxy group, each substituted with deuterium, -F, -Cl, -Br, -I, a cyano group, a phenyl group, a biphenyl group, or any combination thereof; or

a phenyl group, a biphenyl group, a terphenyl group, a naphthyl group, a fluorenyl group, a spiro-bifluorenyl group, a carbazolyl group, a dibenzofuranyl group, a dibenzothiophenyl group, or a dibenzosilole group, each unsubstituted or substituted with deuterium, -F, -Cl, -Br, -I, a cyano group, a $C_1$-$C_{20}$ (*e.g.* $C_1$-$C_{10}$) alkyl group, a $C_1$-$C_{20}$ (*e.g.* $C_1$-$C_{10}$) alkoxy group, a phenyl group, a biphenyl group, or any combination thereof.

In an embodiment, the first dopant may be an organometallic compound represented by Formula 40, wherein, in Formula 40, $Y_{41}$ may be C, $T_{41}$ may be a coordinate bond, m41 may be 0, and m42 to m44 may be 1.

In an embodiment, the first dopant may be an organometallic compound represented by Formula 40, wherein, in Formula 40, $Y_{41}$ may be C, $T_{41}$ may be a coordinate bond, m41 may be 0, m42 to m44 may be 1, $L_{42}$ and $L_{44}$ may be a single bond, and $L_{43}$ may be *-O-*', *-S-*', *-C($R_{45}$)($R_{46}$)-*', or *-N($R_{45}$)-*'.

In an embodiment, the first dopant may be an organometallic compound represented by Formula 50, wherein, in Formula 50, $Y_{51}$ may be C, and $T_{51}$ may be a coordinate bond.

In an embodiment, the first dopant may be an organometallic compound represented by Formula 41:

Formula 41

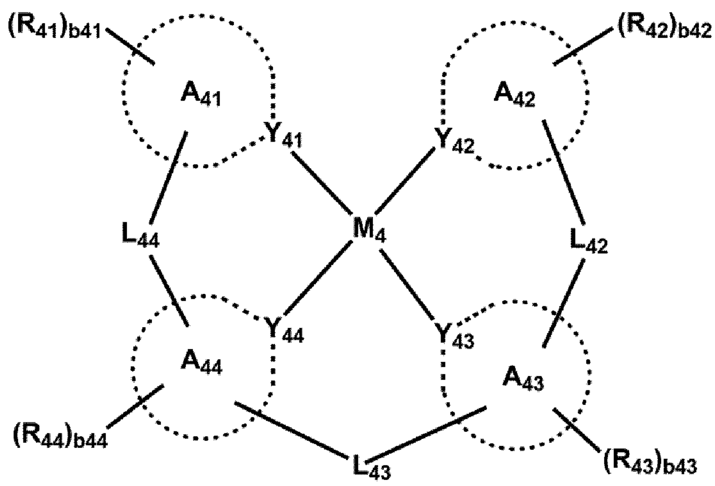

In Formula 41, $M_4$, $Y_{41}$ to $Y_{44}$, ring $A_{41}$ to ring $A_{44}$, $L_{42}$ to $L_{44}$, $R_{41}$ to $R_{44}$, and b41 to b44 are the same as described in the present specification.

In an embodiment, in Formula 41, a group represented by

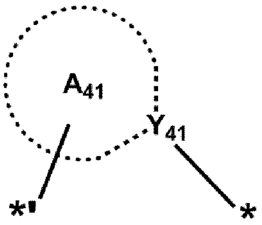

may be a group represented by one of Formulae A41-1 to A41-6:

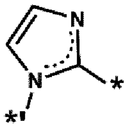
A41-1

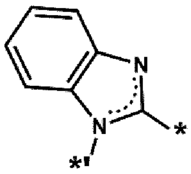
A41-2

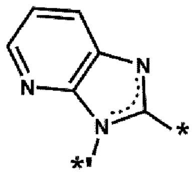
A41-3

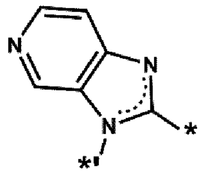
A41-4

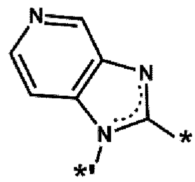
A41-5

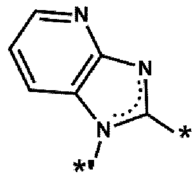
A41-6

In Formulae A41-1 to A41-6,

* is a binding site to $M_4$ in Formula 41, and
*' is a binding site to $L_{44}$ in Formula 41.

In an embodiment, in Formula 41, a group represented by

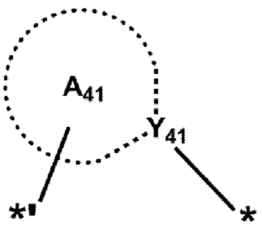

may be a group represented by Formula A41-2.

In one or more embodiments, in Formula 41, a group represented by

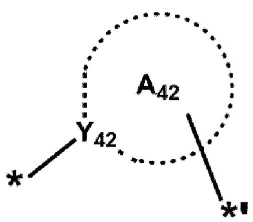

may be a group represented by one of Formulae A42-1 to A42-11 :

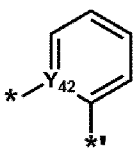
A42-1

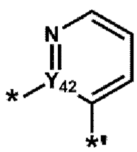
A42-2

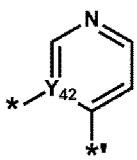
A42-3

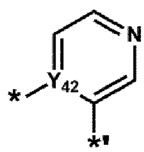
A42-4

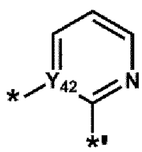
A42-5

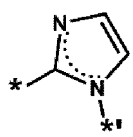
A42-6

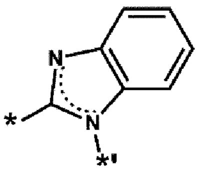
A42-7

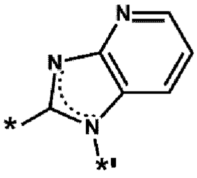
A42-8

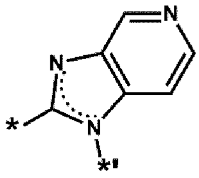
A42-9

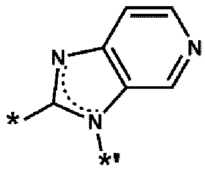
A42-10

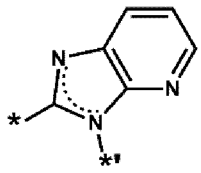
A42-11

In Formulae A42-1 to A42-11,

$Y_{42}$ is the same as described in the present specification,
* is a binding site to $M_4$ in Formula 41, and
*' is a binding site to $L_{42}$ in Formula 41.

In one or more embodiments, in Formula 41, a group represented by

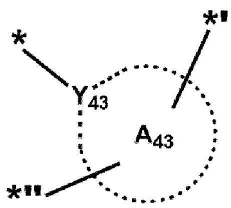

may be a group represented by one of Formulae A43-1 to A43-5:

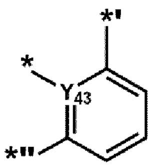
A43-1

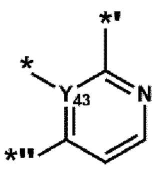
A43-2

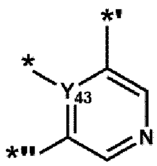
A43-3

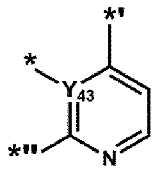
A43-4

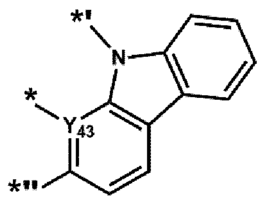
A43-5

In Formulae A43-1 to A43-5,

$Y_{43}$ is the same as described in the present specification,
* is a binding site to $M_4$ in Formula 41,
*' is a binding site to $L_{42}$ in Formula 41, and
*'' is a binding site to $L_{43}$ in Formula 41.

In one or more embodiments, in Formula 41, a group represented by

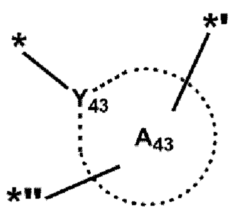

may be a group represented by Formula A43-5.

In one or more embodiments, in Formula 41, a group represented by

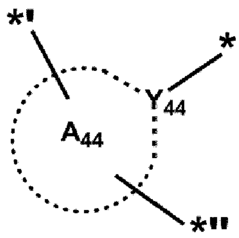

may be a group represented by one of Formulae A44-1 to A44-4:

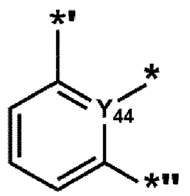

A44-1

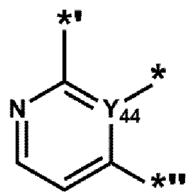

A44-2

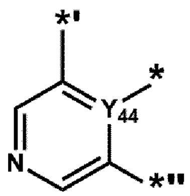

A44-3

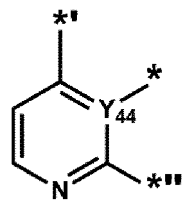

A44-4

In Formulae A44-1 to A44-4,

$Y_{44}$ is the same as described in the present specification,
* is a binding site to $M_4$ in Formula 41,
*' is a binding site to $L_{44}$ in Formula 41, and
*" is a binding site to $L_{43}$ in Formula 41.

The first dopant may include, for example, one of Compounds PD1 to PD25, one of Compounds 40-1 to 40-14, one of Compounds 50-1 to 50-84, one of Comopunds D1-1 to D1-3, or any combination thereof:

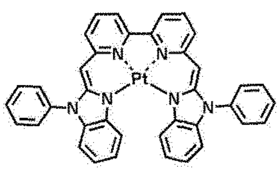

PD1

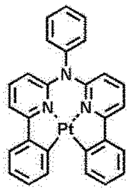

PD2

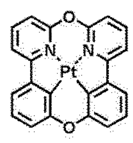

PD3

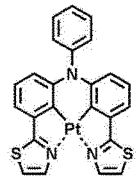

PD4

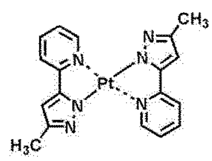

PD5

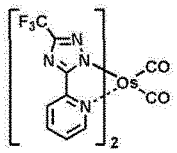

PD6

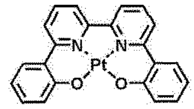

PD7

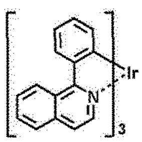

PD8

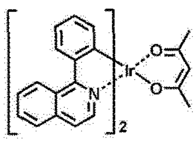

PD9

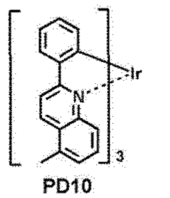

PD10

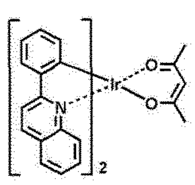

PD11

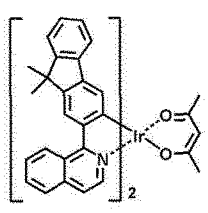

PD12

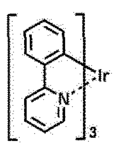

PD13

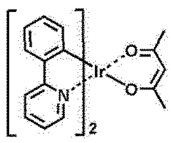

PD14

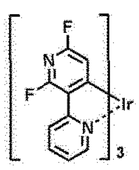

PD15

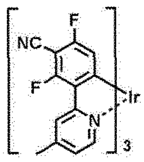
PD16

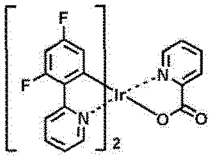
PD17

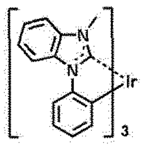
PD18

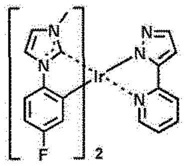
PD19

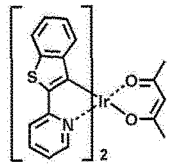
PD20

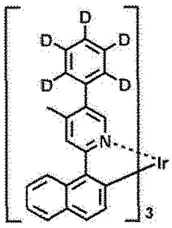
PD21

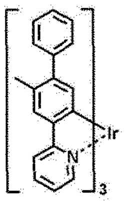
PD22

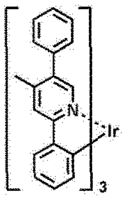
PD23

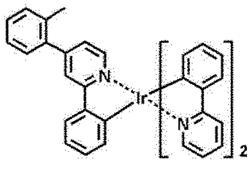
PD24

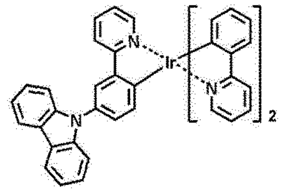
PD25

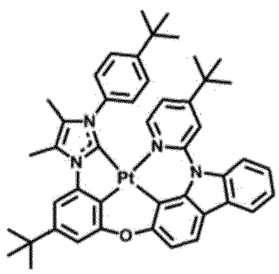
40-1

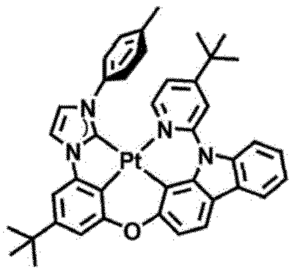
40-2

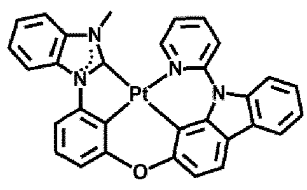
40-3

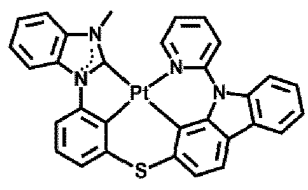
40-4

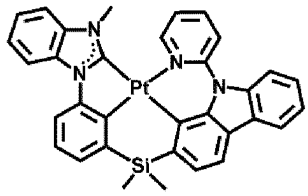
40-5

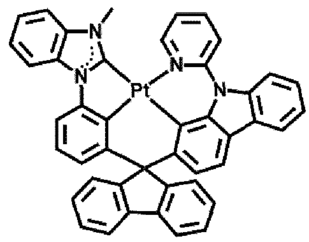
40-6

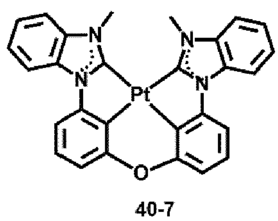
40-7

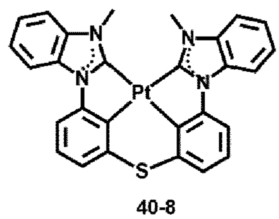
40-8

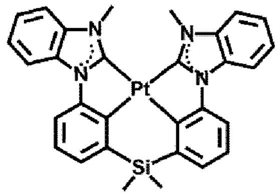
40-9

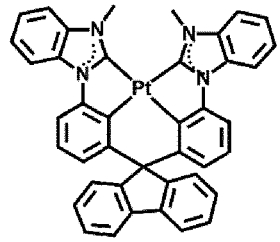
40-10

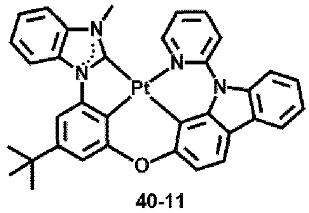
40-11

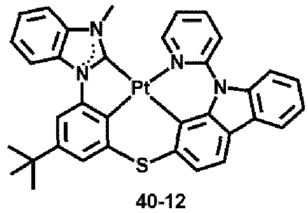
40-12

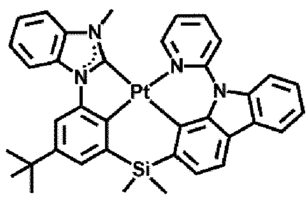
40-13

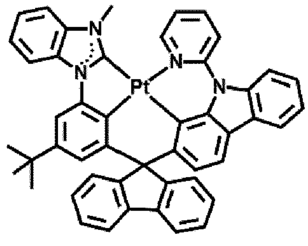
40-14

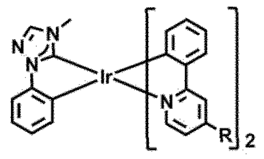

50-1 (R = H)
50-2 (R = Me)
50-3 (R = *iso*-Pr)
50-4 (R = *tert*-Bu)
50-5 (R = $NMe_2$)

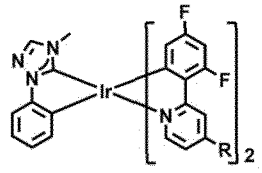

50-6 (R = H)
50-7 (R = Me)
50-8 (R = *iso*-Pr)
50-9 (R = *tert*-Bu)
50-10 (R = $NMe_2$)

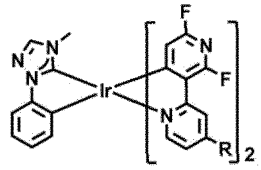

50-11 (R = H)
50-12 (R = Me)
50-13 (R = *iso*-Pr)
50-14 (R = *tert*-Bu)
50-15 (R = $NMe_2$)

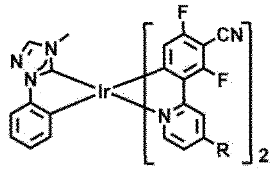

50-16 (R = H)
50-17 (R = Me)
50-18 (R = *iso*-Pr)
50-19 (R = *tert*-Bu)
50-20 (R = $NMe_2$)

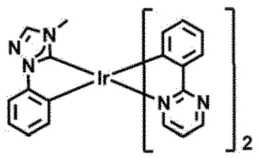

50-21

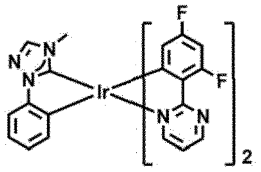

50-22

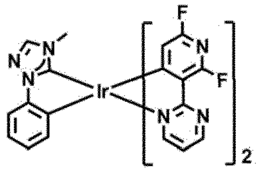

50-23

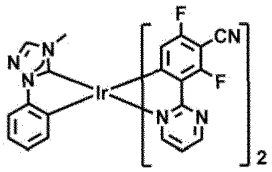

50-24

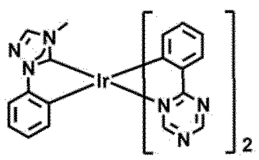

50-25

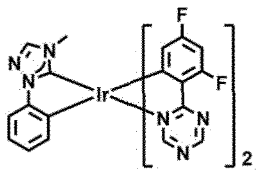

50-26

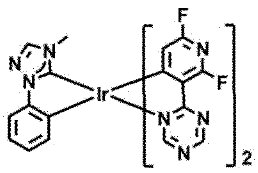

50-27

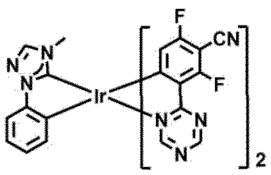

50-28

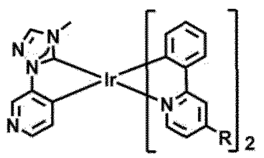

50-29 (R = H)
50-30 (R = Me)
50-31 (R = *iso*-Pr)
50-32 (R = *tert*-Bu)
50-33 (R = $NMe_2$)

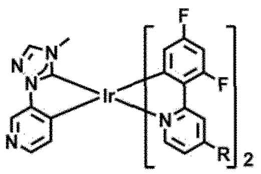

50-34 (R = H)
50-35 (R = Me)
50-36 (R = *iso*-Pr)
50-37 (R = *tert*-Bu)
50-38 (R = $NMe_2$)

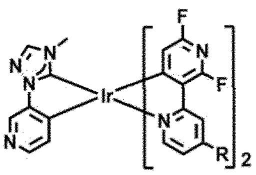

50-39 (R = H)
50-40 (R = Me)
50-41 (R = *iso*-Pr)
50-42 (R = *tert*-Bu)
50-43 (R = $NMe_2$)

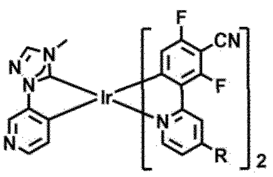

50-44 (R = H)
50-45 (R = Me)
50-46 (R = *iso*-Pr)
50-47 (R = *tert*-Bu)
50-48 (R = $NMe_2$)

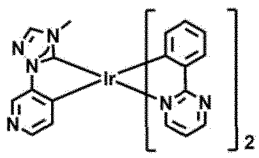

50-49

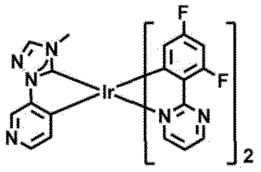

50-50

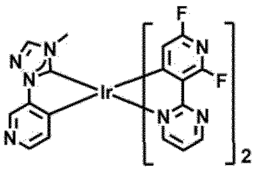

50-51

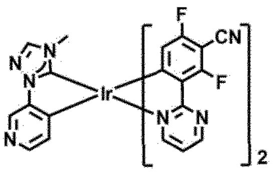

50-52

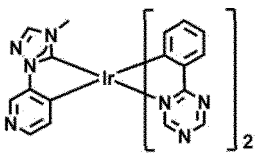

50-53

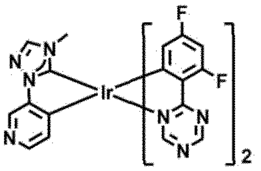

50-54

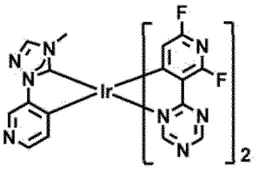

50-55

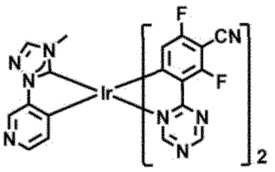

50-56

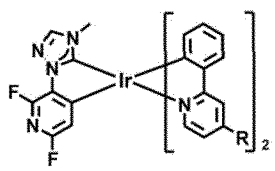

50-57 (R = H)
50-58 (R = Me)
50-59 (R = *iso*-Pr)
50-60 (R = *tert*-Bu)
50-61 (R = $NMe_2$)

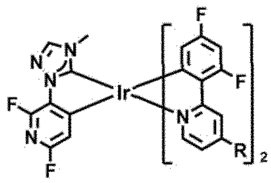

50-62 (R = H)
50-63 (R = Me)
50-64 (R = *iso*-Pr)
50-65 (R = *tert*-Bu)
50-66 (R = $NMe_2$)

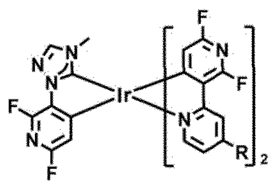

50-67 (R = H)
50-68 (R = Me)
50-69 (R = *iso*-Pr)
50-70 (R = *tert*-Bu)
50-71 (R = $NMe_2$)

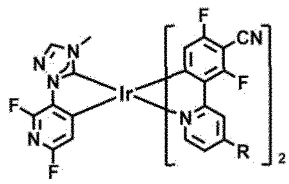

50-72 (R = H)
50-73 (R = Me)
50-74 (R = *iso*-Pr)
50-75 (R = *tert*-Bu)
50-76 (R = $NMe_2$)

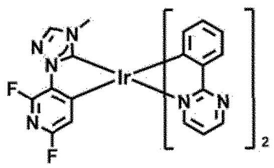

50-77

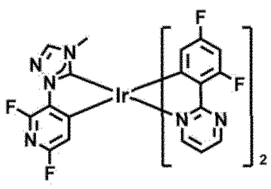

50-78

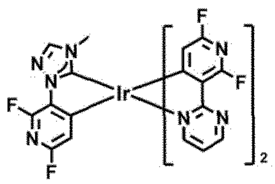

50-79

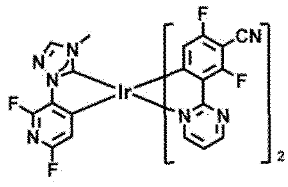

50-80

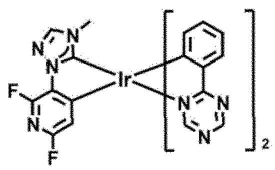

50-81

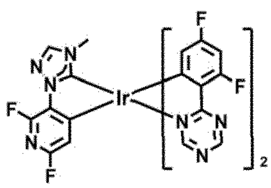

50-82

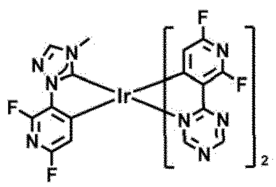

50-83

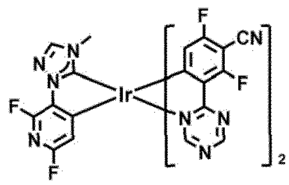

50-84

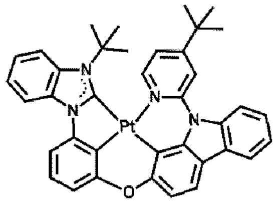

D1-1

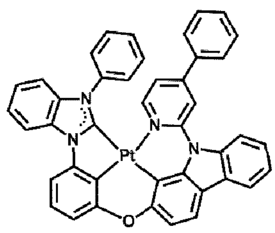

D1-2

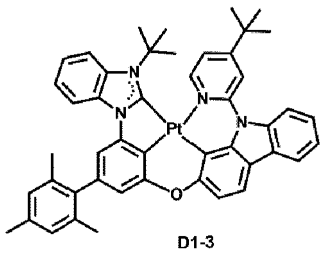

D1-3

In Compounds PD1 to PD25, Compounds 40-1 to 40-14, Compounds 50-1 to 50-84, and Compounds D1-1 to D1-3, Me represents a methyl group, iso-Pr represents an isopropyl group, and tert-Bu represents a t-butyl group.

In an embodiment, the second dopant may not include a transition metal (e.g., may not be a transition metal complex).

In an embodiment, the second dopant may be a fluorescent dopant that may emit fluorescence. The fluorescence may be prompt fluorescence or delayed fluorescence. Therefore, the second dopant may include a prompt fluorescence dopant, a delayed fluorescence dopant, or any combination thereof.

In one or more embodiments, the second dopant may be a delayed fluorescence dopant satisfying Equation 3-2:

Equation 3-2

$$S1(D2) - T1(D2) \leq 0.3 \text{ eV}$$

In Equation 3-2,

S1(D2) is a lowest excitation singlet energy level of the second dopant, and

T1(D2) is a lowest excitation triplet energy level of the second dopant.

When the second dopant satisfies Equation 3-2, $\triangle E_{st}$ which is a difference between a lowest excitation triplet energy and a lowest excitation singlet energy is significantly low, and thus, even at room temperature, reverse intersystem crossing from a triplet excited state to a singlet excited state through thermal activity is possible.

Accordingly, excitons in a triplet state of the second dopant may transition to a singlet excited state and may be used for fluorescence emission, and fluorescence emission efficiency and the lifespan of the light-emitting device may be improved.

In an embodiment, the second dopant may include i) a material that includes at least one electron donor (for example, a $\pi$ electron-rich $C_3$-$C_{60}$ (*e.g.* $C_3$-$C_{30}$) cyclic group, such as a carbazole group) and at least one electron acceptor (for example, a sulfoxide group, a cyano group, or a $\pi$ electron-deficient nitrogen-containing $C_1$-$C_{60}$ (*e.g.* $C_1$-$C_{20}$) cyclic group), ii) a material including a $C_8$-$C_{60}$ (*e.g.* $C_8$-$C_{30}$) polycyclic group in which two or more cyclic groups share boron (B) and are condensed with each other.

In an embodiment, the second dopant may include a heterocyclic compound represented by Formula 11:

Formula 11 $(Ar_1)_{n1}$-$(L_1)_{m1}$-$(Ar_2)_{n2}$

In Formula 11,

$L_1$ is a $C_3$-$C_{60}$ (*e.g.* $C_3$-$C_{30}$) carbocyclic group or a $C_1$-$C_{60}$ (*e.g.* $C_1$-$C_{20}$) heterocyclic group, each unsubstituted or substituted with at least one $R_{10a}$,
n1 and n2 are each independently 0, 1, 2, or 3,
the sum of n1 and n2 is greater than or equal to 1,
m1 is an integer from 0 to 5, and
Ar1 and $Ar_2$ are each independently a group represented by Formula 11A-1, a group represented by Formula 11A-2, or a group represented by Formula 11B,

Formula 11A-1

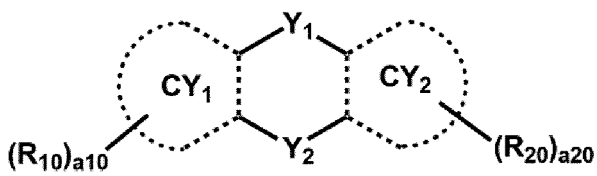

Formula 11A-2

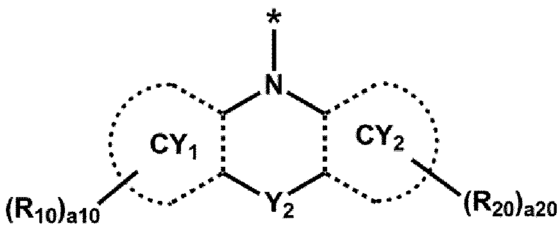

Formula 11B

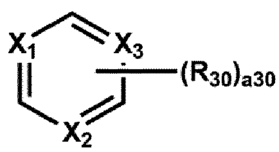

In Formulae 11A-1, 11A-2, and 11B,

$Y_1$ and $Y_2$ are each independently a single bond, *-O-*', *-S-*', *-C($Z_1$)($Z_2$)-*', *-N($Z_1$)-*', *-Si($Z_1$)($Z_2$)-*', *-C(=O)-*', *-S(=O)$_2$-*', *-B($Z_1$)-*', *-P($Z_1$)-*', or -P(=O)($Z_1$)($Z_2$)-*', and at least one of $Y_1$ and $Y_2$ in Formula 11A-1 is not a single bond,

ring $CY_1$ and ring $CY_2$ are each independently a $C_3$-$C_{60}$ (*e.g.* $C_3$-$C_{30}$) carbocyclic group or a $C_1$-$C_{60}$ (*e.g.* $C_1$-$C_{20}$) heterocyclic group,

$X_1$ to $X_3$ are each independently C or N, wherein, when each of $X_1$ to $X_3$ is C, at least one of $R_{30}$(s) is a cyano group,

$Z_1$, $Z_2$, $R_{10}$, $R_{20}$, and $R_{30}$ are each independently hydrogen, deuterium, -F, -Cl, -Br, -I, a hydroxyl group, a cyano group, a nitro group, a $C_1$-$C_{60}$ (*e.g.* $C_1$-$C_{20}$) alkyl group unsubstituted or substituted with at least one $R_{10a}$, a $C_2$-$C_{60}$ (*e.g.* $C_2$-$C_{20}$) alkenyl group unsubstituted or substituted with at least one $R_{10a}$, a $C_2$-$C_{60}$ (*e.g.* $C_2$-$C_{20}$) alkynyl group unsubstituted or substituted with at least one $R_{10a}$, a $C_1$-$C_{60}$ (*e.g.* $C_1$-$C_{20}$) alkoxy group unsubstituted or substituted with at least one $R_{10a}$, a $C_3$-$C_{60}$ (*e.g.* $C_3$-$C_{30}$) carbocyclic group unsubstituted or substituted with at least one $R_{10a}$, a $C_1$-$C_{60}$ (*e.g.* $C_1$-$C_{20}$) heterocyclic group unsubstituted or substituted with at least one $R_{10a}$, a $C_6$-$C_{60}$ (*e.g.* $C_6$-$C_{30}$) aryloxy group unsubstituted or substituted with at least one $R_{10a}$, a $C_6$-$C_{60}$ (*e.g.* $C_6$-$C_{30}$) arylthio group unsubstituted or substituted with at least one $R_{10a}$, - Si($Q_1$)($Q_2$)($Q_3$), -N($Q_1$)($Q_2$), -B($Q_1$)($Q_2$), -C(=O)($Q_1$), -S(=O)$_2$($Q_1$), or -P(=O)($Q_1$)($Q_2$),

a10 and a20 are each independently an integer from 1 to 10,

a30 is an integer from 1 to 6,

two or more of $Z_1$, $Z_2$, $R_{10}$, $R_{20}$, and $R_{30}$ are optionally linked to each other to form a $C_3$-$C_{60}$ (*e.g.* $C_3$-$C_{30}$) carbocyclic group unsubstituted or substituted with at least one $R_{10a}$ or a $C_1$-$C_{60}$ (*e.g.* $C_1$-$C_{20}$) heterocyclic group unsubstituted or substituted with at least one $R_{10a}$,

two or more $R_{30}$ are optionally linked to each other to form a $C_3$-$C_{60}$ (*e.g.* $C_3$-$C_{30}$) carbocyclic group unsubstituted or substituted with at least one $R_{10a}$ or a $C_1$-$C_{60}$ (*e.g.* $C_1$-$C_{20}$) heterocyclic group unsubstituted or substituted with at least one $R_{10a}$,

at least one of $R_{10}$ and $R_{20}$ in Formula 11A-1 is a binding site to $L_1$ or Ar1 in Formula 11,

* in Formula 11A-2 is a binding site to $L_1$ or Ar1 in Formula 11,

at least one of $R_{30}$(s) in Formula 11B is a binding site to $L_1$ or Ar1, and

$R_{10a}$ and $Q_1$ to $Q_3$ are the same as described in the present specification.

The heterocyclic compound may efficiently block intermolecular orbital overlap by separating an electron donor moiety and an electron acceptor moiety, such that a singlet and triplet of a molecule do not overlap, and thus the heterocyclic compound may have a significantly low $\triangle E_{st}$. Accordingly, even at room temperature, reverse intersystem crossing from a triplet excited state to a singlet excited state through thermal activity is possible, such that the heterocyclic compound is a compound that may exhibit thermally activated delayed fluorescence emission (TADF), and thus excitons in a triplet state are used for light emission, resulting in improvement of emission efficiency of the light-emitting device.

In one or more embodiments, the second dopant may include a condensed cyclic ring in which at least one first ring and at least one second ring are condensed with each other, wherein the first ring may be a 6-membered ring including, as a ring-forming atom, boron (B) (for example, a 6-membered ring including, as a ring-forming atom, boron (B) and nitrogen (N)), and the second ring may be a pyrrole group, a furan group, a thiophene group, a benzene group, a pyridine group, or a pyrimidine group.

In one or more embodiments, the second dopant may include a heterocyclic compound represented by one of Formulae 11(4) to 11(7):

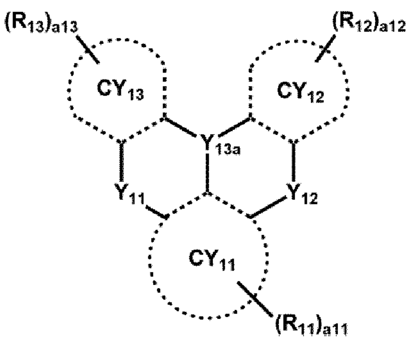

11(4)

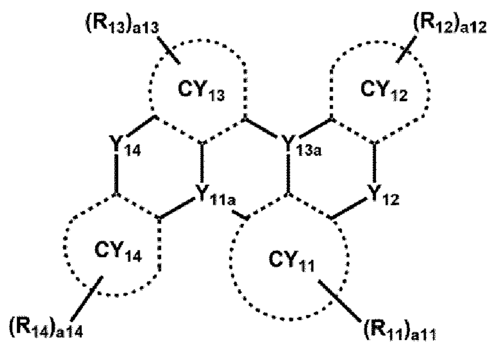

11(5)

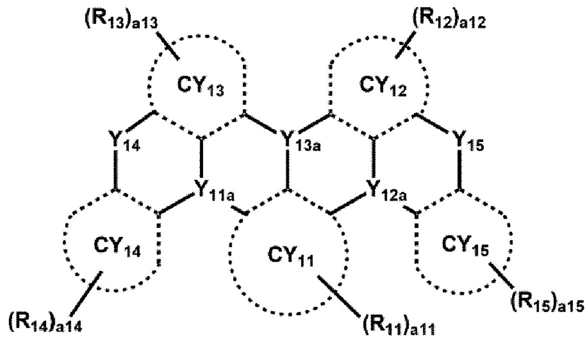

11(6)

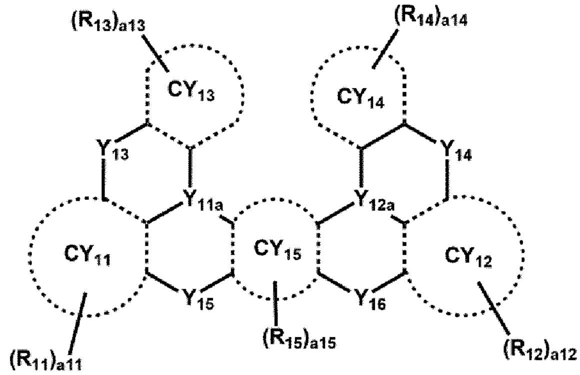

11(7)

In Formulae 11(4) to 11(7),

ring $CY_{11}$ to ring $CY_{15}$ are each independently a $C_3$-$C_{60}$ (*e.g.* $C_3$-$C_{30}$) carbocyclic group or a $C_1$-$C_{60}$ (*e.g.* $C_1$-$C_{20}$) heterocyclic group,
$Y_{11}$ to $Y_{16}$ are each independently a single bond, *-O-*', *-S-*', *-C($R_{16}$)($R_{17}$)-*', *-N($R_{10}$)-*', *-Si($R_{16}$)($R_{17}$)-*', *-C(=O)-*', *-S(=O)$_2$-*', *-B($R_{10}$)-*', *-P($R_{17}$)-*', or *-P(=O)($R_{10}$)-*', and * and *' may each indicate a binding site to a neighboring atom,
$Y_{11a}$, $Y_{12a}$, and $Y_{13a}$ are each independently N, B, or P,
$R_{11}$ to $R_{17}$ are each independently hydrogen, deuterium, -F, -Cl, -Br, -I, a hydroxyl group, a cyano group, a nitro group, a $C_1$-$C_{60}$ (*e.g.* $C_1$-$C_{20}$) alkyl group unsubstituted or substituted with at least one $R_{10a}$, a $C_2$-$C_{60}$ (*e.g.* $C_2$-$C_{20}$) alkenyl group unsubstituted or substituted with at least one $R_{10a}$, a $C_2$-$C_{60}$ (*e.g.* $C_2$-$C_{20}$) alkynyl group unsubstituted or substituted with at least one $R_{10a}$, a $C_1$-$C_{60}$ (*e.g.* $C_1$-$C_{20}$) alkoxy group unsubstituted or substituted with at least one $R_{10a}$, a $C_3$-$C_{60}$ (*e.g.* $C_3$-$C_{30}$) carbocyclic group unsubstituted or substituted with at least one $R_{10a}$, a $C_1$-$C_{60}$ (*e.g.* $C_1$-$C_{20}$) heterocyclic group unsubstituted or substituted with at least one $R_{10a}$, a $C_6$-$C_{60}$ (*e.g.* $C_6$-$C_{30}$) aryloxy group unsubstituted or substituted with at least one $R_{10a}$, a $C_6$-$C_{60}$ (*e.g.* $C_6$-$C_{30}$) arylthio group unsubstituted or substituted with at least one $R_{10a}$, - Si($Q_1$)($Q_2$)($Q_3$), -N($Q_1$)($Q_2$), -B($Q_1$)($Q_2$), -C(=O)($Q_1$), -S(=O)$_2$($Q_1$), or -P(=O)($Q_1$)($Q_2$),
two or more of $R_{11}$ to $R_{17}$ are optionally linked to each other to form a $C_3$-$C_{60}$ (*e.g.* $C_3$-$C_{30}$) carbocyclic group unsubstituted or substituted with at least one $R_{10a}$ or a $C_1$-$C_{60}$ (*e.g.* $C_1$-$C_{20}$) heterocyclic group unsubstituted or substituted with at least one $R_{10a}$,
a11 to a15 are each independently an integer from 1 to 6, and
$R_{10a}$ and $Q_1$ to $Q_3$ are the same as described in the present specification.

In one or more embodiments, in Formulae 11(4) to 11(7), $CY_{11}$ to $CY_{15}$ may each independently be a benzene group, a naphthalene group, a carbazole group, a dibenzofuran group, a dibenzothiophene group, or a dibenzosilole group.

In one or more embodiments, in Formulae 11(4) to 11(7), $R_{11}$ to $R_{17}$ may each independently be: hydrogen, deuterium, -F, -Cl, -Br, -I, a methyl group, an ethyl group, an n-propyl group, an isopropyl group, an n-butyl group, a sec-butyl group, an isobutyl group, a tert-butyl group, an ethenyl group, a propenyl group, a butenyl group, a methoxy group, an ethoxy group, an n-propoxy group, an isopropoxy group, an n-butoxy group, a sec-butoxy group, an isobutoxy group, or a tert-butoxy group;

a methyl group, an ethyl group, an n-propyl group, an isopropyl group, an n-butyl group, a sec-butyl group, an isobutyl group, a tert-butyl group, a methoxy group, an ethoxy group, an n-propoxy group, an isopropoxy group, an n-butoxy group, a sec-butoxy group, an isobutoxy group, or a tert-butoxy group, substituted with deuterium, -F, -Cl, -Br, -I, a cyano group, a phenyl group, a biphenyl group, or any combination thereof;
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentacenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl

group, an isoquinolinyl group, a benzoquinolinyl group, a benzoisoquinolinyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, a benzothiazolyl group, a benzoisothiazolyl group, a benzoxazolyl group, a benzoisoxazolyl group, a triazolyl group, a tetrazolyl group, a thiadiazolyl group, an oxadiazolyl group, a triazinyl group, a carbazolyl group, a dibenzofuranyl group, a dibenzothiophenyl group, a dibenzosilolyl group, a benzocarbazolyl group, a naphthobenzofuranyl group, a naphthobenzothiophenyl group, a naphthobenzosilolyl group, a dibenzocarbazolyl group, a dinaphthofuranyl group, a dinaphthothiophenyl group, a dinaphthosilolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, an indenopyrrolyl group, an indolopyrrolyl group, an indeno carbazolyl group, and an indolocarbazolyl group, each unsubstituted or substituted with deuterium, -F, - Cl, -Br, -I, a cyano group, a methyl group, an ethyl group, an n-propyl group, an isopropyl group, an n-butyl group, a sec-butyl group, an isobutyl group, a tert-butyl group, a methoxy group, an ethoxy group, an n-propoxy group, an isopropoxy group, an n-butoxy group, a sec-butoxy group, an isobutoxy group, a tert-butoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentacenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a benzoisoquinolinyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, a benzothiazolyl group, a benzoisothiazolyl group, a benzoxazolyl group, a benzoisoxazolyl group, a triazolyl group, a tetrazolyl group, a thiadiazolyl group, an oxadiazolyl group, a triazinyl group, a carbazolyl group, a dibenzofuranyl group, a dibenzothiophenyl group, a dibenzosilolyl group, a benzocarbazolyl group, a naphthobenzofuranyl group, a naphthobenzothiophenyl group, a naphthobenzosilolyl group, a dibenzocarbazolyl group, a dinaphthofuranyl group, a dinaphthothiophenyl group, a dinaphthosilolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, an indenopyrrolyl group, an indolopyrrolyl group, an indeno carbazolyl group, an indolocarbazolyl group, - $Si(Q_{31})(Q_{32})(Q_{33})$, $-N(Q_{31})(Q_{32})$, $-B(Q_{31})(Q_{32})$, $-C(=O)(Q_{31})$, $-S(=O)(Q_{31})$, $-S(=O)_2(Q_{31})$, $-P(=O)(Q_{31})(Q_{32})$, $-P(=S)(Q_{31})(Q_{32})$, or any combination thereof; or
$-N(Q_{11})(Q_{12})$.

In one or more embodiments, the second dopant may include one of Compounds 12-1 to 12-10, Compound D2-1, or any combination thereof:

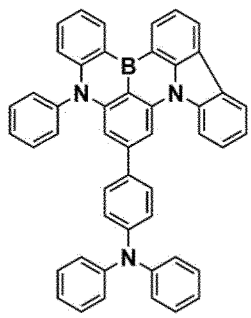

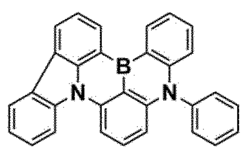

12-1 12-2

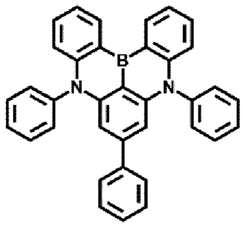
12-3

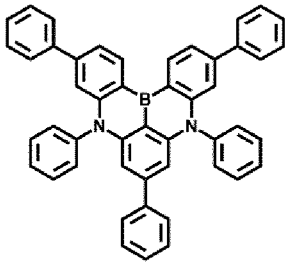
12-4

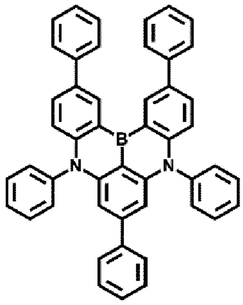
12-5

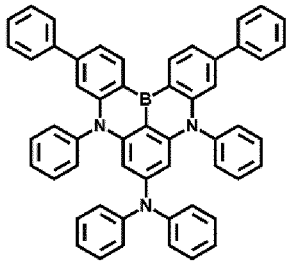
12-6

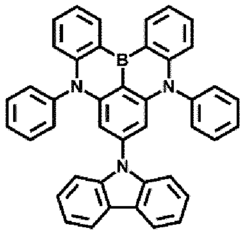
12-7

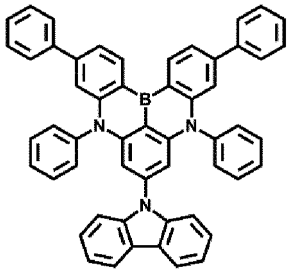
12-8

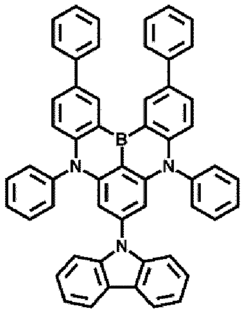
12-9

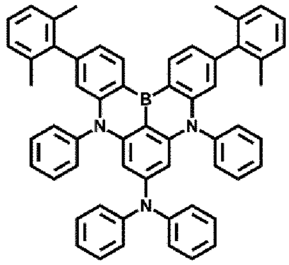
12-10

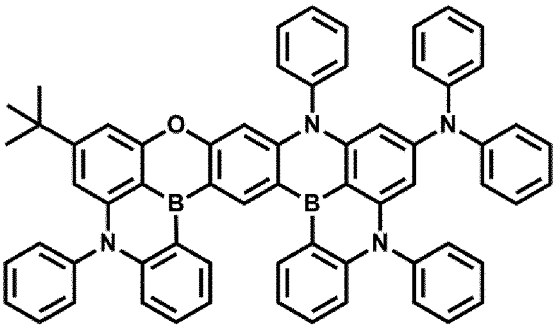
D2-1

In one or more embodiments, the second dopant may be a prompt fluorescence dopant.

In an embodiment, the fluorescent dopant may include an amine group-containing compound, a styryl group-containing compound, or any combination thereof.

In an embodiment, the fluorescent dopant may include a compound represented by Formula 501:

Formula 501

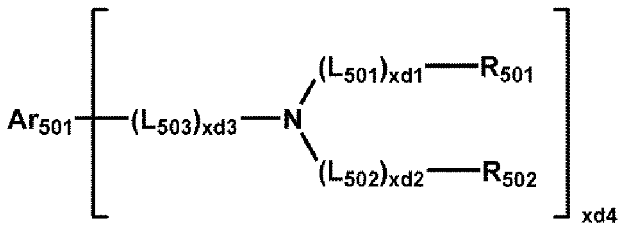

In Formula 501,

$Ar_{501}$, $L_{501}$ to $L_{503}$, $R_{501}$, and $R_{502}$ are each independently a $C_3$-$C_{60}$ (*e.g.* $C_3$-$C_{30}$) carbocyclic group unsubstituted or substituted with at least one $R_{10a}$ or a $C_1$-$C_{60}$ (*e.g.* $C_1$-$C_{20}$) heterocyclic group unsubstituted or substituted with at least one $R_{10a}$,

xd1 to xd3 are each independently 0, 1, 2, or 3, and

xd4 is 1, 2, 3, 4, 5, or 6.

In an embodiment, $Ar_{501}$ in Formula 501 may be a condensed cyclic group in which three or more monocyclic groups are condensed (for example, an anthracene group, a chrysene group, or a pyrene group).

In an embodiment, xd4 in Formula 501 may be 2.

In an embodiment, $Ar_{501}$ in Formula 501 may be a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, an indeno phenanthrene group, or a group represented by

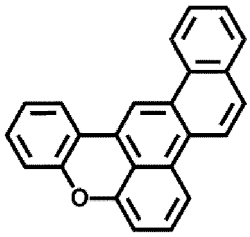

,

each unsubstituted or substituted with at least one $R_{10a}$.

In one or more embodiments, in Formula 501, $L_{501}$ to $L_{503}$, $R_{501}$, and $R_{502}$ may each independently be a benzene group, a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a perylene group, a pentaphene group, a hexacene group, a pentacene group, a thiophene group, a furan group, a carbazole group, an indole group, an isoindole group, a benzofuran group, a benzothiophene group, a dibenzofuran group, a dibenzothiophene group, a benzocarbazole group, a dibenzocarbazole group, a dibenzosilole group, or a pyridine group, each unsubstituted or substituted with at least one $R_{10a}$.

In an embodiment, the fluorescent dopant may include one of Compounds FD1 to FD37, DPVBi, DPAVBi, or any combination thereof:

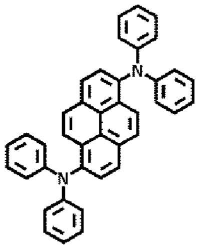

FD1

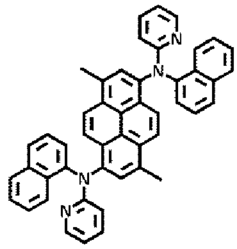

FD2

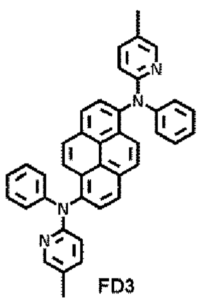

FD3

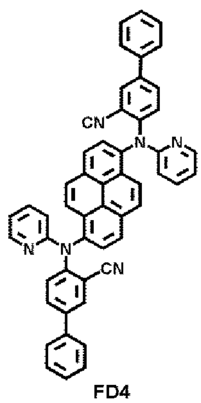

FD4

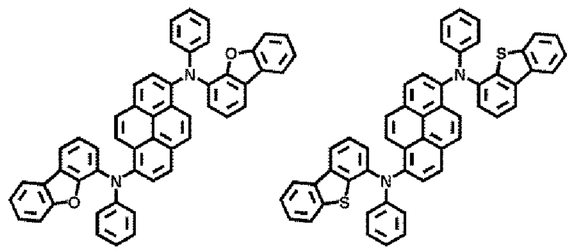

FD5 FD6

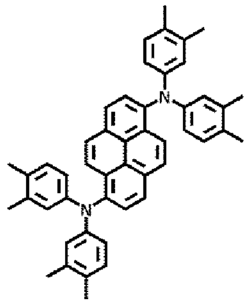

FD7

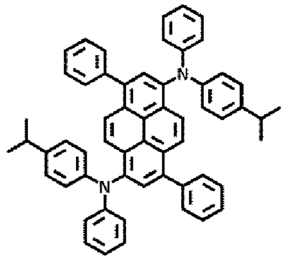

FD8

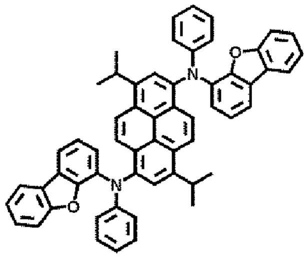

FD9

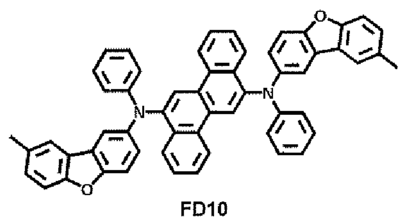

FD10

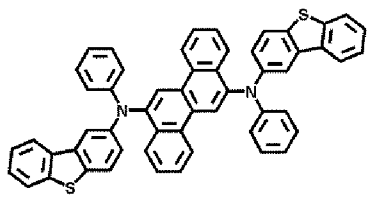

FD11

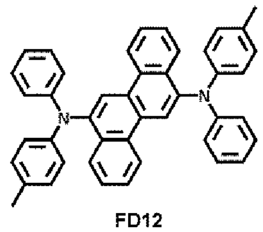

FD12

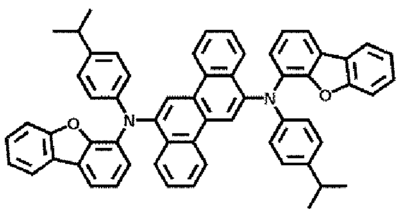

FD13

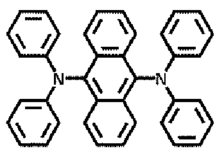

FD14

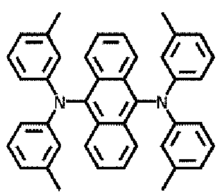

FD15

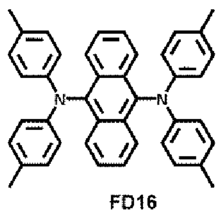

FD16

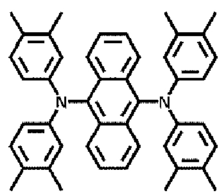

FD17

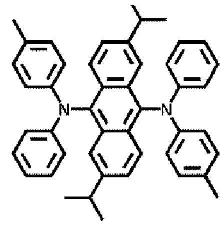

FD18

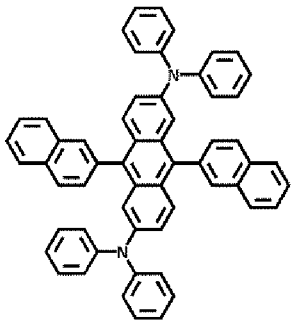

FD19

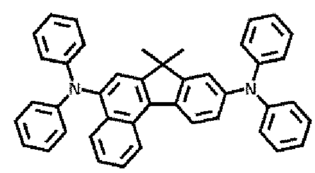

FD20

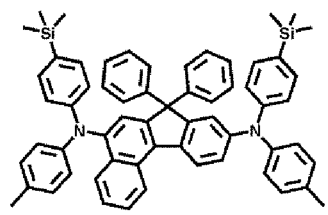

FD21

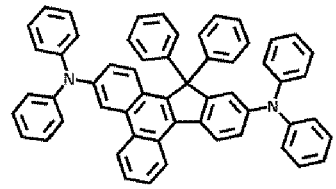
FD22

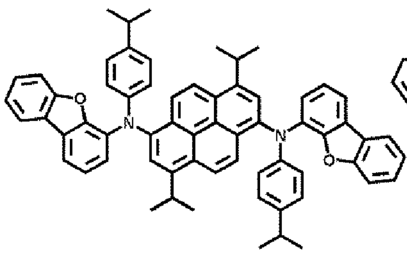
FD23

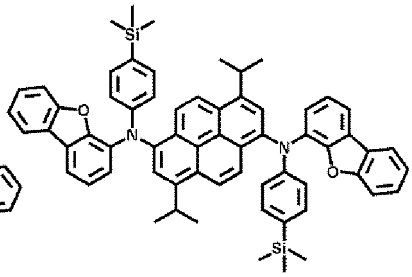
FD24

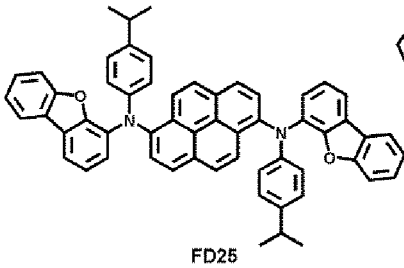
FD25

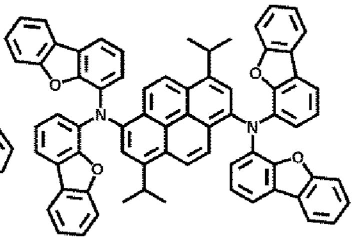
FD26

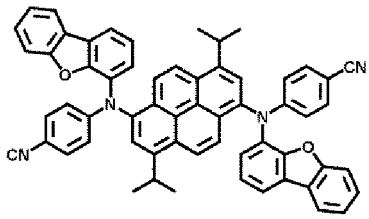
FD27

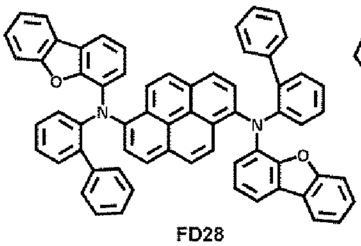
FD28

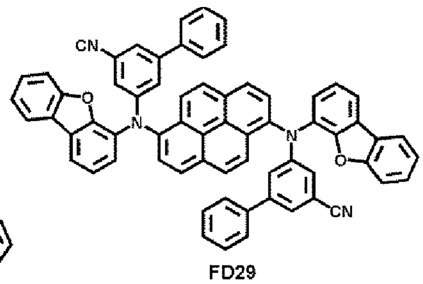
FD29

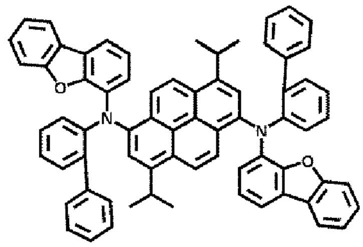
FD30

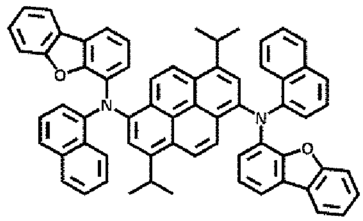
FD31

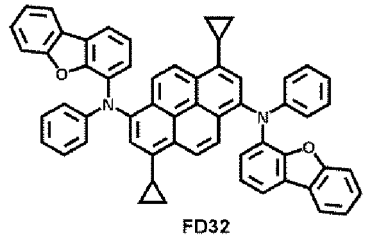
FD32

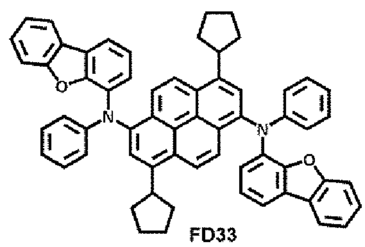
FD33

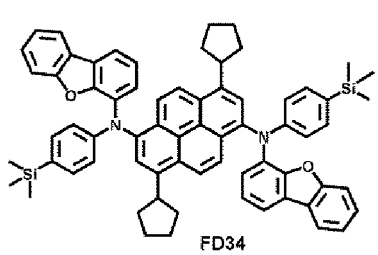
FD34

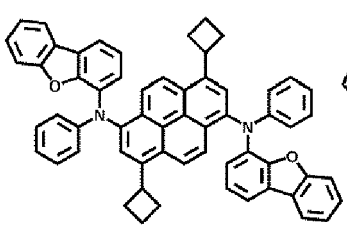
FD35

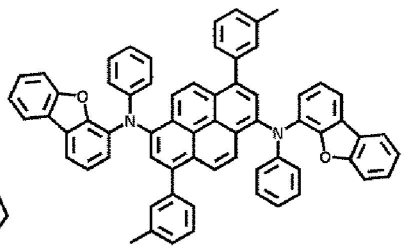
FD36

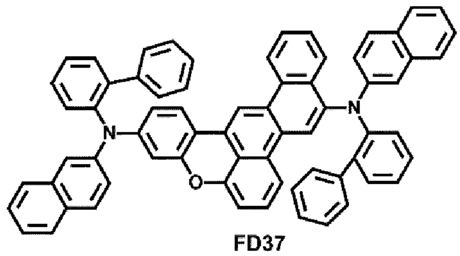

FD37

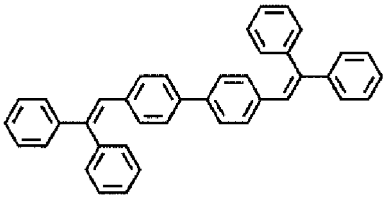

DPVBi

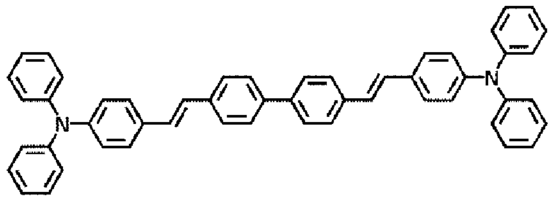

DPAVBi

[Electron transport region in interlayer 130]

The electron transport region may have: i) a single-layered structure consisting of a single layer consisting of a single material, ii) a single-layered structure consisting of a single layer consisting of a plurality of different materials, or iii) a multi-layered structure including a plurality of layers including different materials.

The electron transport region may include a buffer layer, a hole blocking layer, an electron control layer, an electron transport layer, an electron injection layer, or any combination thereof.

In an embodiment, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, wherein, for each structure, constituting layers are sequentially stacked from an emission layer.

The electron transport region (for example, the buffer layer, the hole blocking layer, the electron control layer, or the electron transport layer in the electron transport region) may include a metal-free compound including at least one $\pi$-electron-deficient nitrogen-containing $C_1$-$C_{60}$ (*e.g.* $C_1$-$C_{20}$) cyclic group.

In an embodiment, the electron transport region may include a compound represented by Formula 601 below:

Formula 601 $[Ar_{601}]_{xe11}$-$[(L_{601})_{xe1}$-$R_{601}]_{xe21}$

In Formula 601,

$Ar_{601}$ and $L_{601}$ are each independently a $C_3$-$C_{60}$ (*e.g.* $C_3$-$C_{30}$) carbocyclic group unsubstituted or substituted with at least one $R_{10a}$ or a $C_1$-$C_{60}$ (*e.g.* $C_1$-$C_{20}$) heterocyclic group unsubstituted or substituted with at least one $R_{10a}$,
xe11 is 1, 2, or 3,
xe1 is 0, 1, 2, 3, 4, or 5,
$R_{601}$ is a $C_3$-$C_{60}$ (*e.g.* $C_3$-$C_{30}$) carbocyclic group unsubstituted or substituted with at least one $R_{10a}$, a $C_1$-$C_{60}$ (*e.g.* $C_1$-$C_{20}$) heterocyclic group unsubstituted or substituted with at least one $R_{10a}$, -Si($Q_{601}$)($Q_{602}$)($Q_{603}$), -C(=O)($Q_{601}$), -S(=O)$_2$($Q_{601}$), or -P(=O)($Q_{601}$)($Q_{602}$),
$Q_{601}$ to $Q_{603}$ are the same as described in connection with $Q_1$,
xe21 is 1, 2, 3, 4, or 5, and
at least one of $Ar_{601}$, $L_{601}$, and $R_{601}$ may each independently be a $\pi$ electron-deficient nitrogen-containing $C_1$-$C_{60}$ (*e.g.* $C_1$-$C_{20}$) cyclic group unsubstituted or substituted with at least one $R_{10a}$.

In an embodiment, when xe11 in Formula 601 is 2 or more, two or more of $Ar_{601}$ (s) may be linked to each other via a single bond.

In an embodiment, $Ar_{601}$ in Formula 601 may be a substituted or unsubstituted anthracene group.

In an embodiment, the electron transport region may include a compound represented by Formula 601-1 :

Formula 601-1

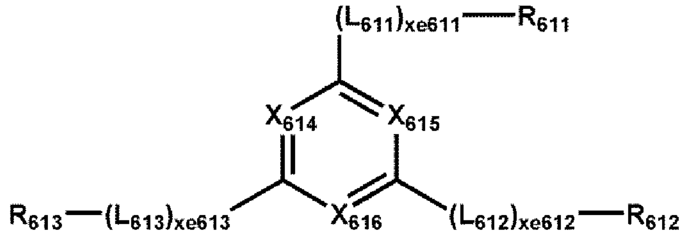

In Formula 601-1,

$X_{614}$ is N or $C(R_{614})$, $X_{615}$ is N or $C(R_{615})$, $X_{616}$ is N or $C(R_{616})$, and at least one of $X_{614}$ to $X_{616}$ is N,
$L_{611}$ to $L_{613}$ may be understood by referring to the description presented in connection with $L_{601}$,
xe611 to xe613 may be understood by referring to the description presented in connection with xe1,
$R_{611}$ to $R_{613}$ may be understood by referring to the description presented in connection with $R_{601}$, and
$R_{614}$ to $R_{616}$ are each independently hydrogen, deuterium, -F, -Cl, -Br, -I, a hydroxyl group, a cyano group, a nitro group, a $C_1$-$C_{20}$ (*e.g.* $C_1$-$C_{10}$) alkyl group, a $C_1$-$C_{20}$ (*e.g.* $C_1$-$C_{10}$) alkoxy group, a $C_3$-$C_{60}$ (*e.g.* $C_3$-$C_{30}$) carbocyclic group unsubstituted or substituted with at least one $R_{10a}$, or a $C_1$-$C_{60}$ (*e.g.* $C_1$-$C_{20}$) heterocyclic group unsubstituted or substituted with at least one $R_{10a}$.

In an embodiment, xe1 and xe611 to xe613 in Formulae 601 and 601-1 may each independently be 0, 1, or 2.

The electron transport region may include one of Compounds ET1 to ET45, 2,9-dimethyl-4,7-diphenyl-1,10-phenanthroline (BCP), 4,7-diphenyl-1,10-phenanthroline (Bphen), $Alq_3$, BAlq, TAZ, NTAZ, or any combination thereof:

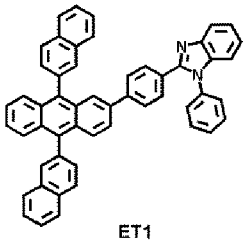

ET1

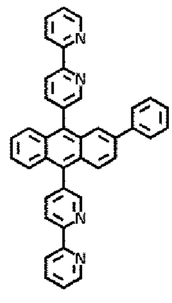

ET2

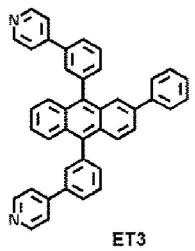

ET3

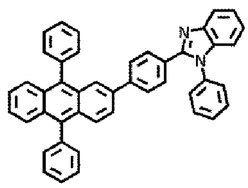

ET4

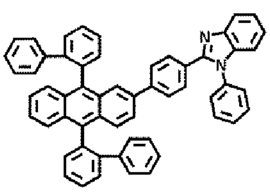

ET5

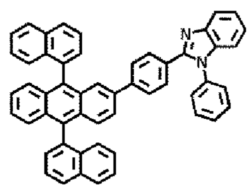

ET6

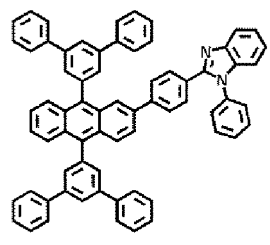

ET7

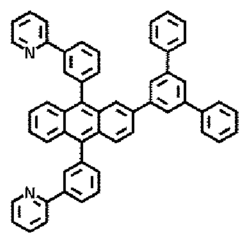

ET8

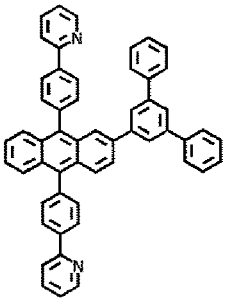
ET9

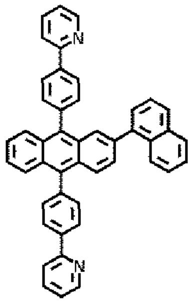
ET10

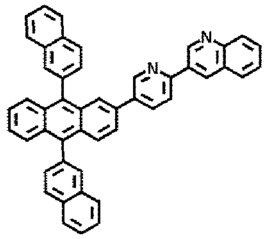
ET11

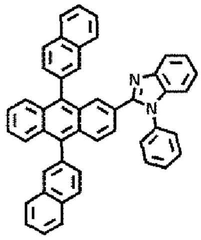
ET12

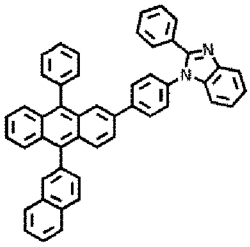
ET13

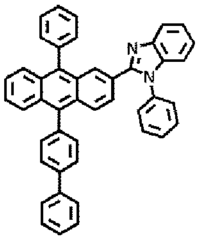
ET14

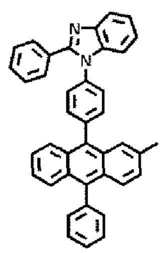
ET15

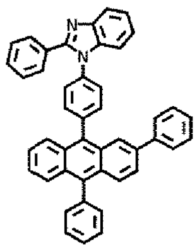
ET16

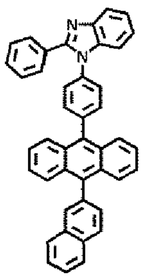
ET17

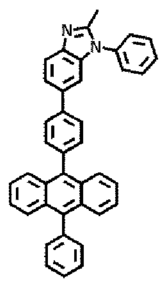
ET18

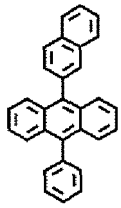
ET19

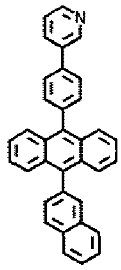
ET20

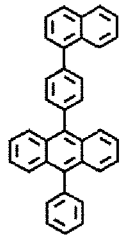
ET21

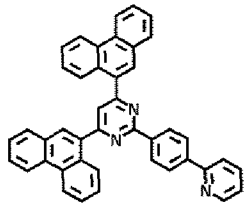
ET22

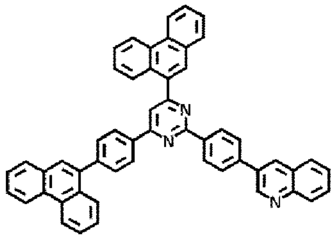
ET23

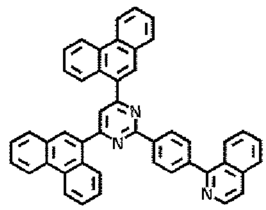
ET24

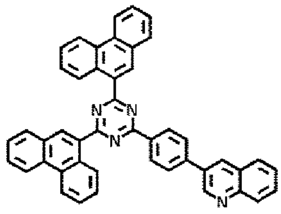
ET25

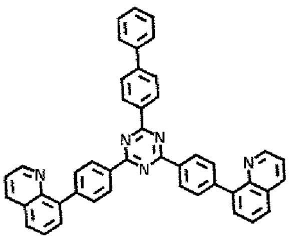
ET26

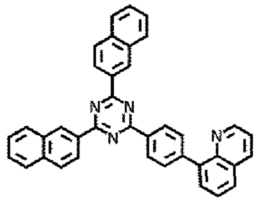
ET27

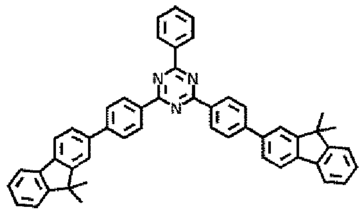
ET28

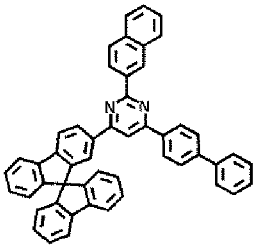
ET29
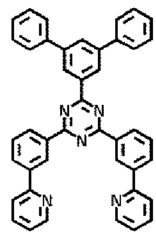
ET30
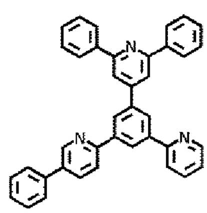
ET31
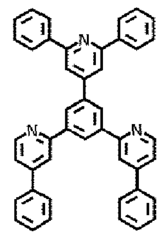
ET32

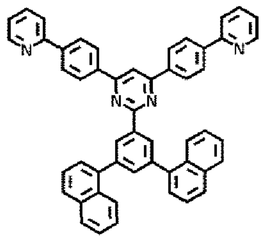
ET33
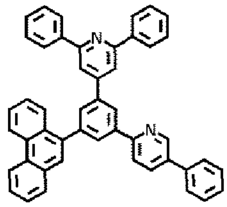
ET34
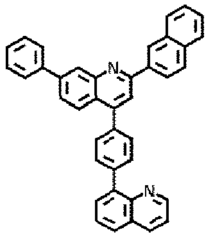
ET35
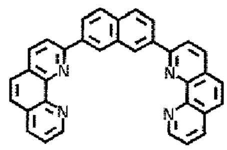
ET36

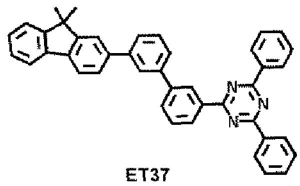
ET37
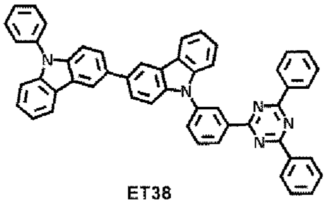
ET38
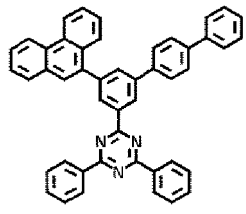
ET39
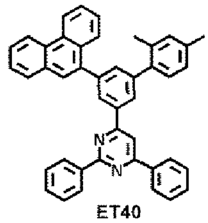
ET40

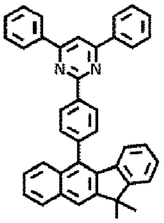
ET41
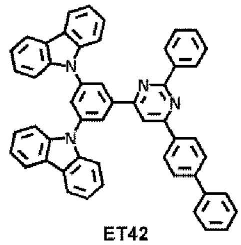
ET42
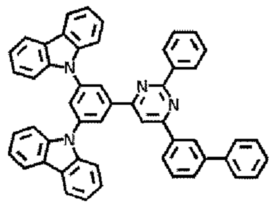
ET43
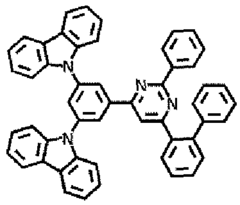
ET44

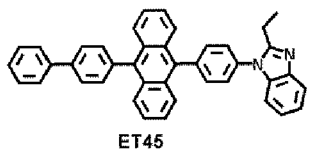
ET45

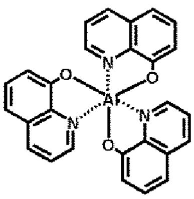
$Alq_3$
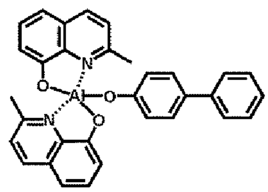
BAlq
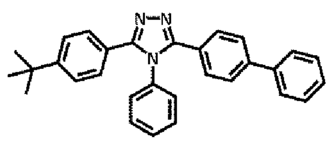
TAZ
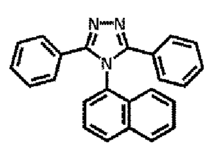
NTAZ

A thickness of the electron transport region may be from about 100 Å to about 5000 Å or about 160 Å to about 5,000 Å, for example, about 100 Å to about 4,000 Å or about 100 Å to about 1000 Å. When the electron transport region includes a buffer layer, a hole blocking layer, an electron control layer, an electron transport layer, or any combination

thereof, a thickness of the buffer layer, the hole blocking layer, or the electron control layer may each independently be from about 20 Å to about 1,000 Å, for example, about 20 Å to about 700 Å, about 20 Å to about 500 Å, about 20 Å to about 400 Å, about 30 Å to about 400 Å or about 30 Å to about 300 Å, and the thickness of the electron transport layer may be from about 100 Å to about 1,000 Å, for example, about 100 Å to about 700 Å, about 100 Å to about 600 Å, about 150 Å to about 600 Å, about 150 Å to about 500 Å or about 200 Å to about 400 Å. When the thickness of the buffer layer, the hole blocking layer, the electron control layer, and/or the electron transport layer are within these ranges, satisfactory electron transporting characteristics may be obtained without a substantial increase in driving voltage.

The electron transport region (for example, the electron transport layer in the electron transport region) may further include, in addition to the materials described above, a metal-containing material.

The metal-containing material may include an alkali metal complex, an alkaline earth-metal complex, or any combination thereof. A metal ion of the alkali metal complex may be a Li ion, a Na ion, a K ion, a Rb ion, or a Cs ion, and a metal ion of the alkaline earth-metal complex may be a Be ion, a Mg ion, a Ca ion, a Sr ion, or a Ba ion. A ligand coordinated with the metal ion of the alkali metal complex or the alkaline earth-metal complex may be a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

In an embodiment, the metal-containing material may include a Li complex. The Li complex may include, for example, Compound ET-D1 (LiQ) or ET-D2:

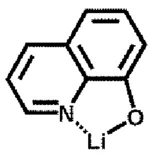

ET-D1

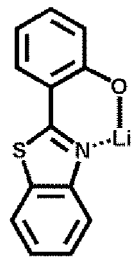

ET-D2

The electron transport region may include an electron injection layer that facilitates the injection of electrons from the second electrode 150. The electron injection layer may directly contact the second electrode 150.

The electron injection layer may have: i) a single-layered structure consisting of a single layer consisting of a single material, ii) a single-layered structure consisting of a single layer including a plurality of different materials, or iii) a multi-layered structure including a plurality of layers including different materials.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth-metal complex, a rare earth metal complex, or any combination thereof.

The alkali metal may include Li, Na, K, Rb, Cs, or any combination thereof. The alkaline earth metal may include Mg, Ca, Sr, Ba, or any combination thereof. The rare earth metal may include Sc, Y, Ce, Tb, Yb, Gd, or any combination thereof.

The alkali metal-containing compound, the alkaline earth metal-containing compound, and the rare earth metal-containing compound may be oxides and halides (for example, fluorides, chlorides, bromides, or iodides) of the alkali metal, the alkaline earth metal, and the rare earth metal, telluride, or any combination thereof.

The alkali metal-containing compound may be alkali metal oxides, such as $Li_2O$, $Cs_2O$, or $K_2O$, and alkali metal halides, such as LiF, NaF, CsF, KF, LiI, NaI, CsI, or KI, or any combination thereof. The alkaline earth metal-containing compound may include an alkaline earth metal oxides, such as BaO, SrO, CaO, $Ba_xSr_{1-x}O$ (x is a real number that satisfies the condition of 0<x<1), or $Ba_xCa_{1-x}O$ (x is a real number that satisfies the condition of 0<x<1). The rare earth metal-containing compound may include $YbF_3$, $ScF_3$, $Sc_2O_3$, $Y_2O_3$, $Ce_2O_3$, $GdF_3$, $TbF_3$, $YbI_3$, $ScI_3$, $TbI_3$, or any combination thereof. In an embodiment, the rare earth metal-containing compound may include lanthanide metal telluride. Examples of the lanthanide metal telluride are LaTe, CeTe, PrTe, NdTe, PmTe, SmTe, EuTe, GdTe, TbTe, DyTe, HoTe, ErTe, TmTe, YbTe, LuTe, $La_2Te_3$, $Ce_2Te_3$, $Pr_2Te_3$, $Nd_2Te_3$, $Pm_2Te_3$, $Sm_2Te_3$, $Eu_2Te_3$, $Gd_2Te_3$, $Tb_2Te_3$, $Dy_2Te_3$, $Ho_2Te_3$, $Er_2Te_3$, $Tm_2Te_3$, $Yb_2Te_3$, and $Lu_2Te_3$.

The alkali metal complex, the alkaline earth-metal complex, and the rare earth metal complex may include i) one of ions of the alkali metal, the alkaline earth metal, and the rare earth metal and ii) as a ligand linked to the metal ion, for example, hydroxyquinoline, hydroxyan isoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenyl benzimidazole, hydroxyphenylbenzothiazole, bipyridine, phenanthroline, cyclopentadiene, or any combination thereof.

The electron injection layer may consist of an alkali metal, an alkaline earth metal, a rare earth metal, an alkali metal-containing compound, an alkaline earth metal-containing compound, a rare earth metal-containing compound, an alkali metal complex, an alkaline earth-metal complex, a rare earth metal complex, or any combination thereof, or may further include an organic material (for example, a compound represented by Formula 601).

In an embodiment, the electron injection layer may consist of i) an alkali metal-containing compound (for example, an alkali metal halide), or ii) a) an alkali metal-containing compound (for example, an alkali metal halide); and b) alkali metal, alkaline earth metal, rare earth metal, or any combination thereof. In an embodiment, the electron injection layer may be a KI:Yb co-deposited layer or a RbI:Yb co-deposited layer.

When the electron injection layer further includes an organic material, an alkali metal, an alkaline earth metal, a rare earth metal, an alkali metal-containing compound, an alkaline earth metal-containing compound, a rare earth metal-containing compound, an alkali metal complex, an alkaline earth-metal complex, a rare earth metal complex, or any combination thereof may be homogeneously or non-homogeneously dispersed in a matrix including the organic material.

A thickness of the electron injection layer may be in the range of about 1 Å to about 100 Å, for example, about 3 Å to about 90 Å or about 3 Å to about 20 Å . When the thickness of the electron injection layer is within the range described above, the electron injection layer may have satisfactory electron injection characteristics without a substantial increase in driving voltage.

[Second electrode 150]

The second electrode 150 may be located on the interlayer 130 having such a structure. The second electrode 150 may be a cathode, which is an electron injection electrode, and as the material for forming the second electrode 150, a metal, an alloy, an electrically conductive compound, or any combination thereof, each having a low work function, may be used.

The second electrode 150 may include lithium (Li), silver (Ag), magnesium (Mg), aluminium (Al), aluminium-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The second electrode 150 may be a transmissive electrode, a semi-transmissive electrode, or a reflective electrode.

The second electrode 150 may have a single-layered structure or a multi-layered structure including two or more layers.

[Capping layer]

A first capping layer may be located outside the first electrode 110, and/or a second capping layer may be located outside the second electrode 150. In detail, the light-emitting device 10 may have a structure in which the first capping layer, the first electrode 110, the interlayer 130, and the second electrode 150 are sequentially stacked in this stated order, a structure in which the first electrode 110, the interlayer 130, the second electrode 150, and the second capping layer are sequentially stacked in this stated order, or a structure in which the first capping layer, the first electrode 110, the interlayer 130, the second electrode 150, and the second capping layer are sequentially stacked in this stated order.

Light generated in an emission layer of the interlayer 130 of the light-emitting device 10 may be extracted toward the outside through the first electrode 110, which is a semi-transmissive electrode or a transmissive electrode, and the first capping layer, and light generated in an emission layer of the interlayer 130 of the light-emitting device 10 may be extracted toward the outside through the second electrode 150, which is a semi-transmissive electrode or a transmissive electrode, and the second capping layer.

The first capping layer and the second capping layer may increase external luminescence efficiency according to the principle of constructive interference. Accordingly, the light extraction efficiency of the light-emitting device 10 is increased, so that the luminescence efficiency of the light-emitting device 10 may be improved.

Each of the first capping layer and the second capping layer may include a material having a refractive index of 1.6 or more (at 589 nm).

The first capping layer and the second capping layer may each independently be an organic capping layer including an organic material, an inorganic capping layer including an inorganic material, or an organic-inorganic composite capping layer including an organic material and an inorganic material.

At least one of the first capping layer and the second capping layer may each independently include a carbocyclic compound, a heterocyclic compound, an amine group-containing compound, a porphyrin derivative, a phthalocyanine derivative, a naphthalocyanine derivative, an alkali metal complex, an alkaline earth-metal complex, or any combination

thereof. The carbocyclic compound, the heterocyclic compound, and the amine group-containing compound may be optionally substituted with a substituent containing O, N, S, Se, Si, F, Cl, Br, I, or any combination thereof. In an embodiment, at least one of the first capping layer and the second capping layer may each independently include an amine group-containing compound.

In an embodiment, at least one of the first capping layer and second capping layer may each independently include a compound represented by Formula 201, a compound represented by Formula 202, or any combination thereof.

In an embodiment, at least one of the first capping layer and the second capping layer may each independently include one of Compounds HT28 to HT33, one of Compounds CP1 to CP6, β-NPB, or any combination thereof:

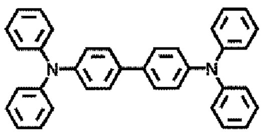

CP1

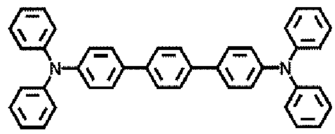

CP2

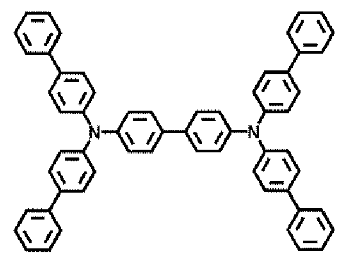

CP3

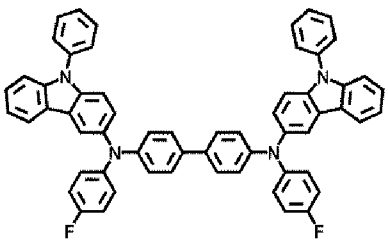

CP4

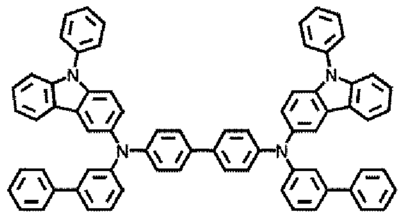

CP5

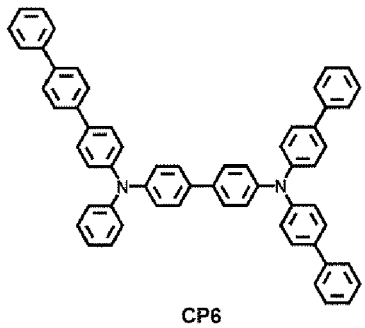

CP6

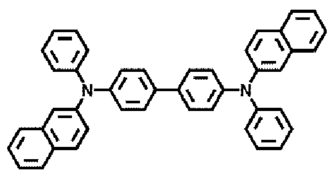

β-NPB

[Electronic apparatus]

The light-emitting device may be included in various electronic apparatuses. In an embodiment, an electronic apparatus including the light-emitting device may be a light-emitting apparatus, an authentication apparatus, or the like.

The electronic apparatus (for example, light-emitting apparatus) may further include, in addition to the light-emitting device, i) a color filter, ii) a color conversion layer, or iii) a color filter and a color conversion layer. The color filter and/or the color conversion layer may be located in at least one traveling direction of light emitted from the light-emitting device. In an embodiment, light emitted from the light-emitting device may be blue light or white light. The light-emitting device may be the same as described above. In an embodiment, the color conversion layer may include a quantum dot.

The electronic apparatus may include a first substrate. The first substrate may include a plurality of subpixel areas, the color filter may include a plurality of color filter areas respectively corresponding to the plurality of subpixel areas, and the color conversion layer may include a plurality of color conversion areas respectively corresponding to the plurality of subpixel areas.

A pixel-defining film may be located between the plurality of subpixel areas to define each of the subpixel areas.

The color filter may further include a plurality of color filter areas and light-blocking patterns located between

the plurality of color filter areas, and the color conversion layer may further include a plurality of color conversion areas and light-blocking patterns located between the plurality of color conversion areas.

The plurality of color filter areas (or the plurality of color conversion areas) may include a first area emitting first-color light, a second area emitting second-color light, and/or a third area emitting third-color light, and the first-color light, the second-color light, and/or the third-color light may have different maximum emission wavelengths from one another. In an embodiment, the first-color light may be red light, the second-color light may be green light, and the third-color light may be blue light. In an embodiment, the plurality of color filter areas (or the plurality of color conversion areas) may include quantum dots. In detail, the first area may include a red quantum dot, the second area may include a green quantum dot, and the third area may not include a quantum dot. Each of the first area, the second area, and/or the third area may further include a scattering body.

In an embodiment, the light-emitting device may emit first light, the first area may absorb the first light to emit first first-color light, the second area may absorb the first light to emit second first-color light, and the third area may absorb the first light to emit third first-color light. In this regard, the first first-color light, the second first-color light, and the third first-color light may have different maximum emission wavelengths from one another. In detail, the first light may be blue light, the first first-color light may be red light, the second first-color light may be green light, and the third first-color light may be blue light.

The electronic apparatus may further include a thin-film transistor in addition to the light-emitting device as described above. The thin-film transistor may include a source electrode, a drain electrode, and an activation layer, wherein any one of the source electrode and the drain electrode may be electrically connected to any one of the first electrode and the second electrode of the light-emitting device.

The thin-film transistor may further include a gate electrode, a gate insulation layer, or the like.

The activation layer may include crystalline silicon, amorphous silicon, organic semiconductor, oxide semiconductor, or the like.

The electronic apparatus may further include a sealing portion for sealing the light-emitting device. The sealing portion may be located between the color filter and/or the color conversion layer and the light-emitting device. The sealing portion allows light from the light-emitting device to be extracted to the outside, while simultaneously preventing ambient air and moisture from penetrating into the light-emitting device. The sealing portion may be a sealing substrate including a transparent glass substrate or a plastic substrate. The sealing portion may be a thin film encapsulation layer including one or more organic layers and/or one or more inorganic layers. When the sealing portion is a thin film encapsulation layer, the electronic apparatus may be flexible.

On the sealing portion, in addition to the color filter and/or color conversion layer, various functional layers may be further located according to the use of the electronic apparatus. Examples of the functional layers may include a touch screen layer, a polarizing layer, and the like. The touch screen layer may be a pressure-sensitive touch screen layer, a capacitive touch screen layer, or an infrared touch screen layer. The authentication apparatus may be, for example, a biometric authentication apparatus for authenticating an individual by using biometric information of a biometric body (for example, a fingertip, a pupil, or the like).

The authentication apparatus may further include, in addition to the light-emitting device, a biometric information collector.

The electronic apparatus may be applied to various displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, or endoscope displays), fish finders, various measuring instruments, meters (for example, meters for a vehicle, an aircraft, and a vessel), projectors, and the like.

[Description of FIGS. 2 and 3]

FIG. 2 is a cross-sectional view showing a light-emitting apparatus according to an embodiment of the present disclosure.

The light-emitting apparatus of FIG. 2 includes a substrate 100, a thin-film transistor (TFT), a light-emitting device, and an encapsulation portion 300 that seals light-emitting device.

The substrate 100 may be a flexible substrate, a glass substrate, or a metal substrate. A buffer layer 210 may be located on the substrate 100. The buffer layer 210 prevents the penetration of impurities through the substrate 100 and may provide a flat surface on the substrate 100.

The TFT may be located on the buffer layer 210. The TFT may include an activation layer 220, a gate electrode 240, a source electrode 260, and a drain electrode 270.

The activation layer 220 may include an inorganic semiconductor such as silicon or polysilicon, an organic semiconductor, or an oxide semiconductor, and may include a source region, a drain region, and a channel region.

A gate insulating film 230 for insulating the activation layer 220 from the gate electrode 240 may be located on the activation layer 220, and the gate electrode 240 may be located on the gate insulating film 230.

An interlayer insulating film 250 may be located on the gate electrode 240. The interlayer insulating film 250 is located between the gate electrode 240 and the source electrode 260 to insulate the gate electrode 240 from the source electrode 260 and between the gate electrode 240 and the drain electrode 270 to insulate the gate electrode 240 from the drain electrode 270.

The source electrode 260 and the drain electrode 270 may be located on the interlayer insulating film 250. The interlayer insulating film 250 and the gate insulating film 230 may be formed to expose the source region and the drain region of the activation layer 220, and the source electrode 260 and the drain electrode 270 may be located to be in contact with the exposed portions of the source region and the drain region of the activation layer 220.

The TFT may be electrically connected to a light-emitting device to drive the light-emitting device, and is protected by being covered by a passivation layer 280. The passivation layer 280 may include an inorganic insulating film, an organic insulating film, or a combination thereof. A light-emitting device is provided on the passivation layer 280. The light-emitting device includes the first electrode 110, the interlayer 130, and the second electrode 150.

The first electrode 110 may be located on the passivation layer 280. The passivation layer 280 does not completely cover the drain electrode 270 and exposes a portion of the drain electrode 270, and the first electrode 110 may be connected to the exposed portion of the drain electrode 270.

A pixel defining layer 290 including an insulating material may be located on the first electrode 110. The pixel defining layer 290 may expose a certain region of the first electrode 110, and the interlayer 130 may be formed in the exposed region of the first electrode 110. The pixel defining layer 290 may be a polyimide or polyacryl-based organic film. Although not shown in FIG. 2, at least some layers of the interlayer 130 may extend beyond the upper portion of the pixel defining layer 290 and may thus be located in the form of a common layer.

The second electrode 150 may be located on the interlayer 130, and a capping layer 170 may be additionally formed on the second electrode 150. The capping layer 170 may be formed to cover the second electrode 150.

The encapsulation portion 300 may be located on the capping layer 170. The encapsulation portion 300 may be located on a light-emitting device and protects the light-emitting device from moisture or oxygen. The encapsulation portion 300 may include: an inorganic film including silicon nitride (SiNx), silicon oxide (SiOx), indium tin oxide, indium zinc oxide, or a combination thereof; an organic film including polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate or polyacrylic acid), an epoxy-based resin (for example, aliphatic glycidyl ether (AGE)), or any combination thereof; or a combination of an inorganic film and an organic film.

FIG. 3 is a cross-sectional view of a light-emitting apparatus according to another embodiment.

The light-emitting apparatus of FIG. 3 is the same as the light-emitting apparatus of FIG. 2, except that a light-blocking pattern 500 and a functional region 400 are additionally located on the encapsulation portion 300. The functional region 400 may be i) a color filter area, ii) a color conversion areas, or iii) a combination of the color filter area and the color conversion area. In an embodiment, the light-emitting device included in the light-emitting apparatus of FIG. 3 may be a tandem light-emitting device.

[Preparation method]

Layers constituting the hole transport region, an emission layer, and layers constituting the electron transport region may be formed in a certain region by using one or more suitable methods selected from vacuum deposition, spin coating, casting, Langmuir-Blodgett (LB) deposition, ink-jet printing, laser-printing, and laser-induced thermal imaging.

When layers constituting the hole transport region, the emission layer, and layers constituting the electron transport region are formed by vacuum deposition, the vacuum deposition may be performed at a deposition temperature of about 100 °C to about 500 °C, a vacuum degree of about $10^{-8}$ torr to about $10^{-3}$ torr, and a deposition speed of about 0.01 Å/sec to about 100 Å/sec by taking into account a material to be included in a layer to be formed and the structure of a layer to be formed.

[Definition of Terms]

The term "$C_3$-$C_{60}$ carbocyclic group" as used herein refers to a cyclic group that consists of carbon only as a ring-forming atom and has three to sixty carbon atoms, and the term "$C_1$-$C_{60}$ heterocyclic group" as used herein refers to a cyclic group that has one to sixty carbon atoms and further includes, in addition to carbon, a heteroatom as a ring-forming atom. The $C_3$-$C_{60}$ carbocyclic group and the $C_1$-$C_{60}$ heterocyclic group may each be a monocyclic group that consists of one ring or a polycyclic group in which two or more rings are condensed with each other. In an embodiment, the number of ring-forming atoms of the $C_1$-$C_{60}$ heterocyclic group may be from 3 to 61.

The term "cyclic group" as used herein includes the $C_3$-$C_{60}$ carbocyclic group and the $C_1$-$C_{60}$ heterocyclic group.

The term "π electron-rich $C_3$-$C_{60}$ cyclic group" as used herein refers to a cyclic group that has three to sixty carbon atoms and does not include *-N=*' as a ring-forming moiety, and the term "π electron-deficient nitrogen-containing $C_1$-$C_{60}$ cyclic group" as used herein refers to a heterocyclic group that has one to sixty carbon atoms and includes *-N=*' as a ring-forming moiety.

In an embodiment,

the $C_3$-$C_{60}$ carbocyclic group may be i) a group T1 or ii) a condensed cyclic group in which two or more groups T1 are condensed with each other (for example, a cyclopentadiene group, an adamantane group, a norbornane group, a benzene group, a pentalene group, a naphthalene group, an azulene group, an indacene group, acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),

the $C_1$-$C_{60}$ heterocyclic group may be i) a group T2, ii) a condensed cyclic group in which two or more groups T2 are condensed with each other, or iii) a condensed cyclic group in which at least one group T2 and at least one group T1 are condensed with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothieno dibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, or an azadibenzofuran group),

the π electron-rich $C_3$-$C_{60}$ cyclic group may be i) a group T1, ii) a condensed cyclic group in which two or more groups T1 are condensed with each other, iii) a group T3, iv) a condensed cyclic group in which two or more groups T3 are condensed with each other, or v) a condensed cyclic group in which at least one group T3 and at least one group T1 are condensed with each other (for example, a $C_3$-$C_{60}$ carbocyclic group, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, or a benzothienodibenzothiophene group),

the π-electron-deficient nitrogen-containing $C_1$-$C_{60}$ cyclic group may be i) a group T4, ii) a condensed cyclic group in which two or more groups T4 are condensed with each other, iii) a condensed cyclic group in which at least one group T4 and at least one group T1 are condensed with each other, iv) a condensed cyclic group in which at least one group T4 and at least one group T3 are condensed with each other, or v) a condensed cyclic group in which at least one group T4, at least one group T1, and at least one group T3 are condensed with each other (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, or an azadibenzofuran group),

the group T1 may be a cyclopropane group, a cyclobutane group, a cyclopentane group, a cyclohexane group, a

cycloheptane group, a cyclooctane group, a cyclobutene group, a cyclopentene group, a cyclopentadiene group, a cyclohexene group, a cyclohexadiene group, a cycloheptene group, an adamantane group, a norbornane group (or, a bicyclo[2.2.1]heptane group), a norbornene group, a bicyclo[1.1.1]pentane group, a bicyclo[2.1.1]hexane group, a bicyclo[2.2.2]octane group, or a benzene group,

the group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group,

the group T3 may be a furan group, a thiophene group, a 1H-pyrrole group, a silole group, or a borole group, and

the group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "the cyclic group, the $C_3$-$C_{60}$ carbocyclic group, the $C_1$-$C_{60}$ heterocyclic group, the $\pi$ electron-rich $C_3$-$C_{60}$ cyclic group, or the rr-electron-deficient nitrogen-containing $C_1$-$C_{60}$ cyclic group" as used herein refer to a group that is condensed with a cyclic group, a monovalent group, a polyvalent group (for example, a divalent group, a trivalent group, a tetravalent group, or the like), according to the structure of a formula described with corresponding terms. In an embodiment, the term "benzene group" may be a benzo group, a phenyl group, a phenylene group, or the like, which may be easily understand by one of ordinary skill in the art according to the structure of a formula including the "benzene group."

In an embodiment, examples of the monovalent $C_3$-$C_{60}$ carbocyclic group and the monovalent $C_1$-$C_{60}$ heterocyclic group are a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed polycyclic group, and a monovalent non-aromatic condensed heteropolycyclic group, and examples of the divalent $C_3$-$C_{60}$ carbocyclic group and the divalent $C_1$-$C_{60}$ heterocyclic group are a $C_3$-$C_{10}$ cycloalkylene group, a $C_1$-$C_{10}$ heterocycloalkylene group, a $C_3$-$C_{10}$ cycloalkenylene group, a $C_1$-$C_{10}$ heterocycloalkenylene group, a $C_6$-$C_{60}$ arylene group, a $C_1$-$C_{60}$ heteroarylene group, a divalent non-aromatic condensed polycyclic group, and a substituted or unsubstituted divalent non-aromatic condensed heteropolycyclic group.

The term "$C_1$-$C_{60}$ alkyl group" as used herein refers to a linear or branched aliphatic hydrocarbon saturated monovalent group having 1 to 60 carbon atoms, and examples thereof are a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "$C_1$-$C_{60}$ alkylene group" as used herein refers to a divalent group having the same structure as the $C_1$-$C_{60}$ alkyl group. Corresponding definitions apply to other ranges given for the number of carbon atoms in an alkyl/alkylene group.

The term "$C_2$-$C_{60}$ alkenyl group" as used herein refers to a monovalent hydrocarbon group having at least one carbon-carbon double bond in the middle or at the terminus of a $C_2$-$C_{60}$ alkyl group, and examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group. Corresponding definitions apply to other ranges given for the number of carbon atoms in an alkenyl/alkenylene group.

The term "$C_2$-$C_{60}$ alkynyl group" as used herein refers to a monovalent hydrocarbon group having at least one carbon-carbon triple bond in the middle or at the terminus of a $C_2$-$C_{60}$ alkyl group, and examples thereof include an ethynyl group and a propynyl group. The term "$C_2$-$C_{60}$ alkynylene group" as used herein refers to a divalent group having the same structure as the $C_2$-$C_{60}$ alkynyl group. Corresponding definitions apply to other ranges given for the number of carbon atoms in an alkynyl/alkynylene group.

The term "$C_1$-$C_{60}$ alkoxy group" as used herein refers to a monovalent group represented by $-OA_{101}$ (wherein $A_{101}$ is the $C_1$-$C_{60}$ alkyl group), and examples thereof include a methoxy group, an ethoxy group, and an isopropyloxy group. Corresponding definitions apply to other ranges given for the number of carbon atoms in an alkoxy group.

The term "$C_3$-$C_{10}$ cycloalkyl group" as used herein refers to a monovalent saturated hydrocarbon cyclic group having 3 to 10 carbon atoms, and examples thereof are a cyclopropyl group, a cyclobutyl group, a cyclopentyl group, a cyclohexyl group, a cycloheptyl group, a cycloctyl group, an adamantanyl group, a norbornanyl group (or a bicyclo[2.2.1]heptyl group), a bicyclo[1.1.1]pentyl group, a bicyclo[2.1.1]hexyl group, and a bicyclo[2.2.2]octyl group. The term "$C_3$-$C_{10}$ cycloalkylene group" as used herein refers to a divalent group having the same structure as the $C_3$-$C_{10}$ cycloalkyl

group.

The term "$C_1$-$C_{10}$ heterocycloalkyl group" as used herein refers to a monovalent cyclic group that further includes, in addition to a carbon atom, at least one heteroatom as a ring-forming atom and has 1 to 10 carbon atoms, and examples thereof are a 1,2,3,4-oxatriazolidinyl group, a tetrahydrofuranyl group, and a tetrahydrothiophenyl group. The term "$C_1$-$C_{10}$ heterocycloalkylene group" as used herein refers to a divalent group having the same structure as the $C_1$-$C_{10}$ heterocycloalkyl group.

The term "$C_3$-$C_{10}$ cycloalkenyl group" as used herein refers to a monovalent cyclic group that has 3 to 10 carbon atoms and at least one double bond in the ring thereof and no aromaticity, and examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent cyclic group that has, in addition to a carbon atom, at least one heteroatom as a ring-forming atom, 1 to 10 carbon atoms, and at least one carbon-carbon double bond in the cyclic structure thereof. Examples of the $C_1$-$C_{10}$ heterocycloalkenyl group include a 4,5-dihydro-1 ,2,3,4-oxatriazolyl group, a 2,3-dihydrofuranyl group, and a 2,3-dihydrothiophenyl group. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms, and the term "$C_6$-$C_{60}$ arylene group" as used herein refers to a divalent group having a carbocyclic aromatic system having 6 to 60 carbon atoms. Examples of the $C_6$-$C_{60}$ aryl group are a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group. When the $C_6$-$C_{60}$ aryl group and the $C_6$-$C_{60}$ arylene group each include two or more rings, the two or more rings may be condensed to each other. Corresponding definitions apply to other ranges given for the number of carbon atoms in an aryl/arylene group.

The term "$C_1$-$C_{60}$ heteroaryl group" as used herein refers to a monovalent group having a heterocyclic aromatic system that has, in addition to a carbon atom, at least one heteroatom as a ring-forming atom, and 1 to 60 carbon atoms. The term "$C_1$-$C_{60}$ heteroarylene group" as used herein refers to a divalent group having a heterocyclic aromatic system that has, in addition to a carbon atom, at least one heteroatom as a ring-forming atom, and 1 to 60 carbon atoms. Examples of the $C_1$-$C_{60}$ heteroaryl group are a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the $C_1$-$C_{60}$ heteroaryl group and the $C_1$-$C_{60}$ heteroarylene group each include two or more rings, the two or more rings may be condensed with each other. Corresponding definitions apply to other ranges given for the number of carbon atoms in an heteroaryl/heteroarylene group.

The term "monovalent non-aromatic condensed polycyclic group" as used herein refers to a monovalent group (for example, having 8 to 60 carbon atoms) having two or more rings condensed with each other, only carbon atoms as ring-forming atoms, and non-aromaticity in its entire molecular structure. Examples of the monovalent non-aromatic condensed polycyclic group are an indenyl group, a fluorenyl group, a spiro-bifluorenyl group, a benzofluorenyl group, an indenophenanthrenyl group, and an indenoanthracenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 1 to 60 carbon atoms) having two or more rings condensed to each other, at least one heteroatom other than carbon atoms, as a ring-forming atom, and non-aromaticity in its entire molecular structure. Examples of the monovalent non-aromatic condensed heteropolycyclic group include a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indenocarbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothiophenyl group. The term "divalent non-aromatic condensed heteropolycyclic group" as used herein refers to a divalent group having the same structure as the monovalent non-aromatic condensed heteropolycyclic group.

The term "$C_6$-$C_{60}$ aryloxy group" as used herein refers to -$OA_{102}$ (wherein $A_{102}$ is the $C_6$-$C_{60}$ aryl group), and the term "$C_6$-$C_{60}$ arylthio group" as used herein refers to -$SA_{103}$ (wherein $A_{103}$ is the $C_6$-$C_{60}$ aryl group). Corresponding definitions apply to other ranges given for the number of carbon atoms in an aryloxy group and an arylthio group.

The term "$R_{10a}$" as used herein refers to:

deuterium (-D), -F, -Cl, -Br, -I, a hydroxyl group, a cyano group, or a nitro group;
a $C_1$-$C_{60}$ (*e.g.* $C_1$-$C_{20}$) alkyl group, a $C_2$-$C_{60}$ (*e.g.* $C_2$-$C_{20}$) alkenyl group, a $C_2$-$C_{60}$ (*e.g.* $C_2$-$C_{20}$) alkynyl group, or a $C_1$-$C_{60}$ (*e.g.* $C_1$-$C_{20}$) alkoxy group, each unsubstituted or substituted with deuterium, -F, -Cl, -Br, -I, a hydroxyl group, a cyano group, a nitro group, a $C_3$-$C_{60}$ (*e.g.* $C_3$-$C_{30}$) carbocyclic group, a $C_1$-$C_{60}$ (*e.g.* $C_1$-$C_{20}$) heterocyclic group, a $C_6$-$C_{60}$ (*e.g.* $C_6$-$C_{30}$) aryloxy group, a $C_6$-$C_{60}$ (*e.g.* $C_6$-$C_{30}$) arylthio group, -Si($Q_{11}$)($Q_{12}$)($Q_3$), -N($Q_{11}$)($Q_{12}$), -B($Q_{11}$)($Q_{12}$), -C(=O)($Q_{11}$), -S(=O)$_2$($Q_{11}$), - P(=O)($Q_{11}$)($Q_{12}$), or any combination thereof;
a $C_3$-$C_{60}$ carbocyclic group, a $C_1$-$C_{60}$ (*e.g.* $C_1$-$C_{20}$) heterocyclic group, a $C_6$-$C_{60}$ (*e.g.* $C_6$-$C_{30}$) aryloxy group, or a $C_6$-$C_{60}$ (*e.g.* $C_6$-$C_{30}$) arylthio group, each unsubstituted or substituted with deuterium, -F, -Cl, -Br, -I, a hydroxyl group, a cyano group, a nitro group, a $C_1$-$C_{60}$ (*e.g.* $C_1$-$C_{20}$) alkyl group, a $C_2$-$C_{60}$ (*e.g.* $C_2$-$C_{20}$) alkenyl group, a $C_2$-$C_{60}$ (*e.g.* $C_2$-$C_{20}$) alkynyl group, a $C_1$-$C_{60}$ (*e.g.* $C_1$-$C_{20}$) alkoxy group, a $C_3$-$C_{60}$ (*e.g.* $C_3$-$C_{30}$) carbocyclic group, a $C_1$-$C_{60}$ (*e.g.* $C_1$-$C_{20}$) heterocyclic group, a $C_6$-$C_{60}$ (*e.g.* $C_6$-$C_{30}$) aryloxy group, a $C_6$-$C_{60}$ (*e.g.* $C_6$-$C_{30}$) arylthio group, -Si($Q_{21}$)($Q_{22}$)($Q_{23}$), - N($Q_{21}$)($Q_{22}$), -B($Q_{21}$)($Q_{22}$), -C(=O)($Q_{21}$), -S(=O)$_2$($Q_{21}$), -P(=O)($Q_{21}$)($Q_{22}$), or any combination thereof; or
-Si($Q_{31}$)($Q_{32}$)($Q_{33}$), -N($Q_{31}$)($Q_{32}$), -B($Q_{31}$)($Q_{32}$), -C(=O)($Q_{31}$), -S(=O)$_2$($Q_{31}$), or - P(=O)($Q_{31}$)($Q_{32}$).
$Q_1$ to $Q_3$, $Q_{11}$ to $Q_{13}$, $Q_{21}$ to $Q_{23}$, and $Q_{31}$ to $Q_{33}$ used herein may each independently be: hydrogen; deuterium; -F; -Cl; -Br; -I; a hydroxyl group; a cyano group; a nitro group; a $C_1$-$C_{60}$ (*e.g.* $C_1$-$C_{20}$) alkyl group; a $C_2$-$C_{60}$ (*e.g.* $C_2$-$C_{20}$) alkenyl group; a $C_2$-$C_{60}$ (*e.g.* $C_2$-$C_{20}$) alkynyl group; a $C_1$-$C_{60}$ (*e.g.* $C_1$-$C_{20}$) alkoxy group; or a $C_3$-$C_{60}$ (*e.g.* $C_3$-$C_{30}$) carbocyclic group or a $C_1$-$C_{60}$ (*e.g.* $C_1$-$C_{20}$) heterocyclic group, each unsubstituted or substituted with deuterium, -F, a cyano group, a $C_1$-$C_{60}$ (*e.g.* $C_1$-$C_{20}$) alkyl group, a $C_1$-$C_{60}$ (*e.g.* $C_1$-$C_{20}$) alkoxy group, a phenyl group, a biphenyl group, or any combination thereof.

The term "heteroatom" as used herein refers to any atom other than a carbon atom. Examples of the heteroatom are O, S, N, P, Si, B, Ge, Se, and any combination thereof.

The term "Ph" as used herein refers to a phenyl group, the term "Me" as used herein refers to a methyl group, the term "Et" as used herein refers to an ethyl group, the term "ter-Bu" or "$Bu^t$" as used herein refers to a tert-butyl group, and the term "OMe" as used herein refers to a methoxy group.

The term "biphenyl group" as used herein refers to "a phenyl group substituted with a phenyl group." In other words, the "biphenyl group" is a substituted phenyl group having a $C_6$-$C_{60}$ aryl group as a substituent.

The term "terphenyl group" as used herein refers to "a phenyl group substituted with a biphenyl group". In other words, the "terphenyl group" is a substituted phenyl group having, as a substituent, a $C_6$-$C_{60}$ aryl group substituted with a $C_6$-$C_{60}$ aryl group.

* and *' as used herein, unless defined otherwise, each refer to a binding site to a neighboring atom in a corresponding formula.

[Examples]

Evaluation Example 1

According to a method described in Table 1, with respect to each of the compounds described in Table 2, an emission spectrum, an emission peak wavelength, an absorption spectrum, an absorption peak wavelength, a molar extinction coefficient, and a Stokes shift were evaluated, and results thereof are described in Table 2. Emission spectra of D1-1, D1-2 and D1-3 ("D1-1", "D1-2" and "D1-3") and an absorption spectra of D2-1 ("D2-1(Abs)") are shown in Figure 4.

Table 1

| | |
|---|---|
| Emission spectrum | 5 μmol/L of a toluene solution of a compound to be measured was prepared and then placed in a quartz cell, and an emission spectrum (vertical axis: emission intensity / horizontal axis: wavelength (nm)) of the solution was measured at room temperature (300 K) by using a streak camera (manufactured by Hamamatsu) and a ps LASER (EKSPLA). |
| Emission peak | A maximum emission wavelength of the peak at which |
| wavelength (nm) | emission intensity becomes the maximum in the emission spectrum was evaluated as the emission peak wavelength. |
| Absorption spectrum | 5 μmol/L of a toluene solution of a compound to be measured was prepared and then placed in a quartz cell, and an absorption spectrum (vertical axis: absorption intensity / horizontal axis: wavelength (nm)) of the solution was measured at room temperature (300 K) by using a streak camera (manufactured by Hamamatsu) and a ps LASER (EKSPLA). |
| Absorption peak wavelength (nm) | A maximum absorption wavelength of the peak at which absorption intensity becomes the maximum in the absorption spectrum was evaluated as the absorption peak wavelength. |
| Molar extinction coefficient (extinction coefficienct(ε), L/(mol·cm), or $M^{-1}cm^{-1}$) | An absorption intensity of an absorption peak located at the longest wavelength side of the absorption spectrum was divided by the concentration of the solution. The absorption peak located at the longest wavelength side of the absorption spectrum is a peak appearing on the longest wavelength side among peaks having an absorption intensity of 1/10 or more of the absorption peak wavelength. |
| Stokes shift (nm) | A Stokes shift was calculated by subtracting the absorption peak wavelength of the absorption spectrum from the emission peak wavelength of the emission spectrum. |

Table 2

| Compound | | Emission peak wavelength (nm) | Absorption peak wavelength (nm) | Molar extinction coefficient ($M^{-1}cm^{-1}$) | Stokes shift (nm) |
|---|---|---|---|---|---|
| First dopant | D1-1 | 458 | 410 | - | - |
| | D1-2 | 460 | 415 | - | - |
| | D1-3 | 462 | 417 | - | - |
| | D1-A | 475 | - | - | - |
| Second dopant | D2-1 | 462 | 448 | 9.786 | 14 |
| | D2-A | 461 | 442 | 8.456 | 19 |

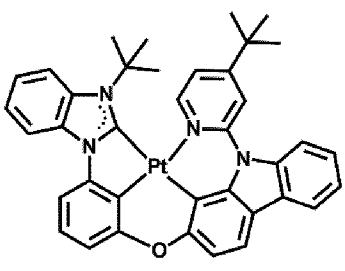

D1-1

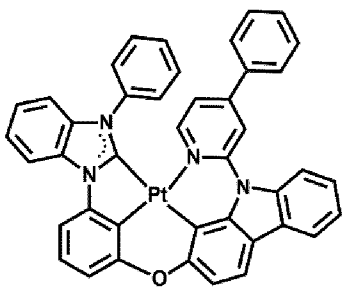

D1-2

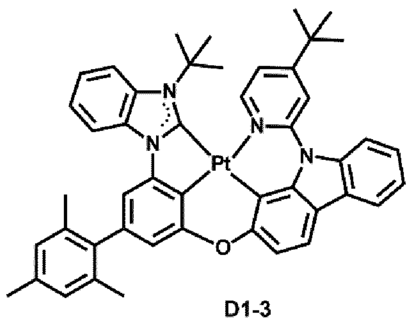

D1-3

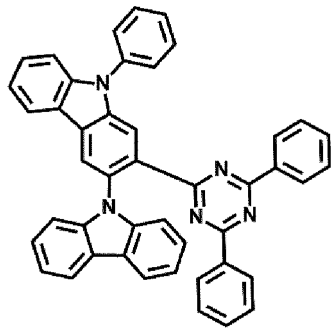

D1-A

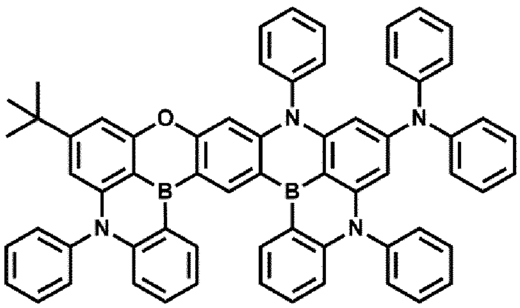

D2-1

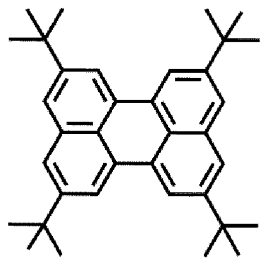

D2-A

Evaluation Example 2

Spectral overlap integrals with respect to each of emission spectra and absorption spectra of compounds described in Table 3 were calculated according to Equation 1 described herein by using an Excel program, and are shown in Table 3.

Table 3

| Compound used for measuring emission spectrum | Compound used for measuring absorption spectrum | Spectral overlap integral of emission spectrum and absorption spectrum ($M^{-1}cm^{-1}nm^4$) |
|---|---|---|
| D1-1 | D2-1 | $1.62 \times 10^{15}$ |
| D1-2 | D2-1 | $1.76 \times 10^{15}$ |
| D1-3 | D2-1 | $1.60 \times 10^{15}$ |
| D1-A | D2-A | $1.32 \times 10^{15}$ |

Evaluation Example 3

With respect to a thin film formed by depositing each compound described in Table 4 into the thin film having a thickness of 300 Å, a low temperature (4 K) emission spectrum and a room temperature (300 K) emission spectrum were each measured by using a spectrophotometer which was used to evaluate the emission spectrum of Table 1, and then 1) a lowest excited triplet ($T_1$) energy level was evaluated by comparing with the room temperature emission spectrum and analyzing a peak observed only in the low temperature emission spectrum, and 2) a lowest excited singlet ($S_1$) energy level was evaluated by coverting the maximum emission wavelength (nm) of a peak at which the emission intensity of the room temperature emission spectrum became the maximum into eV units, and results thereof are shown in Table 4.

Table 4

| Compound | | $T_1$ (eV) | $S_1$ (eV) |
|---|---|---|---|
| First dopant | D1-1 | 2.82 | - |
| | D1-2 | 2.72 | - |
| | D1-3 | 2.67 | - |
| | D1-A | 2.60 | - |
| Second dopant | D2-1 | - | 2.67 |
| | D2-A | - | 2.51 |

Example 1

A 15 $\Omega cm^2$ (1,200 Å) ITO glass substrate (anode) available from Corning Inc. was cut to a size of 50 mm × 50 mm × 0.7 mm, sonicated by using isopropyl alcohol and pure water for 5 minutes each, and then cleaned by irradiation of ultraviolet rays and exposure of ozone thereto for 30 minutes. Then, the resultant glass substrate was loaded onto a vacuum deposition apparatus.

2-TNATA was vacuum-deposited on the glass substrate to form a hole injection layer having a thickness of 600 Å, and then HAT-CN was vacuum-deposited thereon to form a hole transport layer having a thickness of 300 Å.

A host (mCBP), a first dopant, and a second dopant were co-deposited on the hole transport layer at a weight ratio of 90 : 5 : 5 to form an emission layer having a thickness of 300 Å. The first dopant and the second dopant are the same as described in Table 5.

Subsequently, ET1 was vacuum-deposited on the emission layer to form an electron transport layer having a thickness of 300 Å. Yb was vacuum-deposited on the electron transport layer to form an electron injection layer having a thickness of 10 Å, and Al was vacuum-deposited thereon to form a cathode having a thickness of 3,000 Å, thereby completing manufacture of an organic light-emitting device.

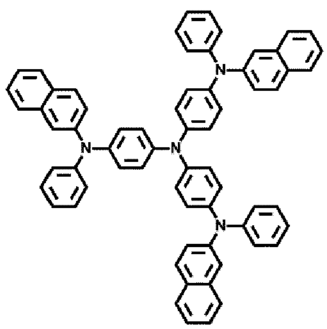
2-TNATA

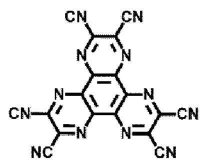
HAT-CN

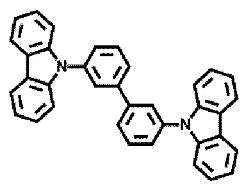
mCBP

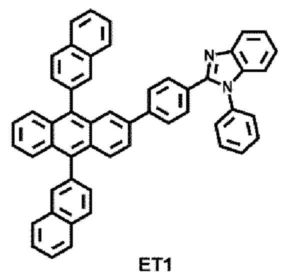
ET1

Examples 2 and 3 and Comparative Example A

Organic light-emitting devices were manufactured in the same manner as in Example 1, except that compounds described in Table 5 were respectively used in forming an emission layer.

Evaluation Example 4

With respect to the organic light-emitting devices manufactured in Examples 1 to 3 and Comparative Example A, driving voltage at a current density of 10 $mA/cm^2$, external quantum efficiency (EQE), lifespan ($LT_{50}$), and color coordinates were measured by using the following methods, and results thereof are shown in Table 5:

- Color coordinates: Power was supplied from a current-voltmeter (Keithley SMU 236), and color coordinates were measured by using a luminance meter PR650.
- Luminance: Power was supplied from a current-voltmeter (Keithley SMU 236), and luminance was measured by using a luminance meter PR650.
- Efficiency: Power was supplied from a current-voltmeter (Keithley SMU 236), and efficiency was measured by using

a luminance meter PR650.

Lifespan ($LT_{50}$) indicates an amount of time that was taken until the luminance was reduced to 50% of initial luminance of 100%.

Table 5

| | Composition of emission layer | | Driving voltage (V) | External quantum efficiency (%) | $LT_{50}$ (hours) | Color coordinates | |
|---|---|---|---|---|---|---|---|
| | First dopant | Second dopant | | | | CIEx | CIEy |
| Example 1 | D1-1 | D2-1 | 4.4 | 19.8 | 460 | 0.128 | 0.130 |
| Example 2 | D1-2 | D2-1 | 4.5 | 18.2 | 440 | 0.122 | 0.129 |
| Example 3 | D1-3 | D2-1 | 4.5 | 16.3 | 350 | 0.127 | 0.132 |
| Comparati ve Example A | D1-A | D2-A | 4.5 | 7.3 | 70 | 0.127 | 0.157 |

From Table 5, it is confirmed that light-emitting devices of Examples 1 to 3 emit blue light and have improved driving voltage, improved external quantum efficiency, and improved lifespan characteristics, compared to the light-emitting device of Comparative Example A.

The light-emitting devices have low driving voltage, high external quantum efficiency, and long lifespan. Also, electronic apparatus may be manufactured by using the light-emitting devices.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

**Claims**

**1.** A light-emitting device (10) comprising:

a first electrode (110);
a second electrode (150) facing the first electrode (110); and
an interlayer (130) located between the first electrode (110) and the second electrode (150) and including an emission layer,
wherein the emission layer includes a host, a first dopant, and a second dopant,
the host, the first dopant, and the second dopant are different from each other,
the first dopant is a phosphorescent dopant,
a Stokes shift of the second dopant is less than or equal to 15 nm,
a spectral overlap integral of an emission spectrum of the first dopant and an absorption spectrum of the second dopant is greater than or equal to $1.5 \times 10^{15}$ $M^{-1}cm^{-1}nm^4$, and
the spectral overlap integral is evaluated by Equation 1:

Equation 1

$$J(\lambda) = \int_0^\infty \varepsilon(\lambda)\lambda^4 F_D(\lambda)d\lambda$$

wherein, in Equation 1,
$J(\lambda)$ is the spectral overlap integral of the emission spectrum of the first dopant and the absorption spectrum of the second dopant in units of $M^{-1}cm^{-1}nm^4$,
$\varepsilon(\lambda)$ is a molar extinction coefficient of the second dopant calculated from the absorption spectrum of the second dopant in units of $M^{-1}cm^{-1}$,

$\lambda$ is the wavelength of the emission spectrum and the absorption spectrum in units of nm, and
$F_D(\lambda)$ is the normalized emission spectrum of the first dopant, and
wherein the emission spectrum of the first dopant is an emission spectrum evaluated at room temperature in a 5 $\mu$M toluene solution of the first dopant, and
the absorption spectrum of the second dopant is an absorption spectrum evaluated at room temperature in a 5 $\mu$M toluene solution of the second dopant.

2. A light-emitting device (10) according to claim 1, wherein the first dopant is a transition metal-containing organometallic compound.

3. A light-emitting device (10) according to claim 1 or claim 2, wherein the Stokes shift of the second dopant is greater than or equal to 5 nm and less than or equal to 15 nm.

4. A light-emitting device (10) according to any one of claims 1 to 3, wherein the spectral overlap integral is greater than or equal to $1.5 \times 10^{15}$ $M^{-1}cm^{-1}nm^4$ and less than or equal to $2.0 \times 10^{15}$ $M^{-1}cm^{-1}nm^4$.

5. A light-emitting device (10) according to any one of claims 1 to 4, wherein:

(i) an emission peak wavelength in the emission spectrum of the first dopant is greater than or equal to 430 nm and less than or equal to 470 nm; and/or
(ii) an emission peak wavelength in the emission spectrum of the first dopant is greater than an absorption peak wavelength in the absorption spectrum of the second dopant.

6. A light-emitting device (10) according to any one of claims 1 to 5, wherein excitons transition from a lowest excitation triplet energy level ($T_1$) of the first dopant to a lowest excitation singlet energy level ($S_1$) of the second dopant, and excitons at the lowest excitation singlet energy level ($S_1$) of the second dopant transition to a ground state to thereby emit light.

7. A light-emitting device (10) according to any one of claims 1 to 6, wherein, among the total emission components emitted from the emission layer, the proportion of emission components emitted from the second dopant is greater than or equal to 80%.

8. A light-emitting device (10) according to any one of claims 1 to 7, wherein the emission layer emits blue light having an emission peak wavelength of greater than or equal to 420 nm and less than or equal to 470 nm.

9. A light-emitting device (10) according to any one of claims 1 to 8, wherein the emission layer emits blue light having a CIE x color coordinate of greater than or equal to 0.115 and less than or equal to 0.135 and a CIE y color coordinate of greater than or equal to 0.120 and less than or equal to 0.140.

10. A light-emitting device (10) according to any one of claims 1 to 9, wherein:

(i) the sum of an amount of the first dopant and an amount of the second dopant is less than an amount of the host; and/or
(ii) the sum of an amount of the first dopant and an amount of the second dopant is greater than or equal to 0.1 parts by weight and less than or equal to 30 parts by weight, based on 100 parts by weight of the emission layer.

11. A light-emitting device (10) according to any one of claims 1 to 10, wherein the first dopant is an organometallic compound including platinum and a tetradentate ligand.

12. A light-emitting device (10) according to any one of claims 1 to 11, wherein:

(i) the second dopant does not include a transition metal; and/or
(ii) the second dopant is a delayed fluorescence dopant satisfying the following Equation 3-2:

Equation 3-2

$$S1(D2) - T1(D2) \leq 0.3 \text{ eV}$$

wherein, in Equation 3-2,
S1(D2) is a lowest excitation singlet energy level of the second dopant, and
T1(D2) is a lowest excitation triplet energy level of the second dopant.

**13.** A light-emitting device (10) according to any one of claims 1 to 12, wherein:

(i) the second dopant includes a condensed cyclic ring in which at least one first ring and at least one second ring are condensed with each other,

the first ring is a 6-membered ring including boron (B) as a ring-forming atom, and
the second ring is a pyrrole group, a furan group, a thiophene group, a benzene group, a pyridine group, or a pyrimidine group; and/or

(ii) the second dopant is a prompt fluorescence dopant.

**14.** An electronic apparatus comprising a light-emitting device (10) according to any one of claims 1 to 13.

**15.** An electronic apparatus according to claim 14, further comprising:

(i) a thin-film transistor,

wherein the thin-film transistor comprises a source electrode (260) and a drain electrode (270), and
the first electrode (110) of the light-emitting device (10) is electrically connected to at least one of the source electrode (260) and the drain electrode (270) of the thin-film transistor; and/or

(ii) a color filter, a color conversion layer, a touch screen layer, a polarizing layer, or any combination thereof.

## Patentansprüche

**1.** Lichtemittierende Vorrichtung (10), die Folgendes umfasst:

eine erste Elektrode (110),
eine zweite Elektrode (150), die der ersten Elektrode (110) gegenüberliegt, und
eine Zwischenschicht (130), die zwischen der ersten Elektrode (110) und der zweiten Elektrode (150) angeordnet ist und eine Emissionsschicht einschließt,
wobei die Emissionsschicht einen Träger, einen ersten Dotierstoff und einen zweiten Dotierstoff einschließt,
sich der Träger, der erste Dotierstoff und der zweite Dotierstoff voneinander unterscheiden,
der erste Dotierstoff ein phosphoreszierender Dotierstoff ist,
eine Stokes-Verschiebung des zweiten Dotierstoffs kleiner als oder gleich 15 nm ist,
ein Spektralüberlappungsintegral eines Emissionsspektrums des ersten Dotierstoffs und eines Absorptionsspektrums des zweiten Dotierstoffs größer als oder gleich 1,5 $\times$ $10^{15}$ $M^{-1}cm^{-1}nm^4$ ist und
das Spektralüberlappungsintegral durch die Gleichung 1 ermittelt wird:

Gleichung 1

$$J(\lambda) = \int_0^\infty \varepsilon(\lambda)\lambda^4 F_D(\lambda)d\lambda,$$

wobei, in Gleichung 1,
$J(\lambda)$ das Spektralüberlappungsintegral des Emissionsspektrums des ersten Dotierstoffs und des Absorptionsspektrums des zweiten Dotierstoffs in Einheiten von $M^{-1}cm^{-1}nm^4$ ist,
$\varepsilon(\lambda)$ ein molarer Extinktionskoeffizient des zweiten Dotierstoffs, berechnet aus dem Absorptionsspektrum des zweiten Dotierstoffs, in Einheiten von $M^{-1}cm^{-1}$ ist,
$\lambda$ die Wellenlänge des Emissionsspektrums und des Absorptionsspektrums in Einheiten von nm ist; und
$F_D(\lambda)$ das normalisierte Emissionsspektrum des ersten Dotierstoffs ist; und
wobei das Emissionsspektrum des ersten Dotierstoffs ein Emissionsspektrum, ermittelt bei Raumtemperatur in einer 5 µM-Toluol-Lösung des ersten Dotierstoffs, ist und

das Absorptionsspektrum des zweiten Dotierstoffs ein Absorptionsspektrum, ermittelt bei Raumtemperatur in einer 5 μM-Toluol-Lösung des zweiten Dotierstoffs, ist.

**2.** Lichtemittierende Vorrichtung (10) nach Anspruch 1, wobei der erste Dotierstoff eine übergangsmetallhaltige organometallische Verbindung ist.

**3.** Lichtemittierende Vorrichtung (10) nach Anspruch 1 oder Anspruch 2, wobei die Stokes-Verschiebung des zweiten Dotierstoffs größer als oder gleich 5 nm und kleiner als oder gleich 15 nm ist.

**4.** Lichtemittierende Vorrichtung (10) nach einem der Ansprüche 1 bis 3, wobei das Spektralüberlappungsintegral größer als oder gleich $1{,}5 \times 10^{15}$ $M^{-1}cm^{-1}nm^4$ und kleiner als oder gleich $2{,}0 \times 10^{15}$ $M^{-1}cm^{-1}nm^4$ ist.

**5.** Lichtemittierende Vorrichtung (10) nach einem der Ansprüche 1 bis 4, wobei:

(i) eine Emissionsspitzen-Wellenlänge in dem Emissionsspektrum des ersten Dotierstoffs größer als oder gleich 430 nm und kleiner als oder gleich 470 nm ist, und/oder
(ii) eine Emissionsspitzen-Wellenlänge in dem Emissionsspektrum des ersten Dotierstoffs größer ist als Absorptionsspitzen-Wellenlänge in dem Absorptionsspektrum des zweiten Dotierstoffs.

**6.** Lichtemittierende Vorrichtung (10) nach einem der Ansprüche 1 bis 5, wobei Exzitonen von einem niedrigsten Anregungstriplett-Energieniveau ($T_1$) des ersten Dotierstoffs zu einem niedrigsten Anregungssingulett-Energieniveau ($S_1$) übergehen des zweiten Dotierstoffs und Exzitonen auf dem niedrigsten Anregungssingulett-Energieniveau ($S_1$) des zweiten Dotierstoffs des zweiten Dotierstoffs zu einem Grundzustand übergehen, um dadurch Licht zu emittieren.

**7.** Lichtemittierende Vorrichtung (10) nach einem der Ansprüche 1 bis 6, wobei, unter den von der Emissionsschicht emittierten Gesamtemissionskomponenten, der Anteil der von dem zweiten Dotierstoff emittierten Emissionskomponenten größer als oder gleich 80 % ist.

**8.** Lichtemittierende Vorrichtung (10) nach einem der Ansprüche 1 bis 7, wobei die Emissionsschicht blaues Licht emittiert, das eine Emissionsspitzen-Wellenlänge, größer als oder gleich 420 nm und kleiner als oder gleich 470 nm, aufweist.

**9.** Lichtemittierende Vorrichtung (10) nach einem der Ansprüche 1 bis 8, wobei die Emissionsschicht blaues Licht emittiert, das eine CIE-x-Farbkoordinate, größer als oder gleich 0,115 und kleiner als oder gleich 0,135, und eine CIE-y-Farbkoordinate, größer als oder gleich 0,120 und kleiner als oder gleich 0,140, aufweist.

**10.** Lichtemittierende Vorrichtung (10) nach einem der Ansprüche 1 bis 9, wobei:

(i) die Summe einer Menge des ersten Dotierstoffs und einer Menge des zweiten Dotierstoffs geringer ist als eine Menge des Trägers und/oder
(ii) die Summe einer Menge des ersten Dotierstoffs und einer Menge des zweiten Dotierstoffs größer als oder gleich 0,1 Gewichtsanteile und kleiner als oder gleich 30 Gewichtsanteile, auf Grundlage von 100 Gewichtsanteilen der Emissionsschicht, ist.

**11.** Lichtemittierende Vorrichtung (10) nach einem der Ansprüche 1 bis 10, wobei der erste Dotierstoff eine organometallische Verbindung ist, die Platin und einen vierzähnigen Liganden einschließt.

**12.** Lichtemittierende Vorrichtung (10) nach einem der Ansprüche 1 bis 11, wobei:

(i) der zweite Dotierstoff kein Übergangsmetall einschließt, und/oder
(ii) der zweite Dotierstoff ein Dotierstoff mit verzögerter Fluoreszenz ist, der die folgende Gleichung 3-2 erfüllt:

Gleichung 3-2

$$S1(D2) - T1(D2) \leq 0{,}3\ eV,$$

wobei, in Gleichung 3-2,

S1(D2) ein niedrigstes Anregungssingulett-Energieniveau des zweiten Dotierstoffs ist, und
T1(D2) ein niedrigsten Anregungstriplett-Energieniveau des zweiten Dotierstoffs ist.

**13.** Lichtemittierende Vorrichtung (10) nach einem der Ansprüche 1 bis 12, wobei:

(i) der zweite Dotierstoff einen kondensierten zyklischen Ring einschließt, in dem mindestens ein erster Ring und mindestens ein zweiter Ring miteinander kondensiert sind,

der erste Ring ein 6-gliedriger Ring ist, der Bor (B) als ein ringbildendes Atom einschließt, und
der zweite Ring eine Pyrrolgruppe, eine Furangruppe, eine Thiophengruppe, eine Benzolgruppe, eine Pyridingruppe oder eine Pyrimidingruppe ist, und/oder

(ii) der zweite Dotierstoff ein Dotierstoff mit prompter Fluoreszenz ist.

**14.** Elektronisches Gerät, das eine Lichtemittierende Vorrichtung (10) nach einem der Ansprüche 1 bis 13 umfasst.

**15.** Elektronisches Gerät nach Anspruch 14, das ferner Folgendes umfasst:

(i) einen Dünnschichttransistor,

wobei der Dünnschichttransistor eine Source-Elektrode (260) und eine Drain-Elektrode (270) umfasst, und
die erste Elektrode (110) der Lichtemittierenden Vorrichtung (10) elektrisch mit mindestens einer von der Source-Elektrode (260) und der Drain-Elektrode (270) des Dünnschichttransistors verbunden ist, und/oder

(ii) einen Farbfilter, eine Farbkonversionsschicht, eine Berührungsbildschirmschicht, eine polarisierende Schicht oder eine beliebige Kombination derselben.

**Revendications**

**1.** Dispositif électroluminescent (10), comprenant :

une première électrode (110) ;
une deuxième électrode (150) faisant face à la première électrode (110) ; et
une couche intermédiaire (130) disposée entre la première électrode (110) et la deuxième électrode (150) et incluant une couche d'émission ;
dans lequel la couche d'émission inclut un hôte, un premier dopant et un deuxième dopant,
l'hôte, le premier dopant et le deuxième dopant étant différents les uns des autres ;
le premier dopant est un dopant phosphorescent ;
un décalage de Stokes du deuxième dopant est inférieur ou égal à 15 nm ;
une intégrale de chevauchement spectral d'un spectre d'émission du premier dopant et d'un spectre d'absorption du deuxième dopant est supérieure ou égale à 1,5 $\times$ $10^{15} M^{-1} cm^{-1} nm^4$ ; et
l'intégrale de chevauchement spectral est évaluée par l'équation 1 :

Equation 1

$$J(\lambda) = \int_0^\infty \varepsilon(\lambda)\lambda^4 F_D(\lambda)d\lambda$$

dans lequel, dans l'équation 1,
$J(\lambda)$ est l'intégrale de chevauchement spectral du spectre d'émission du premier dopant et du spectre d'absorption du deuxième dopant en unités de $M^{-1}cm^{-1}nm^4$,
$\varepsilon(\lambda)$ est un coefficient d'extinction molaire du deuxième dopant calculé à partir du spectre d'absorption du deuxième dopant en unités de $M^{-1}cm^{-1}$;
$\lambda$ est la longueur d'onde du spectre d'émission et du spectre d'absorption en unités de nm; et
$F_D(\lambda)$ est le spectre d'émission normalisé du premier dopant, et
dans lequel le spectre d'émission du premier dopant est un spectre d'émission évalué à température ambiante

dans une solution de toluène à 5 μM du premier dopant, et
le spectre d'absorption du deuxième dopant est un spectre d'absorption évalué à température ambiante dans une solution de toluène à 5 μM du deuxième dopant.

**2.** Dispositif électroluminescent (10) selon la revendication 1, dans lequel le premier dopant est un composé organométallique contenant un métal de transition.

**3.** Dispositif électroluminescent (10) selon les revendications 1 ou 2, dans lequel le décalage de Stokes du deuxième dopant est supérieur ou égal à 5 nm et inférieur ou égal à 15 nm.

**4.** Dispositif électroluminescent (10) selon l'une quelconque des revendications 1 à 3, dans lequel l'intégrale de chevauchement spectral est supérieure ou égale à 1,5 $\times$ $10^{15}$ $M^{-1}cm^{-1}nm^4$ et inférieure ou égale à 2,0 $\times$ $10^{15}$ $M^{-1}cm^{-1}nm^4$.

**5.** Dispositif électroluminescent (10) selon l'une quelconque des revendications 1 à 4, dans lequel :

(i) une longueur d'onde de pic d'émission dans le spectre d'émission du premier dopant est supérieure ou égale à 430 nm et inférieure ou égale à 470 nm ; et/ou
(ii) une longueur d'onde de pic d'émission dans le spectre d'émission du premier dopant est supérieure à une longueur d'onde de pic d'absorption dans le spectre d'absorption du deuxième dopant.

**6.** Dispositif électroluminescent (10) selon l'une quelconque des revendications 1 à 5, dans lequel des excitons passent d'un niveau d'énergie triplet d'excitation le plus bas ($T_1$) du premier dopant à un niveau d'énergie singulet d'excitation le plus bas ($S_1$) du deuxième dopant, et des excitons au niveau d'énergie singulet d'excitation le plus bas ($S_1$) du deuxième dopant passent à un état fondamental pour ainsi émettre de la lumière.

**7.** Dispositif électroluminescent (10) selon l'une quelconque des revendications 1 à 6, dans lequel, parmi les composants d'émission totaux émis par la couche d'émission, la proportion des composants d'émission émis par le deuxième dopant est supérieure ou égale à 80 %.

**8.** Dispositif électroluminescent (10) selon l'une quelconque des revendications 1 à 7, dans lequel la couche d'émission émet une lumière bleue ayant une longueur d'onde de pic d'émission supérieure ou égale à 420 nm et inférieure ou égale à 470 nm.

**9.** Dispositif électroluminescent (10) selon l'une quelconque des revendications 1 à 8, dans lequel la couche d'émission émet une lumière bleue ayant une coordonnée de couleur CIE x supérieure ou égale à 0,115 et inférieure ou égale à 0,135, et une coordonnée de couleur CIE y supérieure ou égale à 0,120 et inférieure ou égale à 0,140.

**10.** Dispositif électroluminescent (10) selon l'une quelconque des revendications 1 à 9, dans lequel :

(i) la somme d'une quantité du premier dopant et d'une quantité du deuxième dopant est inférieure à une quantité de l'hôte ; et/ou
(ii) la somme d'une quantité du premier dopant et d'une quantité du deuxième dopant est supérieure ou égale à 0,1 partie en poids et inférieure ou égale à 30 parties en poids, sur la base de 100 parties en poids de la couche d'émission.

**11.** Dispositif électroluminescent (10) selon l'une quelconque des revendications 1 à 10, dans lequel le premier dopant est un composé organométallique incluant du platine et un ligand tétradenté.

**12.** Dispositif électroluminescent (10) selon l'une quelconque des revendications 1 à 11, dans lequel :

(i) le deuxième dopant n'inclut pas de métal de transition ; et/ou
(ii) le deuxième dopant est un dopant à fluorescence retardée satisfaisant l'équation 3-2 suivante :

Equation 3-2

$$S1(D2) - T1(D2) \leq 0{,}3\ eV,$$

dans lequel, dans l'équation 3-2,
S1(D2) est un niveau d'énergie singulet d'excitation le plus bas du deuxième dopant ; et
T1(D2) est un niveau d'énergie triplet d'excitation le plus bas du deuxième dopant.

**13.** Dispositif électroluminescent (10) selon l'une quelconque des revendications 1 à 12, dans lequel :

(i) le deuxième dopant inclut un anneau cyclique condensé dans lequel au moins un premier anneau et au moins un deuxième anneau sont condensés l'un avec l'autre ;

le premier anneau est un anneau à 6 chaînons incluant du bore (B) comme atome formant l'anneau ; et
le deuxième anneau est un groupe pyrrole, un groupe furane, un groupe thiophène, un benzène, un groupe pyridine ou un groupe pyrimidine ; et/ou

(ii) le deuxième dopant est un dopant à fluorescence rapide.

**14.** Appareil électronique, comprenant un dispositif électroluminescent (10) selon l'une quelconque des revendications 1 à 13.

**15.** Appareil électronique selon la revendication 14, comprenant en outre :

(i) un transistor à couches minces ;

dans lequel la transistor à couches minces comprend une électrode de source (260) et une électrode de drain (270) ; et
la première électrode (110) du dispositif électroluminescent (10) est connectée électriquement à au moins l'une de l'électrode de source (260) et de l'électrode de drain (270) du transistor à couches minces ; et/ou

(ii) un filtre de couleur, une couche de conversion de couleur, une couche d'écran tactile, une couche de polarisation ou une quelconque combinaison de ceux-ci.

FIG. 1

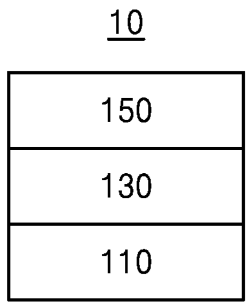

FIG. 2

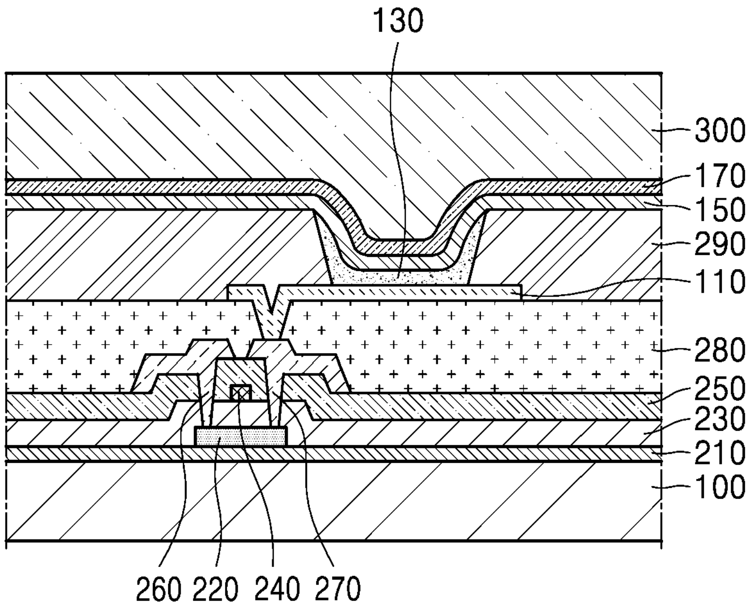

FIG. 3

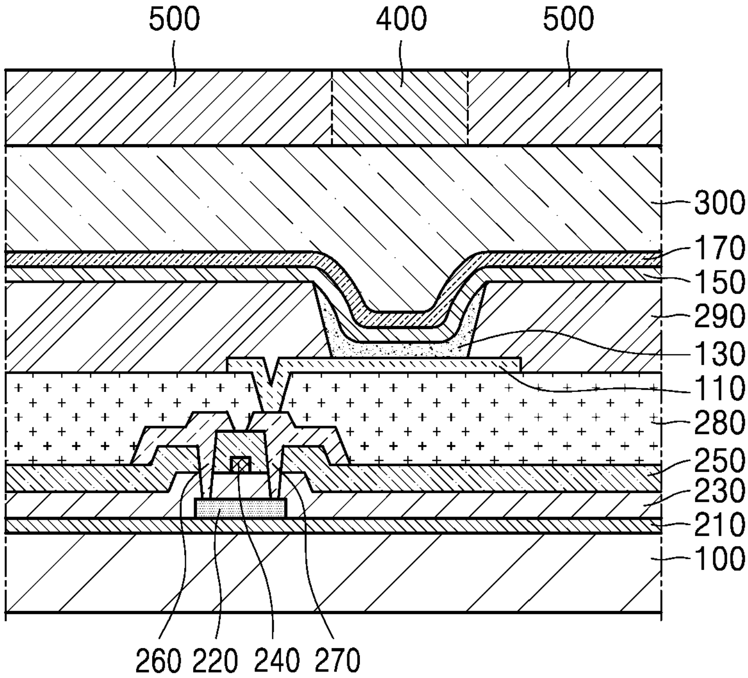
500
400
500
300
170
150
290
130
110
280
250
230
210
100
260 220 240 270

FIG. 4

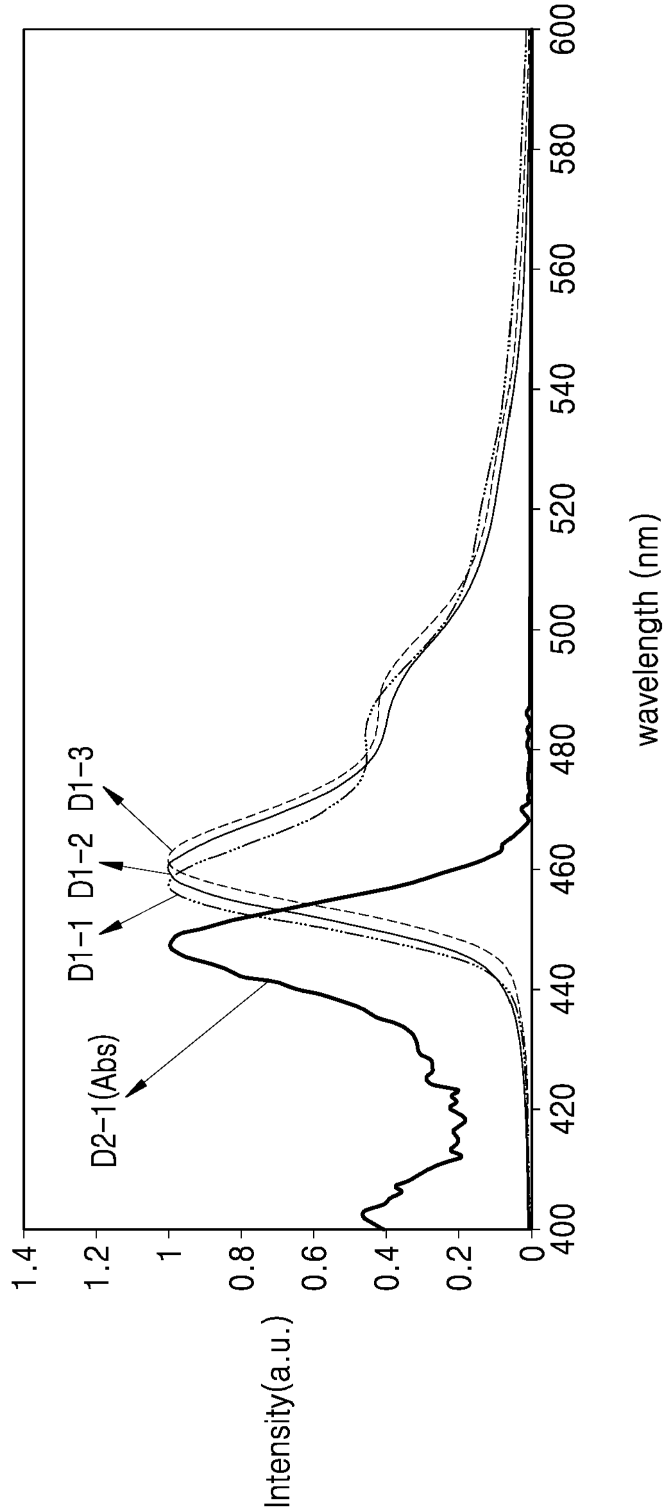
D1-1 D1-2 D1-3
D2-1(Abs)
Nor.Intensity(a.u.)
wavelength (nm)
0
0.2
0.4
0.6
0.8
1
1.2
1.4
400
420
440
460
480
500
520
540
560
580
600

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2019142555 A1
- WO 2018186101 A1
- US 2019280236 A1